# EUROPEAN PATENT SPECIFICATION

(11) **EP 3 889 236 B1**
(45) Date of publication and mention of the grant of the patent: **22.11.2023**
(21) Application number: 19890930.1
(22) Date of filing: 28.11.2019
(51) Int. Cl.: C07F 5/02

(54) **ORGANIC LIGHT-EMITTING ELEMENT USING POLYCYCLIC AROMATIC DERIVATIVE COMPOUND**
ORGANISCHES LICHTEMITTIERENDES ELEMENT MIT POLYCYCLISCHER AROMATISCHER DERIVATVERBINDUNG
ÉLÉMENT ÉLECTROLUMINESCENT ORGANIQUE UTILISANT UN COMPOSÉ DÉRIVÉ AROMATIQUE POLYCYCLIQUE

(30) Priority: 30.11.2018 KR 20180151781; 27.11.2019 KR 20190154524
(43) Date of publication of application: 06.10.2021
(73) Proprietor: SFC Co., Ltd., Cheongju-si, Chungcheongbuk-do 28122 (KR); Hodogaya Chemical Co., Ltd., Tokyo 104-0028 (JP)
(72) Inventor: JOO, Sung-hoon, Cheongju-si Chungcheongbuk-do 28122 (KR); YANG, Byung-sun, Cheongju-si Chungcheongbuk-do 28122 (KR); KIM, Su-jin, Cheongju-si Chungcheongbuk-do 28122 (KR); KIM, Ji-hwan, Cheongju-si Chungcheongbuk-do 28122 (KR); JO, Hyeon-jun, Cheongju-si Chungcheongbuk-do 28122 (KR); CHOI, Sung-eun, Cheongju-si Chungcheongbuk-do 28122 (KR); SHIN, Bong-ki, Cheongju-si Chungcheongbuk-do 28122 (KR); PARK, Young-hwan, Cheongju-si Chungcheongbuk-do 28122 (KR); HAYASHI, Shuichi, Tokyo 104--0028 (JP); YAMAMOTO, Takeshi, Tokyo 104--0028 (JP); MOCHIZUKI, Shunji, Tokyo 104--0028 (JP); HIRAYAMA, Yuta, Tokyo 104--0028 (JP)
(74) Representative: Grosse, Felix Christopher
(86) International application number: PCT/KR2019/016612
(87) International publication number: WO 2020/111830

(56) References cited:
- EP-A1- 3 660 024
- EP-A2- 3 246 963
- WO-A1-2017/027333
- KR-A- 20170 089 094
- KR-A- 20170 127 593
- KR-A- 20180 018 404
- KR-A- 20180 122 298
- KR-B1- 101 876 763
- US-A1- 2018 301 629
- US-A1- 2019 207 112

## Description

The present invention relates to highly efficient organic electroluminescent devices with greatly improved luminous efficiency using polycyclic aromatic compounds.

Organic electroluminescent devices are self-luminous devices in which electrons injected from an electron injecting electrode (cathode) recombine with holes injected from a hole injecting electrode (anode) in a light emitting layer to form excitons, which emit light while releasing energy. Such organic electroluminescent devices have the advantages of low driving voltage, high luminance, large viewing angle, and short response time and can be applied to full-color light emitting flat panel displays. Due to these advantages, organic electroluminescent devices have received attention as next-generation light sources.

The above characteristics of organic electroluminescent devices are achieved by structural optimization of organic layers of the devices and are supported by stable and efficient materials for the organic layers, such as hole injecting materials, hole transport materials, light emitting materials, electron transport materials, electron injecting materials, and electron blocking materials. However, more research still needs to be done to develop structurally optimized structures of organic layers for organic electroluminescent devices and stable and efficient materials for organic layers of organic electroluminescent devices.

There has been much research aimed at improving the characteristics of organic electroluminescent devices by changes in the performance of organic layer materials. In addition, a technique for improving the color purity and enhancing the luminous efficiency of a device by optimizing the optical thickness of layers between an anode and a cathode is considered as a crucial factor for improving the device performance. For example, the formation of a capping layer on an electrode achieves increased luminous efficiency and high color purity.

Thus, there is a continued need to develop structures of organic electroluminescent devices optimized to improve their luminescent properties and new materials capable of supporting the optimized structures of organic electroluminescent devices.

Therefore, the present invention intends to provide a highly efficient organic electroluminescent device using at least one polycyclic aromatic compound and including a capping layer.

An organic electroluminescent device according to one aspect of the present invention has the following features:
(1) the organic electroluminescent device includes a first electrode, a second electrode opposite to the first electrode, and a light emitting layer interposed between the first and second electrodes;
(2) the organic electroluminescent device includes a capping layer formed on one of the surfaces of the first and second electrodes opposite to the light emitting layer;
(3) the light emitting layer includes a compound represented by Formula A-1 and/or A-2: 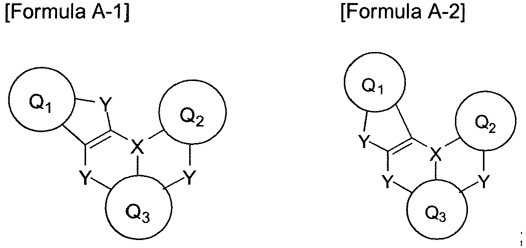 and
(4) the capping layer includes a compound represented by Formula B:

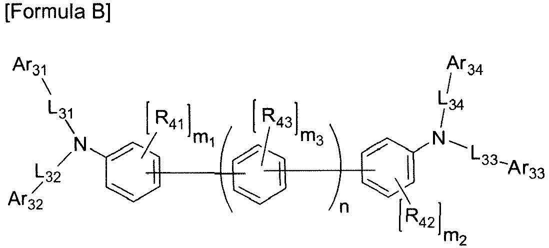

A description will be given concerning the structures of the compounds of Formula A-1, Formula A-2, and Formula B, the definitions of substituents in the compounds of Formula A-1, Formula A-2, and Formula B, specific examples of compounds that can be represented by Formula A-1, Formula A-2, and Formula B, and the organic electroluminescent device including the compound of Formula A-1 and/or A-2 and the compound of Formula B.

The formation of the light emitting layer employing the polycyclic aromatic compound and the optional capping layer makes the organic electroluminescent device of the present invention highly efficient.

The present invention will now be described in more detail.

An organic electroluminescent device of the present invention includes a first electrode, a second electrode opposite to the first electrode, a light emitting layer interposed between the first and second electrodes, and a capping layer formed on one of the surfaces of the first and second electrodes opposite to the light emitting layer.

In the present invention, the light emitting layer includes a compound represented by Formula A-1: 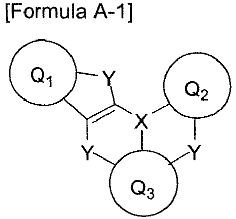 wherein Q₁ to Q₃ are identical to or different from each other and are each independently a substituted or unsubstituted C₆-C₅₀ aromatic hydrocarbon ring or a substituted or unsubstituted C₂-C₅₀ heteroaromatic ring, the linkers Y are identical to or different from each other and are each independently selected from N-R₁, CR₂R₃, O, and S, X is B, and R₁ to R₃ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that each of R₁ to R₃ is optionally bonded to Q₁, Q₂ or Q₃ to form an alicyclic or aromatic monocyclic or polycyclic ring, R₂ and R₃ are optionally linked to each other to form an alicyclic or aromatic monocyclic or polycyclic ring, and/or a compound represented by Formula A-2: 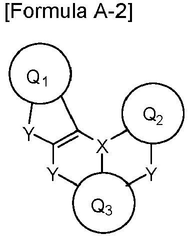 wherein Q₁, Q₂, Q₃, X, and Y are as defined in Formula A-1.
in the present invention, the capping layer includes a compound represented by Formula B: 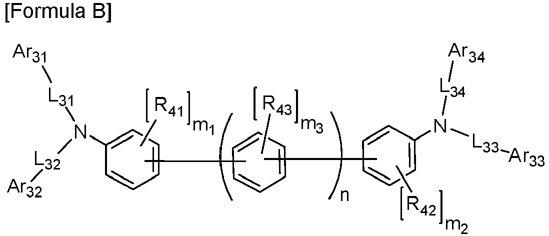 wherein R₄₁ to R₄₃ are identical to or different from each other and are each independently selected
from hydrogen, deuterium, substituted or unsubstituted C₁-C₂₀ alkyl, substituted or unsubstituted C₆-C₅₀ aryl, substituted or unsubstituted C₇-C₅₀ arylalkyl, substituted or unsubstituted C₃-C₃₀ cycloalkyl, substituted or unsubstituted C₁-C₃₀ alkylsilyl, substituted or unsubstituted C₆-C₃₀ arylsilyl, and halogen, L₃₁ to L₃₄ are identical to or different from each other and are each independently single bonds or selected from substituted or unsubstituted C₆-C₅₀ arylene and substituted or unsubstituted C₂-C₅₀ heteroarylene, Ar₃₁ to Ar₃₄ are identical to or different from each other and are each independently selected from substituted or unsubstituted C₆-C₅₀ aryl and substituted or unsubstituted C₂-C₅₀ heteroaryl, n is an integer from 0 to 4, provided that when n is 2 or greater, the aromatic rings containing R₄₃ are identical to or different from each other, m₁ to m₃ are integers from 0 to 4, provided that when both m₁ and m₃ are 2 or more, the R₄₁, R₄₂, and R₄₃ groups are identical to or different from each other, and hydrogen or deuterium atoms are bonded to the carbon atoms of the aromatic rings to which R₄₁ to R₄₃ are not attached.

According to one embodiment of the present invention, the compound of Formula A-1 or A-2 may have a polycyclic aromatic skeletal structure represented by Formula A-3, A-4, A-5 or A-6: 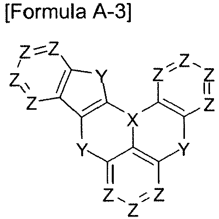 wherein each Z is independently CR or N, the substituents R are identical to or different from each other and are independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that the substituents R are optionally bonded to each other or are optionally linked to other adjacent substituents to form alicyclic or aromatic monocyclic or polycyclic rings whose carbon atoms are optionally substituted with one or more heteroatoms selected from N, S, and O atoms, and X and Y are as defined in Formulae A-1 and A-2, 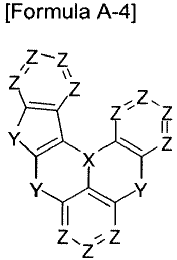 wherein X, Y, and Z are as defined in Formula A-3, 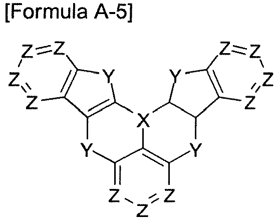 wherein X, Y, and Z are as defined in Formula A-3, 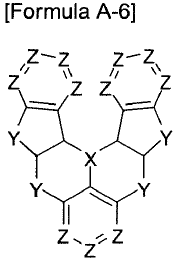 wherein X, Y, and Z are as defined in Formula A-3.

The use of the skeletal structure meets desired requirements of the light emitting layer of the organic electroluminescent device, achieving high efficiency of the device.

According to one embodiment of the present invention, at least one of Ar₃₁ to Ar₃₄ in Formula B is represented by Formula C: 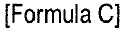 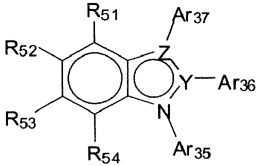 wherein R₅₁ to R₅₄ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, which are optionally linked to each other to form a ring, Y is a carbon or nitrogen atom, Z is a carbon, oxygen, sulfur or nitrogen atom, Ar₃₅ to Ar₃₇ are identical to or different from each other and are each independently selected from substituted or unsubstituted C₅-C₅₀ aryl and substituted or unsubstituted C₃-C₅₀ heteroaryl, provided that when Z is an oxygen or sulfur atom, Ar₃₇ is nothing, provided that when Y and Z are nitrogen atoms, only one of Ar₃₅, Ar₃₆, and Ar₃₇ is present, provided that when Y is a nitrogen atom and Z is a carbon atom, Ar₃₆ is nothing, with the proviso that one of R₅₁ to R₅₄ and Ar₃₅ to Ar₃₇ is a single bond linked to one of the linkers L₃₁ to L₃₄ in Formula B.

As used herein, the term "substituted" in the definition of the substituents in the compounds of Formulae A-1, A-2, and B and various substituents in various compounds described below indicates substitution with one or more substituents selected from the group consisting of deuterium, cyano, halogen, hydroxyl, nitro, C₁-C₂₄ alkyl, C₃-C₂₄ cycloalkyl, C₁-C₂₄ haloalkyl, C₁-C₂₄ alkenyl, C₁-C₂₄ alkynyl, C₁-C₂₄ heteroalkyl, C₁-C₂₄ heterocycloalkyl, C₆-C₂₄ aryl, C₆-C₂₄ arylalkyl, C₂-C₂₄ heteroaryl, C₂-C₂₄ heteroarylalkyl, C₁-C₂₄ alkoxy, C₁-C₂₄ alkylamino, C₁-C₂₄ arylamino, C₁-C₂₄ heteroarylamino, C₁-C₂₄ alkylsilyl, C₁-C₂₄ arylsilyl, and C₁-C₂₄ aryloxy, or a combination thereof. The term "unsubstituted" in the same definition indicates having no substituent.

In the "substituted or unsubstituted C₁-C₁₀ alkyl", "substituted or unsubstituted C₆-C₃₀ aryl", etc., the number of carbon atoms in the alkyl or aryl group indicates the number of carbon atoms constituting the unsubstituted alkyl or aryl moiety without considering the number of carbon atoms in the substituent(s). For example, a phenyl group substituted with a butyl group at the para-position corresponds to a C₆ aryl group substituted with a C₄ butyl group.

As used herein, the expression "form a ring with an adjacent substituent" means that the corresponding substituent combines with an adjacent substituent to form a substituted or unsubstituted alicyclic or aromatic ring and the term "adjacent substituent" may mean a substituent on an atom directly attached to an atom substituted with the corresponding substituent, a substituent disposed sterically closest to the corresponding substituent or another substituent on an atom substituted with the corresponding substituent. For example, two substituents substituted at the ortho position of a benzene ring or two substituents on the same carbon in an aliphatic ring may be considered "adjacent" to each other.

In the present invention, the alkyl groups may be straight or branched. The number of carbon atoms in the alkyl groups is not particularly limited but is preferably from 1 to 20. Specific examples of the alkyl groups include, but are not limited to, methyl, ethyl, propyl, n-propyl, isopropyl, butyl, n-butyl, isobutyl, tert-butyl, sec-butyl, 1-methylbutyl, 1-ethylbutyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohexylmethyl, octyl, n-octyl, tert-octyl, 1-methylheptyl, 2-ethylhexyl, 2-propylpentyl, n-nonyl, 2,2-dimethylheptyl, 1-ethylpropyl, 1,1-dimethylpropyl, isohexyl, 4-methylhexyl, and 5-methylhexyl groups.

The alkenyl group is intended to include straight and branched ones and may be optionally substituted with one or more other substituents. The alkenyl group may be specifically a vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, stilbenyl or styrenyl group but is not limited thereto.

The alkynyl group is intended to include straight and branched ones and may be optionally substituted with one or more other substituents. The alkynyl group may be, for example, ethynyl or 2-propynyl but is not limited thereto.

The cycloalkyl group is intended to include monocyclic and polycyclic ones and may be optionally substituted with one or more other substituents. As used herein, the term "polycyclic" means that the cycloalkyl group may be directly attached or fused to one or more other cyclic groups. The other cyclic groups may be cycloalkyl groups and other examples thereof include heterocycloalkyl, aryl, and heteroaryl groups. The cycloalkyl group may be specifically a cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl or cyclooctyl group but is not limited thereto.

The heterocycloalkyl group is intended to include monocyclic and polycyclic ones interrupted by a heteroatom such as O, S, Se, N or Si and may be optionally substituted with one or more other substituents. As used herein, the term "polycyclic" means that the heterocycloalkyl group may be directly attached or fused to one or more other cyclic groups. The other cyclic groups may be heterocycloalkyl groups and other examples thereof include cycloalkyl, aryl, and heteroaryl groups.

The aryl groups may be monocyclic or polycyclic ones. Examples of the monocyclic aryl groups include, but are not limited to, phenyl, biphenyl, terphenyl, and terphenyl groups. Examples of the polycyclic aryl groups include naphthyl, anthracenyl, phenanthrenyl, pyrenyl, perylenyl, tetracenyl, chrysenyl, fluorenyl, acenaphthacenyl, triphenylene, and fluoranthrene groups but the scope of the present invention is not limited thereto.

The heteroaryl groups refer to heterocyclic groups interrupted by one or more heteroatoms. Examples of the heteroaryl groups include, but are not limited to, thiophene, furan, pyrrole, imidazole, triazole, oxazole, oxadiazole, triazole, pyridyl, bipyridyl, pyrimidyl, triazine, triazole, acridyl, pyridazine, pyrazinyl, quinolinyl, quinazoline, quinoxalinyl, phthalazinyl, pyridopyrimidinyl, pyridopyrazinyl, pyrazinopyrazinyl, isoquinoline, indole, carbazole, benzoxazole, benzimidazole, benzothiazole, benzocarbazole, benzothiophene, dibenzothiophene, benzofuranyl, dibenzofuranyl, phenanthroline, thiazolyl, isooxazolyl, oxadiazolyl, thiadiazolyl, benzothiazolyl, and phenothiazinyl groups.

The alkoxy group may be specifically a methoxy, ethoxy, propoxy, isobutyloxy, sec-butyloxy, pentyloxy, iso-amyloxy or hexyloxy group, but is not limited thereto.

The silyl group is intended to include alkyl-substituted silyl groups and aryl-substituted silyl groups. Specific examples of such silyl groups include trimethylsilyl, triethylsilyl, triphenylsilyl, trimethoxysilyl, dimethoxyphenylsilyl, diphenylmethylsilyl, diphenylvinylsilyl, methylcyclobutylsilyl, and dimethylfurylsilyl.

The amine groups may be, for example, -NH₂, alkylamine groups, and arylamine groups. The arylamine groups are aryl-substituted amine groups and the alkylamine groups are alkyl-substituted amine groups. Examples of the arylamine groups include substituted or unsubstituted monoarylamine groups, substituted or unsubstituted diarylamine groups, and substituted or unsubstituted triarylamine groups. The aryl groups in the arylamine groups may be monocyclic or polycyclic ones. The arylamine groups may include two or more aryl groups. In this case, the aryl groups may be monocyclic aryl groups or polycyclic aryl groups. Alternatively, the aryl groups may consist of a monocyclic aryl group and a polycyclic aryl group. The aryl groups in the arylamine groups may be selected from those exemplified above.

The aryl groups in the aryloxy group and the arylthioxy group are the same as those described above. Specific examples of the aryloxy groups include, but are not limited to, phenoxy, p-tolyloxy, m-tolyloxy, 3,5-dimethylphenoxy, 2,4,6-trimethylphenoxy, p-tert-butylphenoxy, 3-biphenyloxy, 4-biphenyloxy, 1-naphthyloxy, 2-naphthyloxy, 4-methyl-1-naphthyloxy, 5-methyl-2-naphthyloxy, 1-anthryloxy, 2-anthryloxy, 9-anthryloxy, 1-phenanthryloxy, 3-phenanthryloxy, and 9-phenanthryloxy groups. The arylthioxy group may be, for example, a phenylthioxy, 2-methylphenylthioxy or 4-tert-butylphenylthioxy group but is not limited thereto.

The halogen group may be, for example, fluorine, chlorine, bromine or iodine.

More specifically, the compound of Formula A-1 or A-2 used in the organic electroluminescent device of the present invention may be selected from the following compounds:

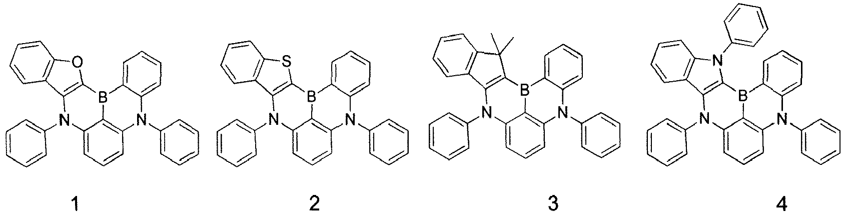

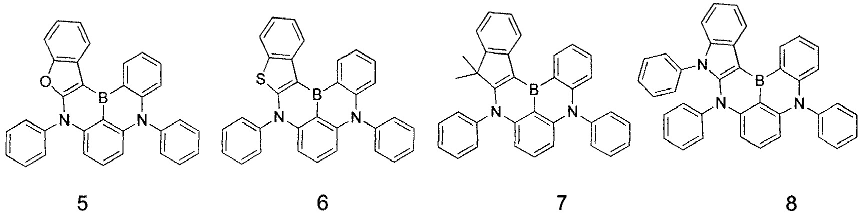

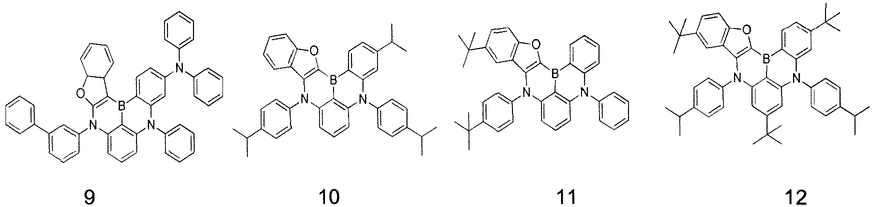

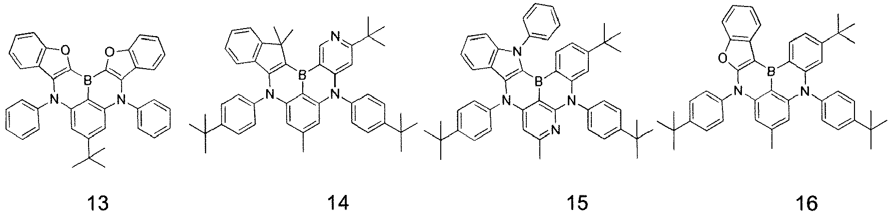

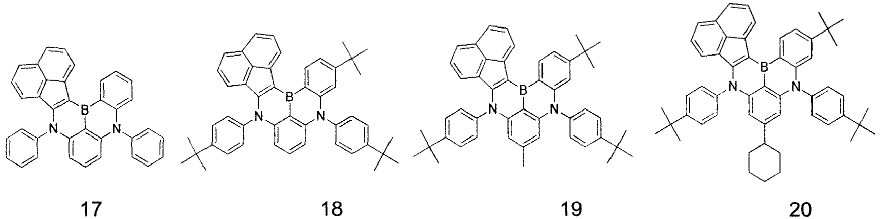

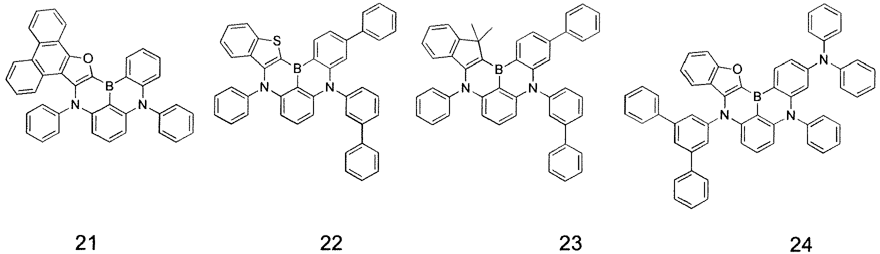

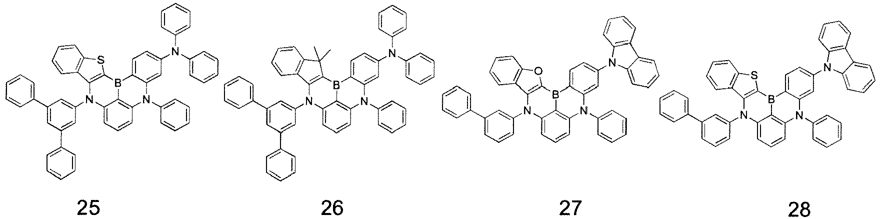

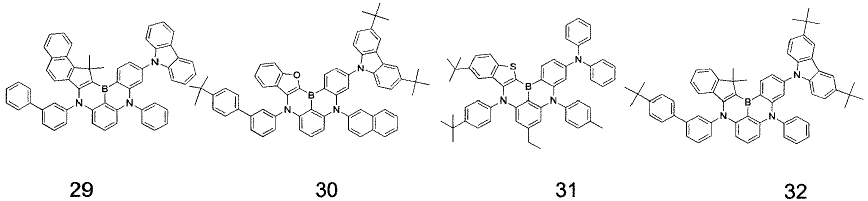

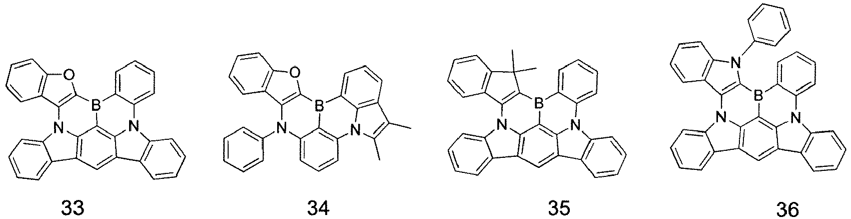

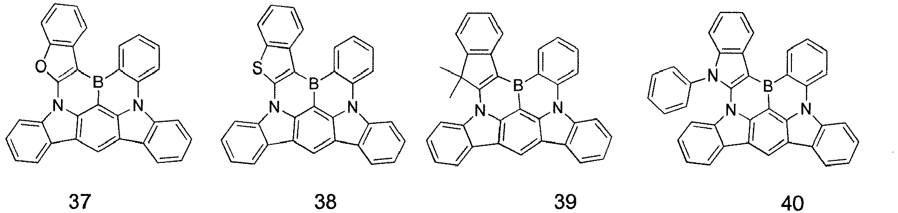

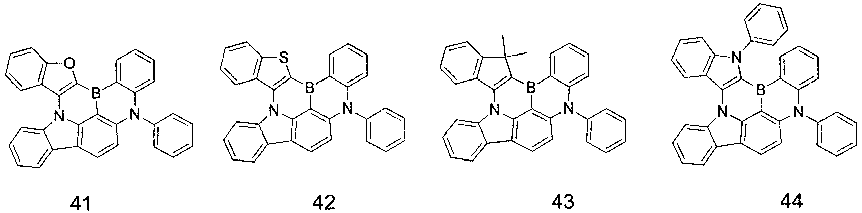

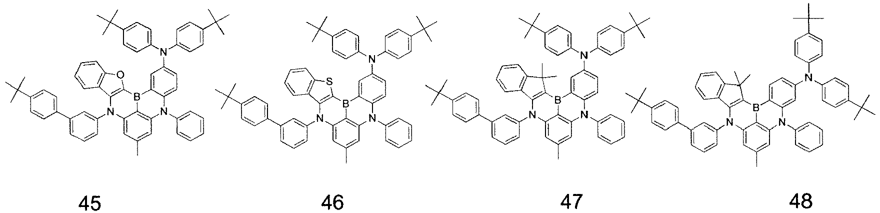

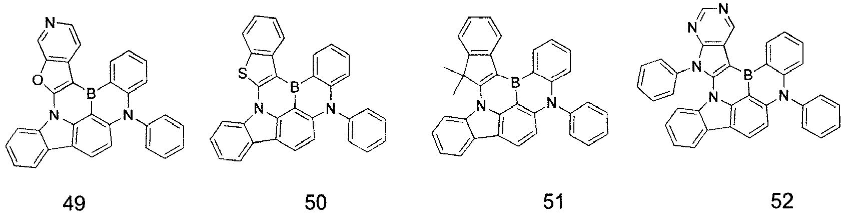

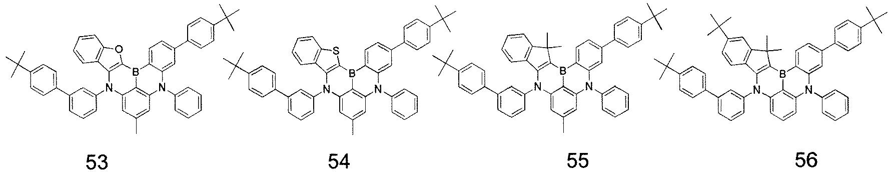

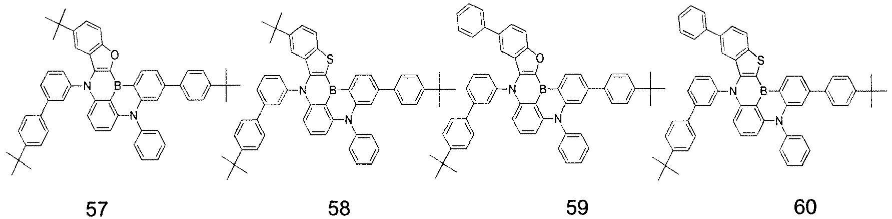

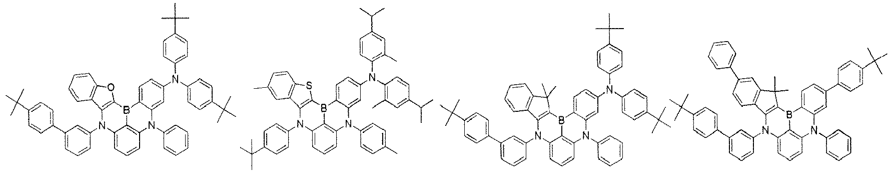

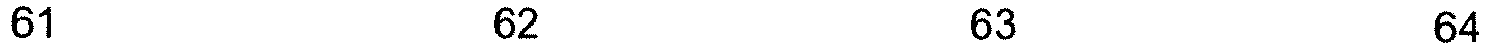

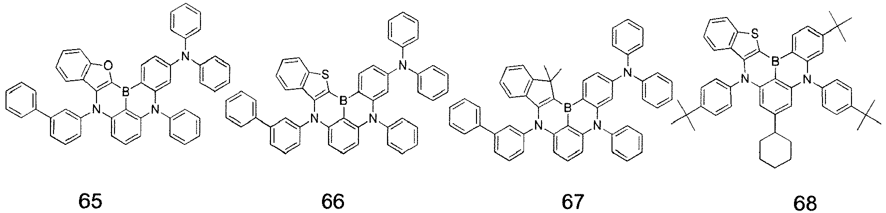

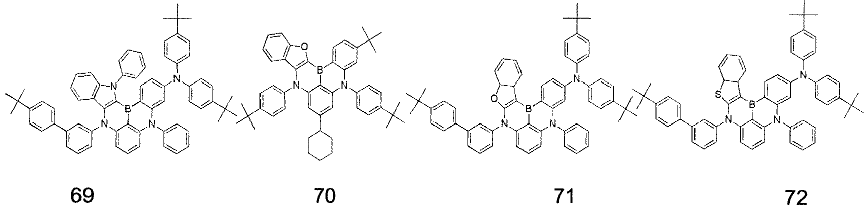

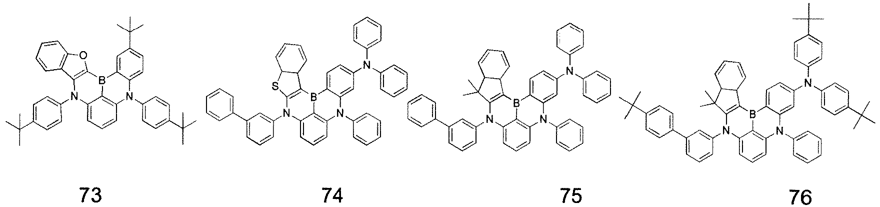

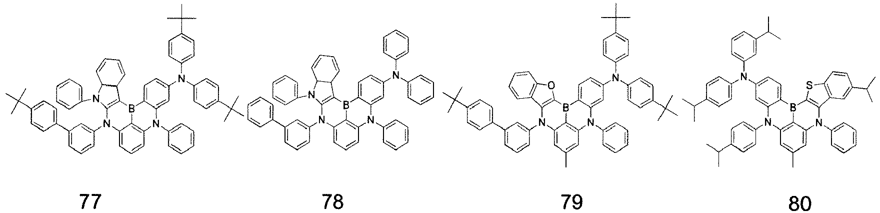

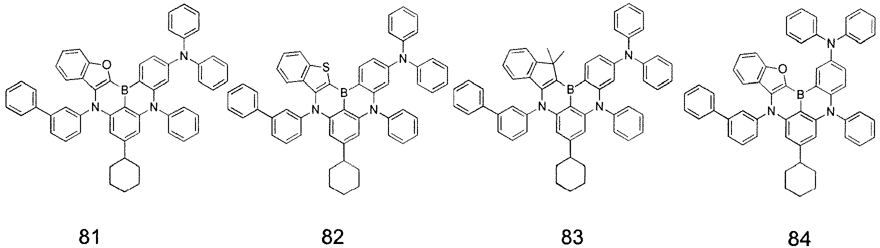

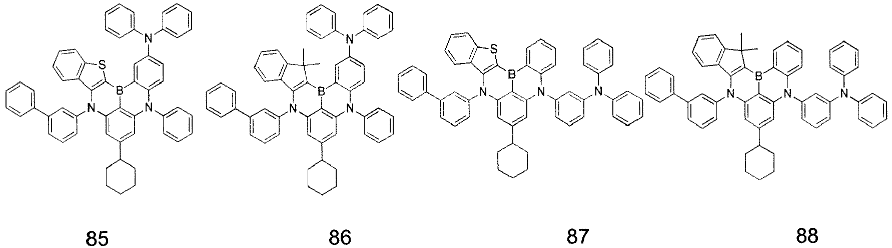

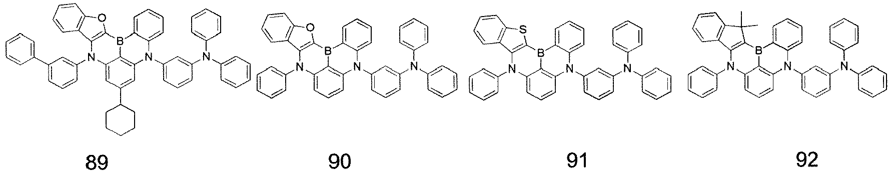

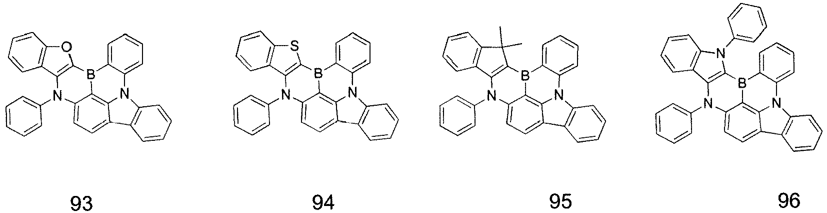

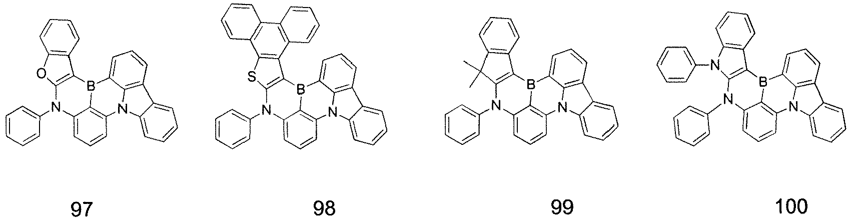

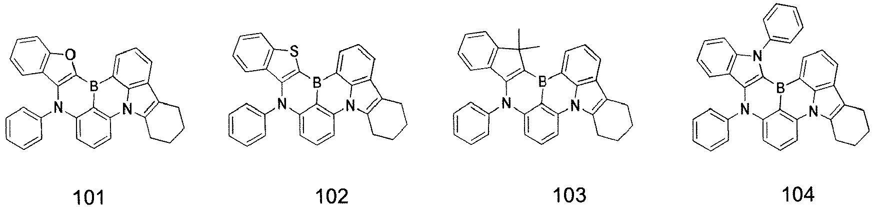

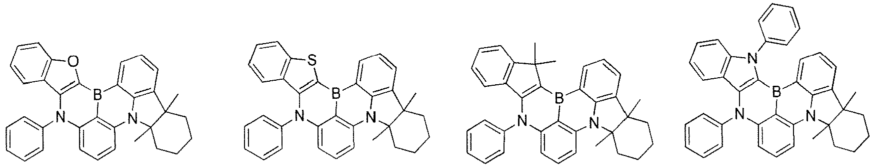

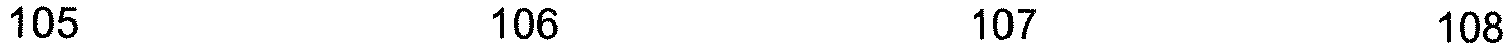

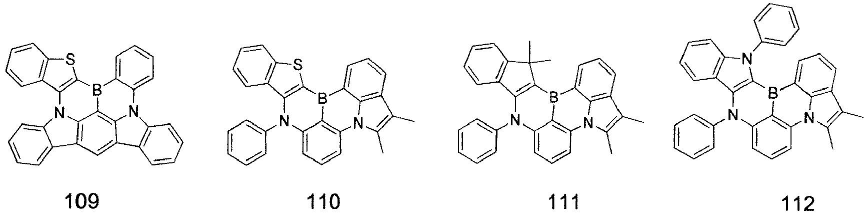

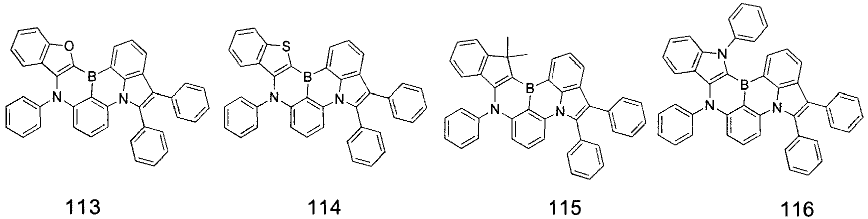

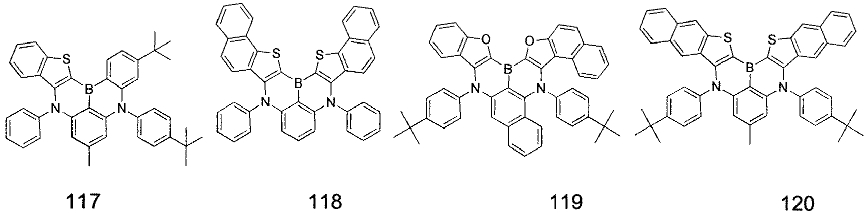

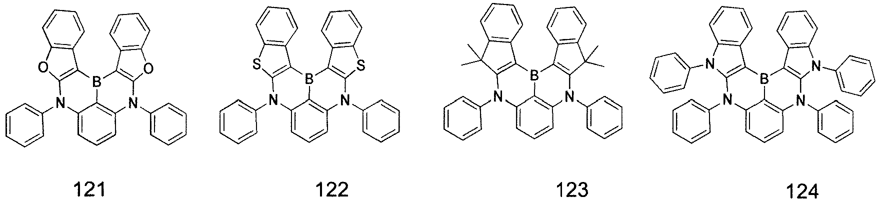

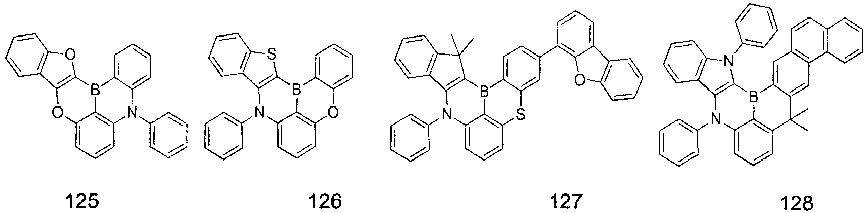

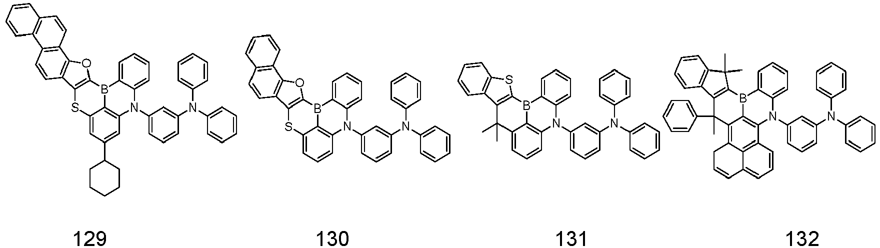

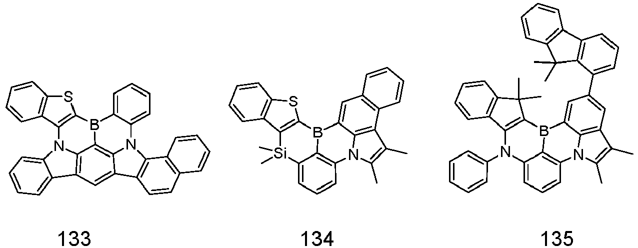

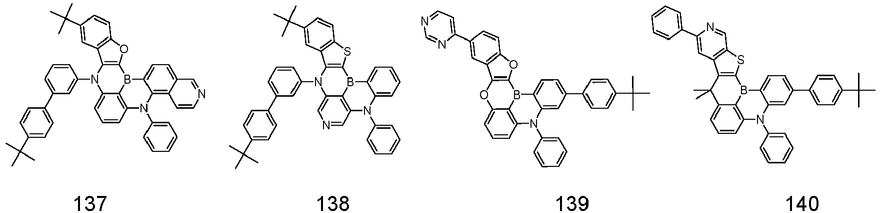

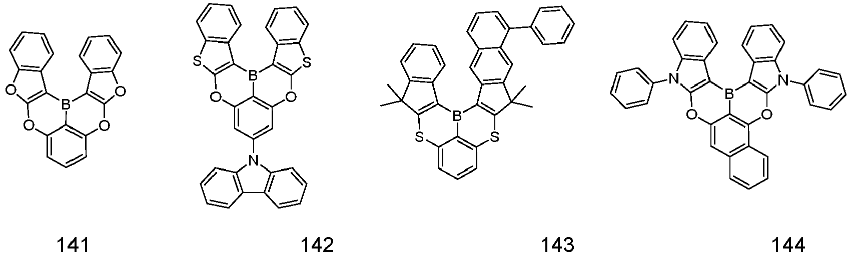

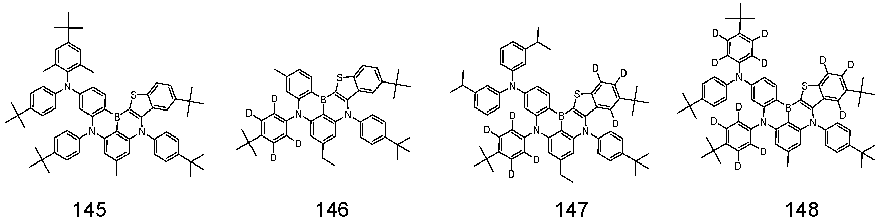

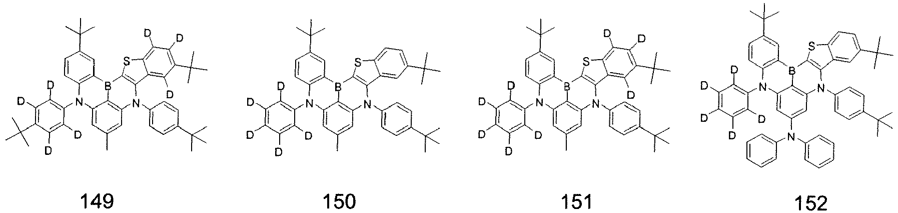

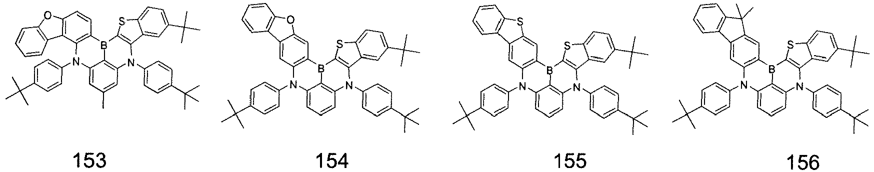

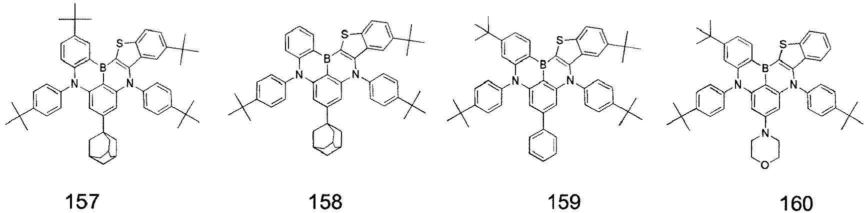

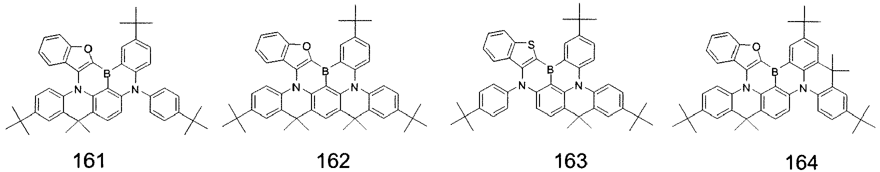

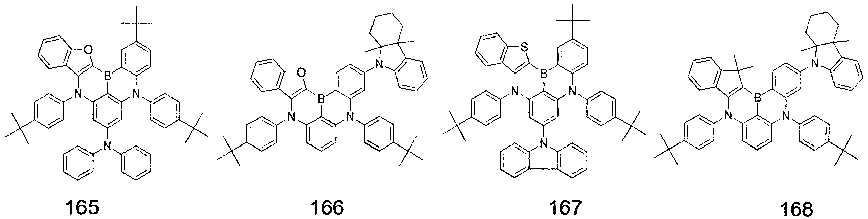

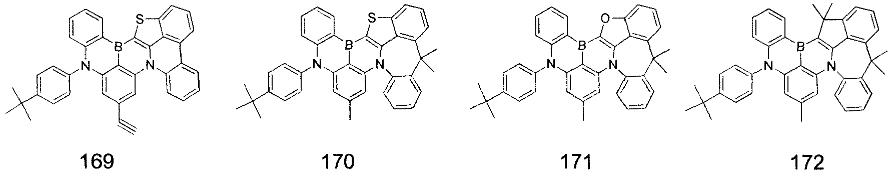

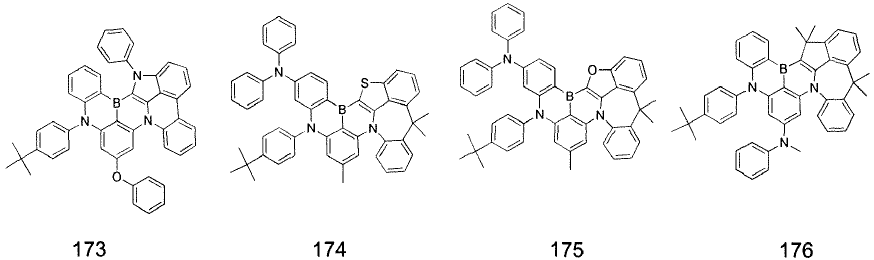

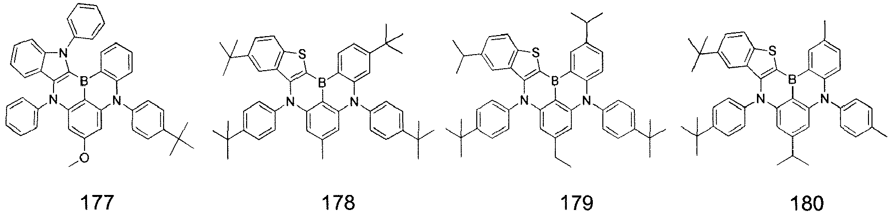

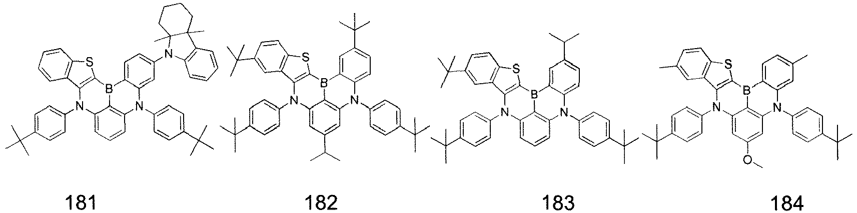

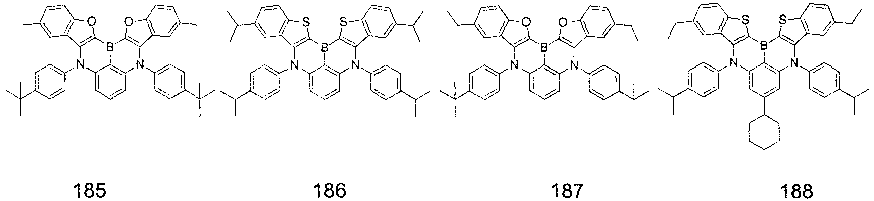

The specific examples of the substituents defined above can be found in the compounds of Formulae 1 to 188 but are not intended to limit the scope of the compound represented by Formula A-1 or A-2.

More specifically, the compound of Formula B employed in the capping layer of the organic electroluminescent device according to the present invention may be selected from the following compounds:

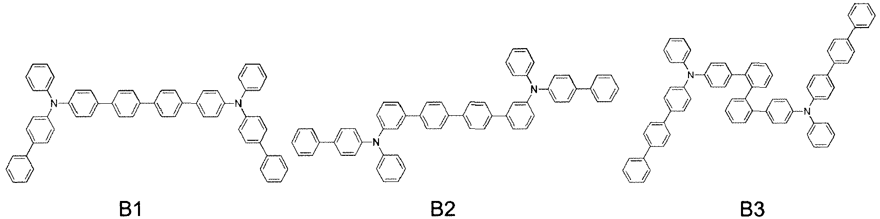

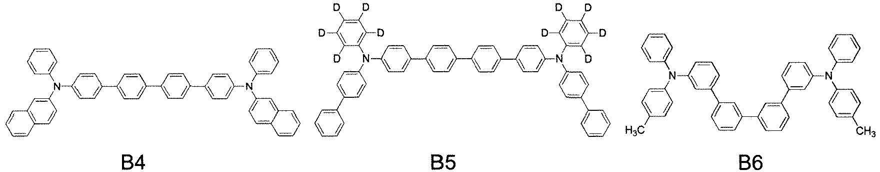

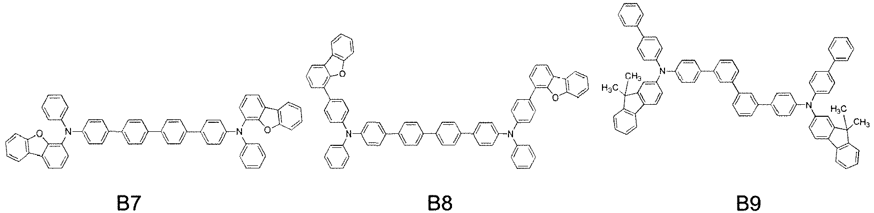

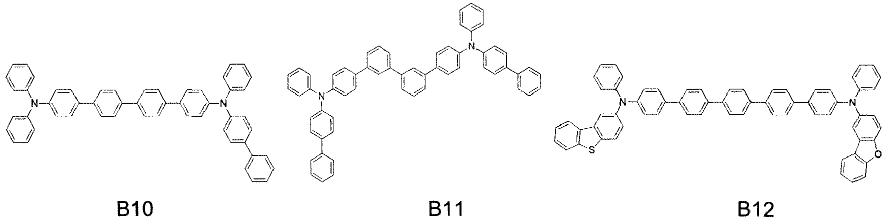

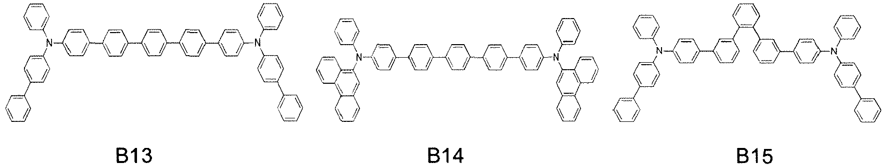

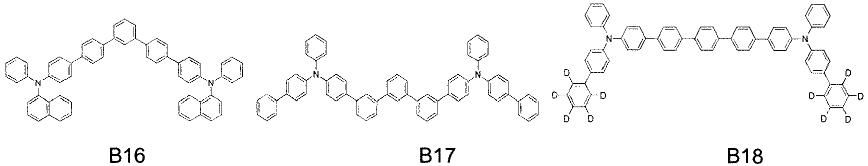

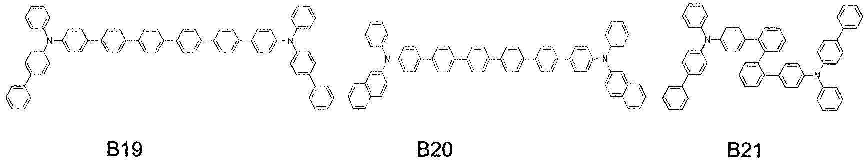

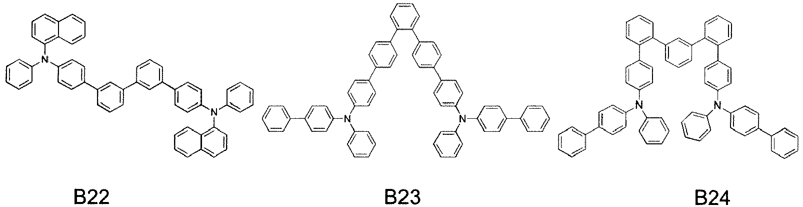

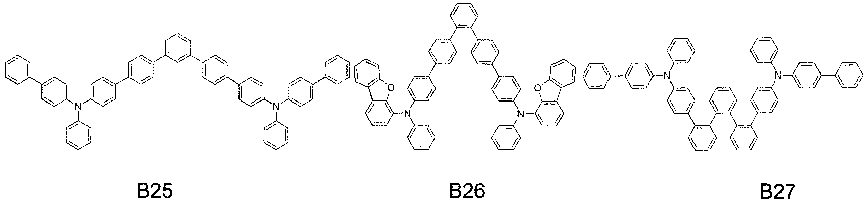

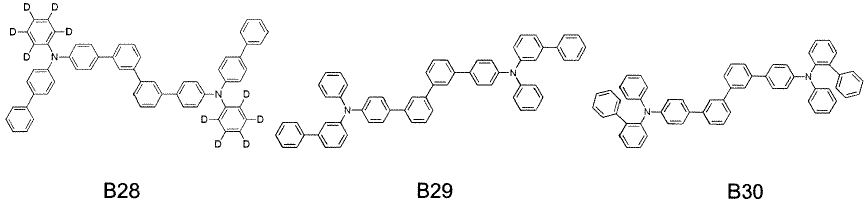

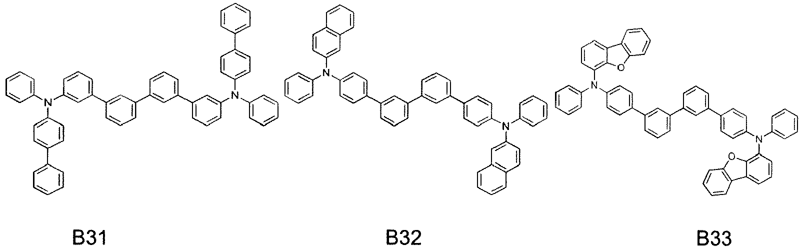

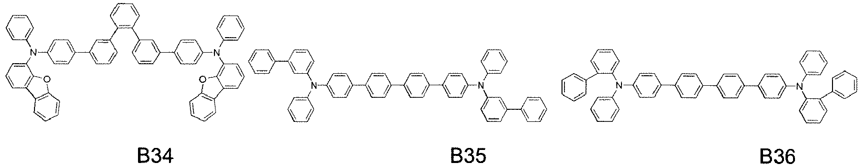

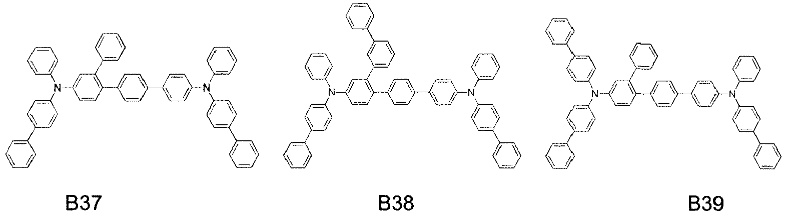

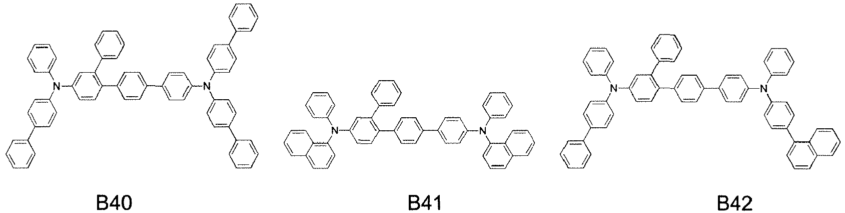

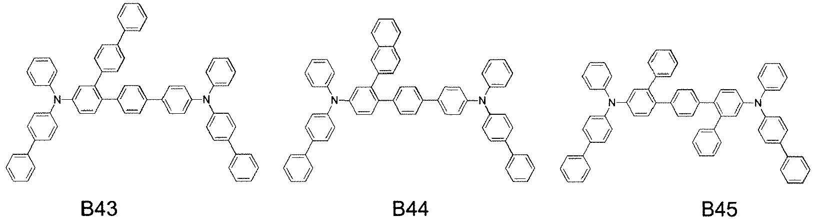

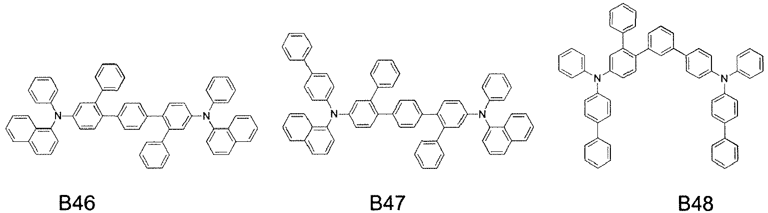

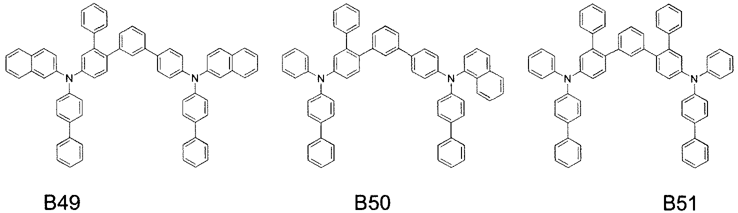

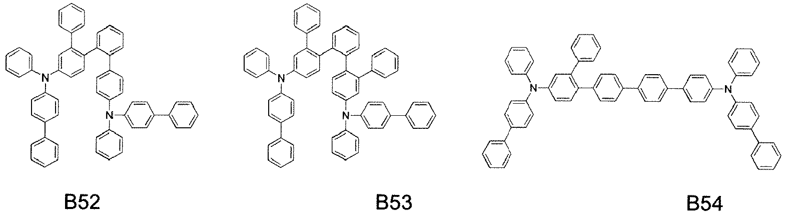

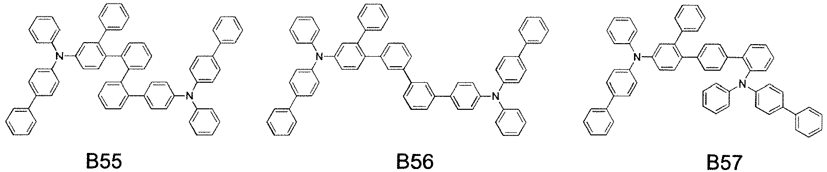

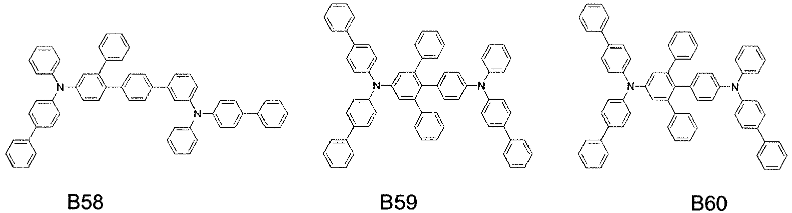

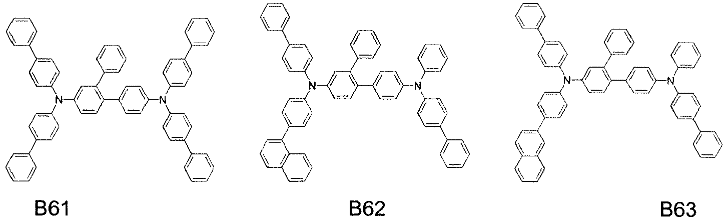

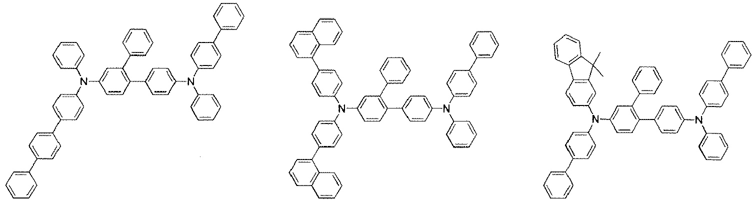

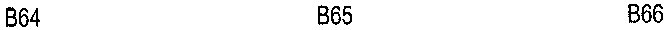

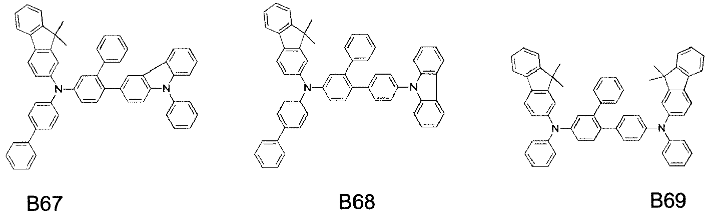

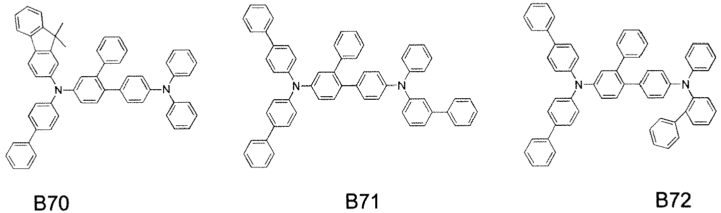

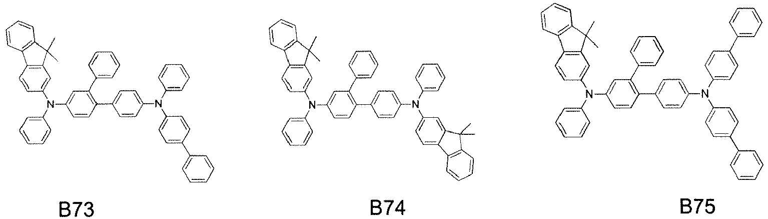

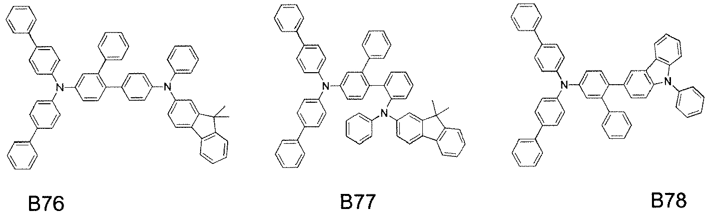

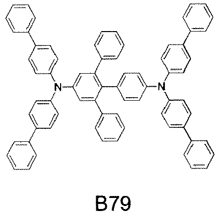

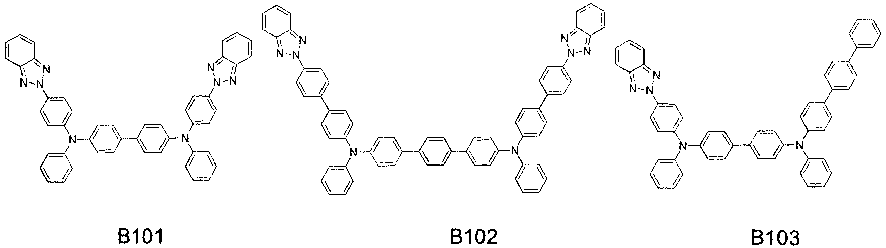

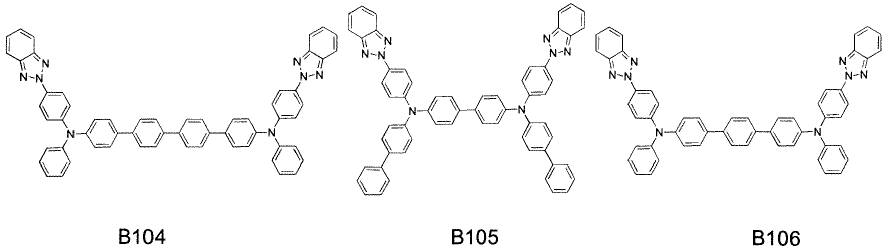

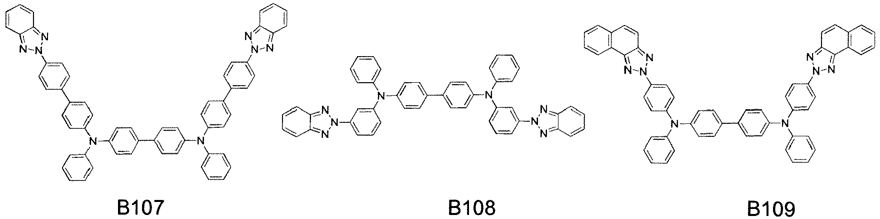

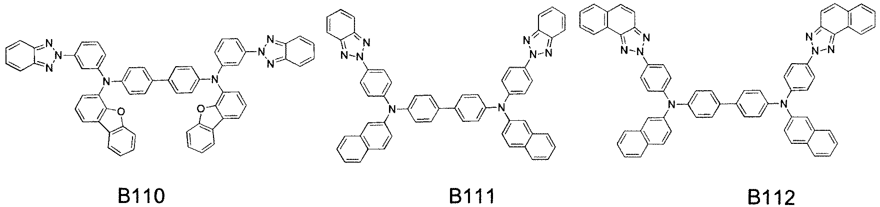

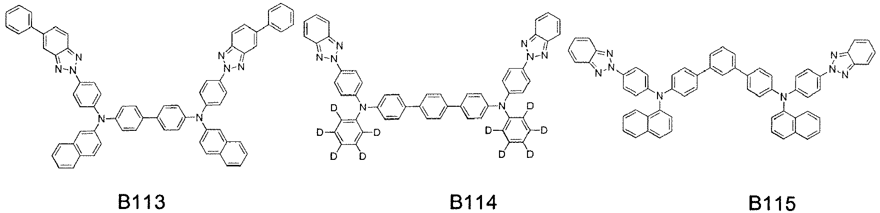

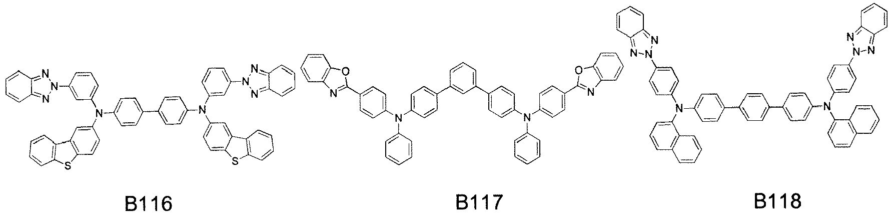

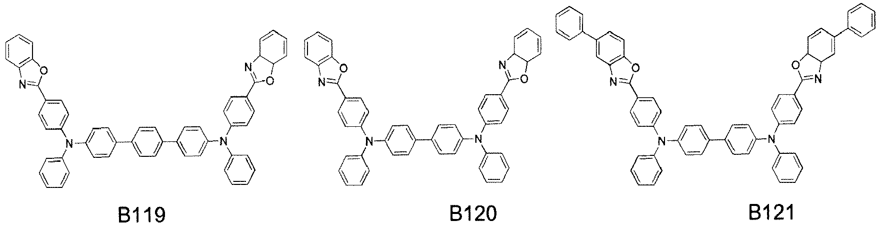

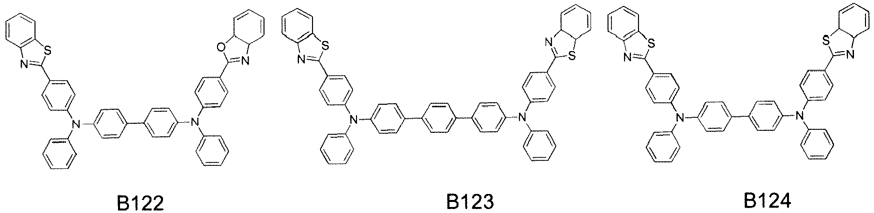

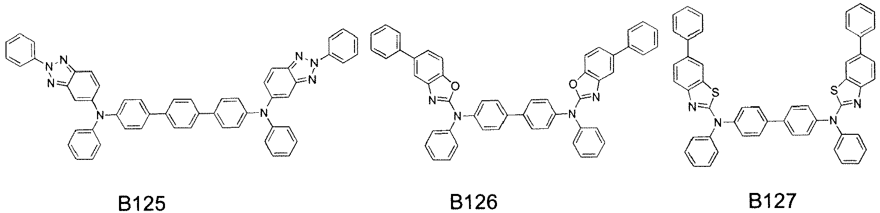

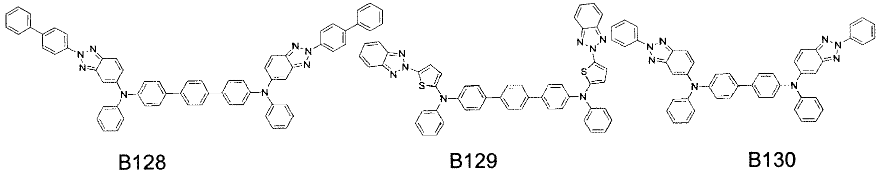

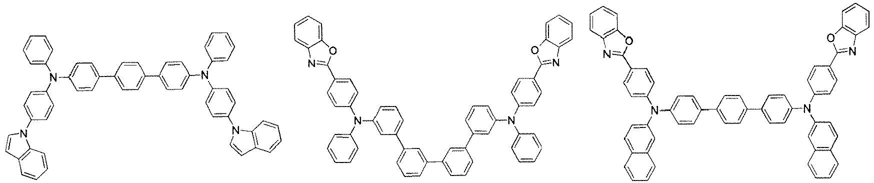

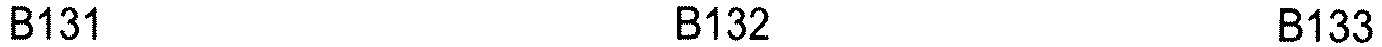

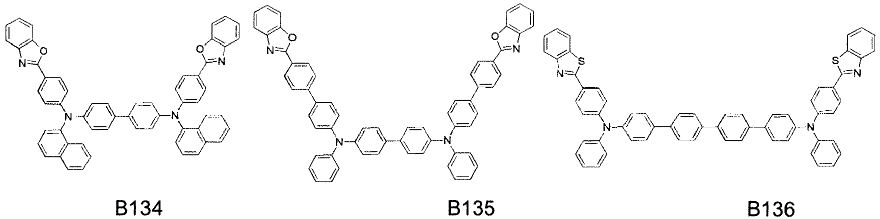

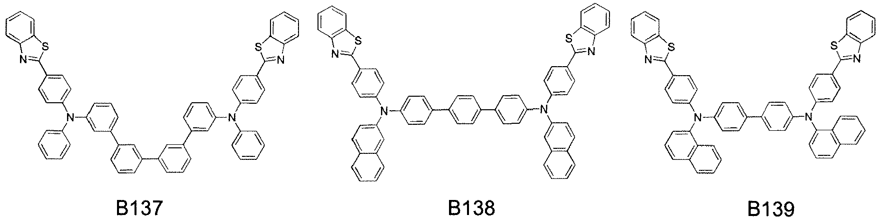

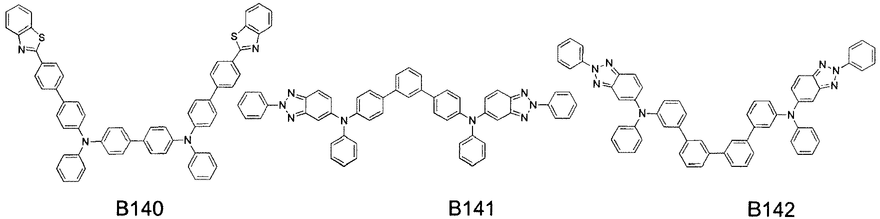

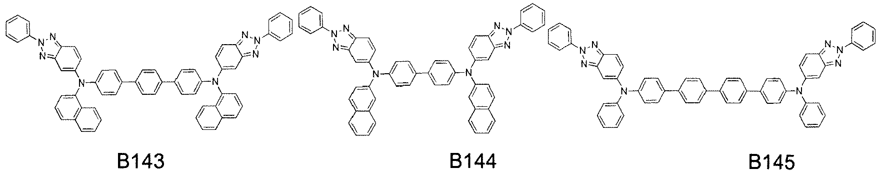

The specific examples of the substituents defined above can be found in the compounds of Formulae B1 to B145 but are not intended to limit the scope of the compound represented by Formula B.

The introduction of the characteristic skeletal structures and various substituents into the compounds employed in the light emitting layer and the capping layer of the organic electroluminescent device according to the present invention allows the compounds to have inherent characteristics of the skeletal structures and the substituents. This introduction makes the organic electroluminescent device highly efficient.

The organic electroluminescent device of the present invention may include one or more organic layers interposed between the first and second electrodes wherein at least one of the organic layers includes the compound represented by Formula A-1 or A-2. According to one embodiment of the present invention, the light emitting layer may be the organic layer including the compound represented by Formula A-1 or A-2.

That is, according to one embodiment of the present invention, the organic electroluminescent device has a structure in which the organic layers are arranged between the first electrode and the second electrode. The organic electroluminescent device of the present invention may be fabricated by a suitable method known in the art using suitable materials known in the art, except that the compound of Formula A-1 or A-2 is used to form the corresponding organic layer.

The organic layers of the organic electroluminescent device according to the present invention may form a monolayer structure. Alternatively, the organic layers may have a multilayer laminate structure. For example, the structure of the organic layers may include a hole injecting layer, a hole transport layer, a hole blocking layer, a light emitting layer, an electron blocking layer, an electron transport layer, and an electron injecting layer, but is not limited thereto. The number of the organic layers is not limited and may be increased or decreased. Preferred structures of the organic layers of the organic electroluminescent device according to the present invention will be explained in more detail in the Examples section that follows.

According to one embodiment of the present invention, the organic electroluminescent device further includes a substrate. In this embodiment, the first electrode serves as an anode, the second electrode serves as a cathode, and the capping layer is formed under the first electrode (bottom emission type) or on the second electrode (top emission type).

When the organic electroluminescent device is of a top emission type, light from the light emitting layer is emitted to the cathode and passes through the capping layer (CPL) formed using the compound of the present invention having a relatively high refractive index. The wavelength of the light is amplified in the capping layer, resulting in an increase in luminous efficiency. Also when the organic electroluminescent device is of a bottom emission type, the compound of the present invention can be employed in the capping layer to improve the luminous efficiency of the organic electroluminescent device based on the same principle.

A more detailed description will be given concerning one embodiment of the organic electroluminescent device according to of the present invention.

The organic electroluminescent device includes an anode, a hole transport layer, a light emitting layer, an electron transport layer, and a cathode. The organic electroluminescent device may optionally further include a hole injecting layer between the anode and the hole transport layer and an electron injecting layer between the electron transport layer and the cathode. If necessary, the organic electroluminescent device may further include one or two intermediate layers such as a hole blocking layer or an electron blocking layer. The organic electroluminescent device may further include one or more organic layers, including the capping layer, that have various functions depending on the desired characteristics of the device.

The light emitting layer of the organic electroluminescent device according to the present invention includes, as a host compound, an anthracene derivative represented by Formula D: 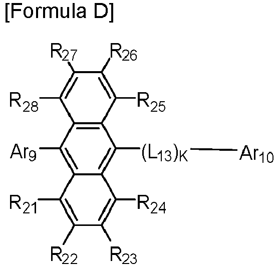 wherein R₂₁ to R₂₈ are identical to or different from each other and are as defined for R₁ to R₃ in Formula A-1 or A-2, Ar₉ and Ar₁₀ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, and substituted or unsubstituted C₆-C₃₀ arylsilyl, L₁₃ is a single bond or is selected from substituted or unsubstituted C₆-C₂₀ arylene and substituted or unsubstituted C₂-C₂₀ heteroarylene, preferably a single bond or substituted or unsubstituted C₆-C₂₀ arylene, and k is an integer from 1 to 3, provided that when k is 2 or more, the linkers L₁₃ are identical to or different from each other.

Ar₉ in Formula D is represented by Formula D-1: 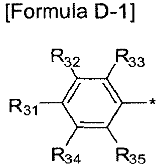 wherein R₃₁ to R₃₅ are identical to or different from each other and are as defined for R₁ to R₅ in Formula A-1 or A-2, and each of R₃₁ to R₃₅ is optionally bonded to an adjacent substituent to form a saturated or unsaturated ring.

The compound of Formula D employed in the organic electroluminescent device of the present invention may be specifically selected from the compounds of Formulae D1 to D48:

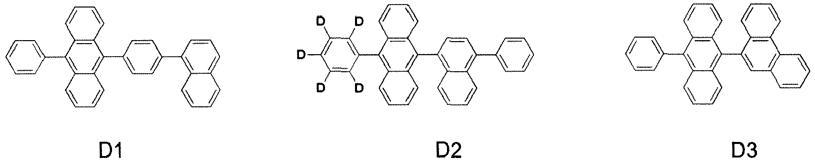

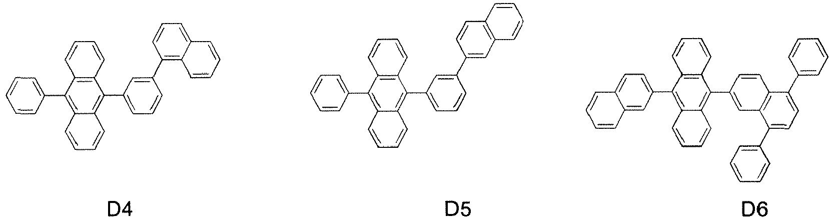

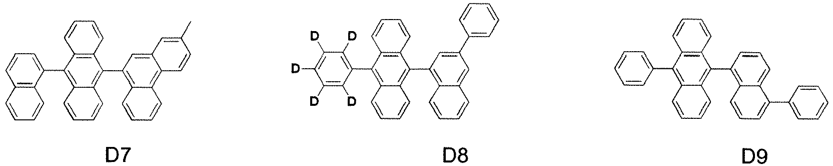

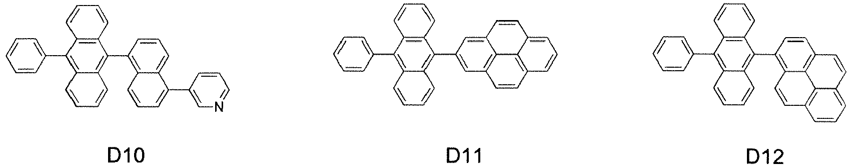

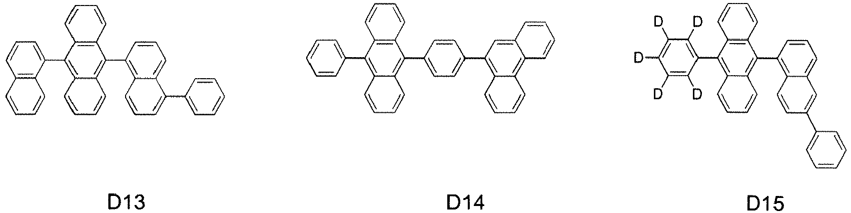

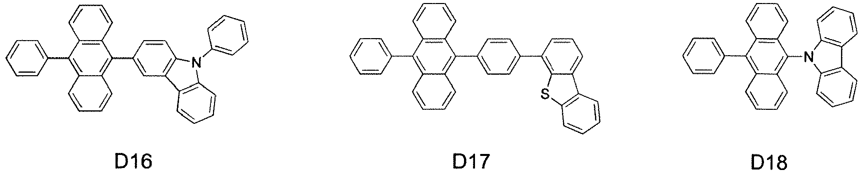

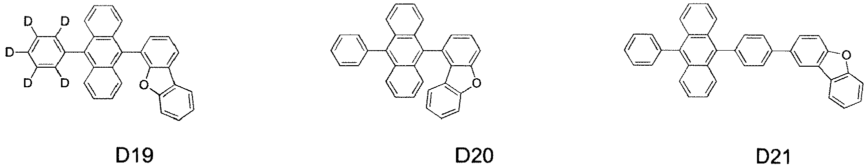

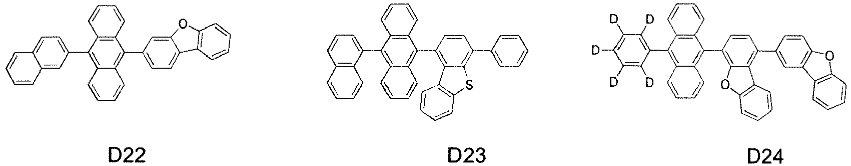

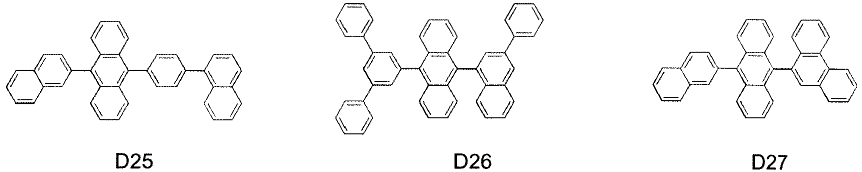

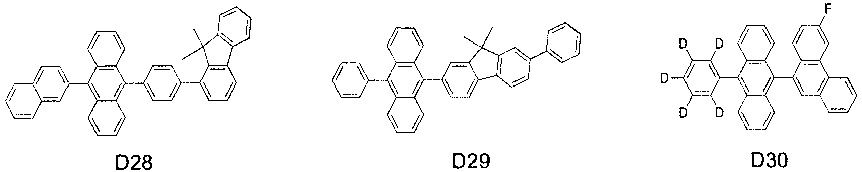

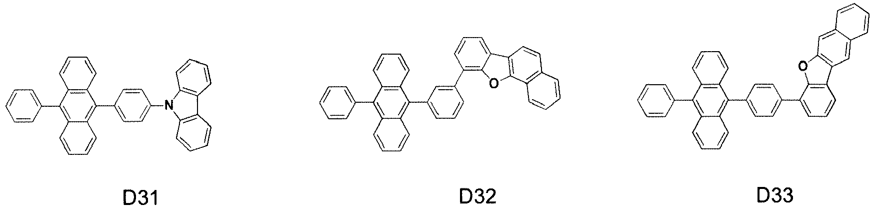

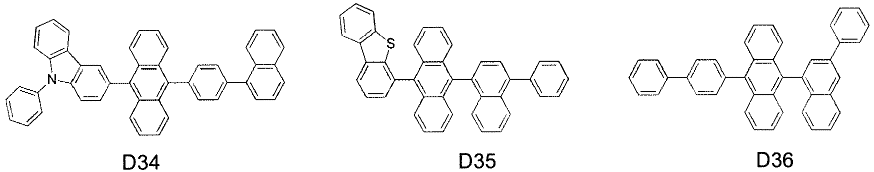

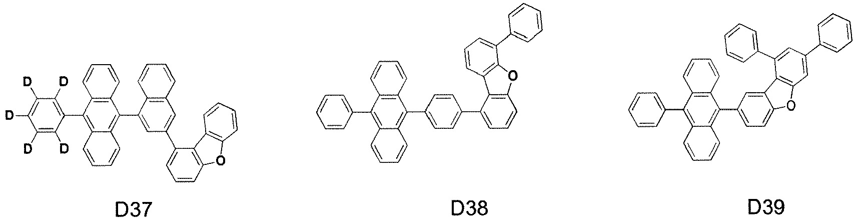

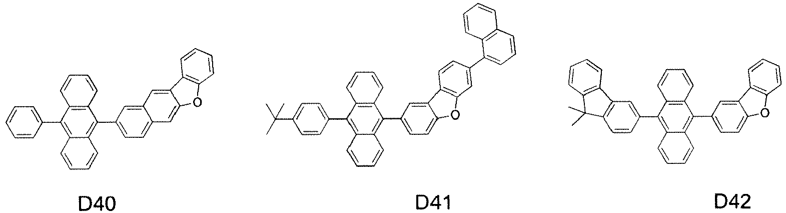

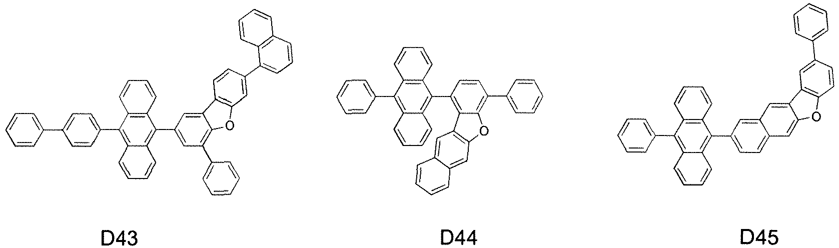

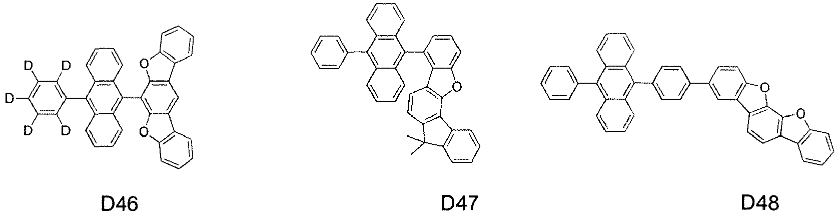

Each of the hole transport layer and the electron blocking layer may include a compound represented by Formula E: 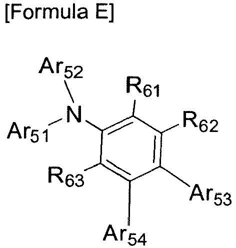 wherein R₆₁ to R₆₃ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₆-C₃₀ arylthioxy, substituted or unsubstituted C₁-C₃₀ alkylamine, substituted or unsubstituted C₆-C₃₀ arylamine, substituted or unsubstituted C₁-C₃₀ alkylsilyl, substituted or unsubstituted C₆-C₃₀ arylsilyl, substituted or unsubstituted C₁-C₃₀ alkylgermanium, substituted or unsubstituted C₁-C₃₀ arylgermanium, cyano, nitro, and halogen, and Ar₅₁ to Ar₅₄ are identical to or different from each other and are each independently substituted or unsubstituted C₆-C₄₀ aryl or substituted or unsubstituted C₂-C₃₀ heteroaryl.

The compound of Formula E employed in the organic electroluminescent device of the present invention may be specifically selected from the compounds of Formulae E1 to E33:

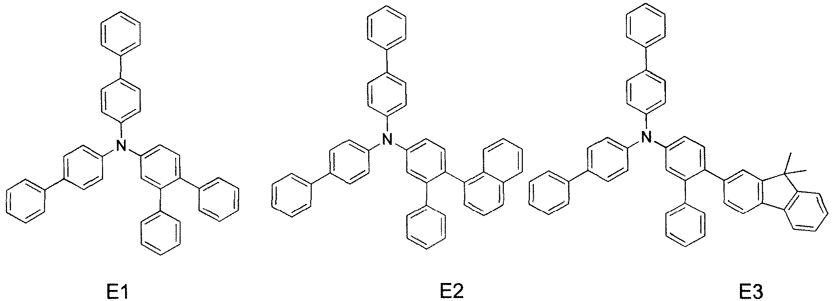

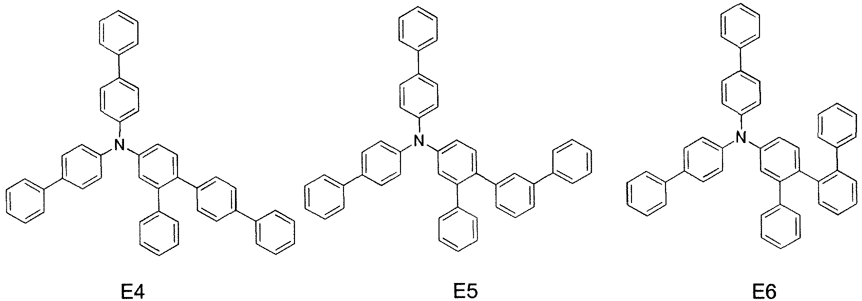

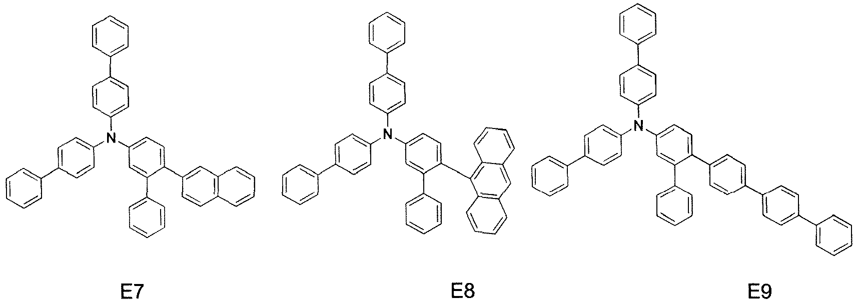

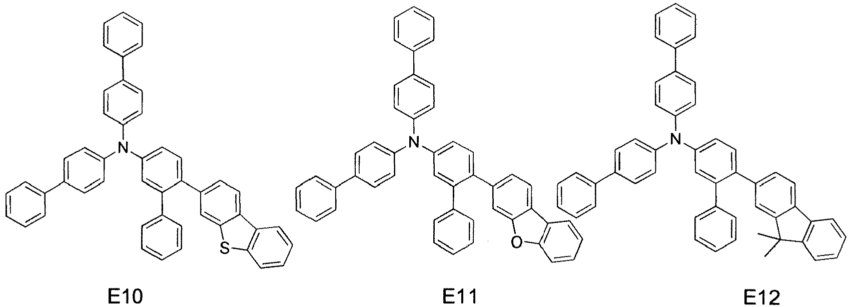

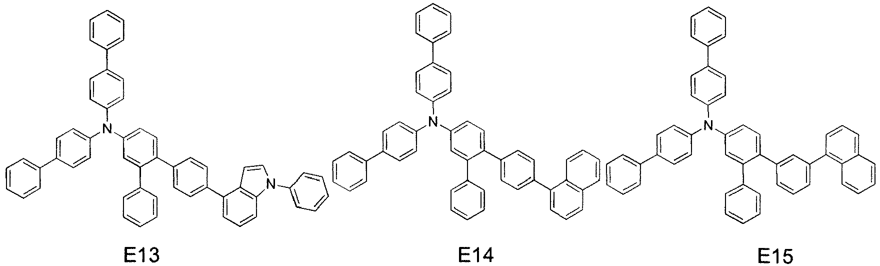

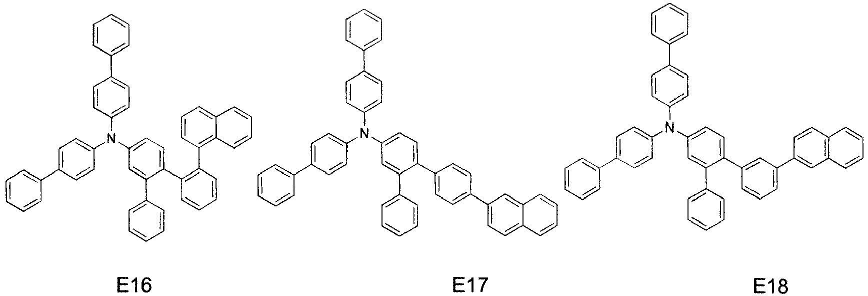

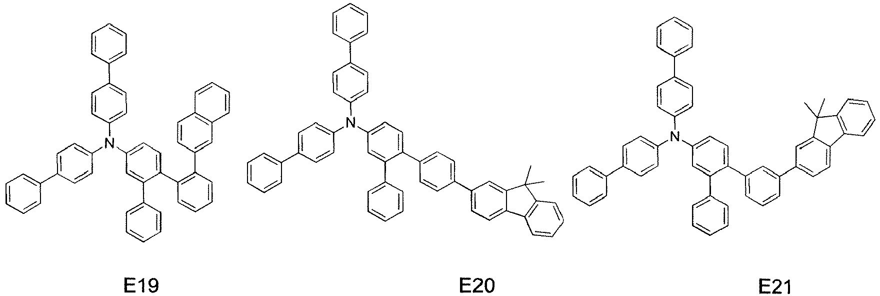

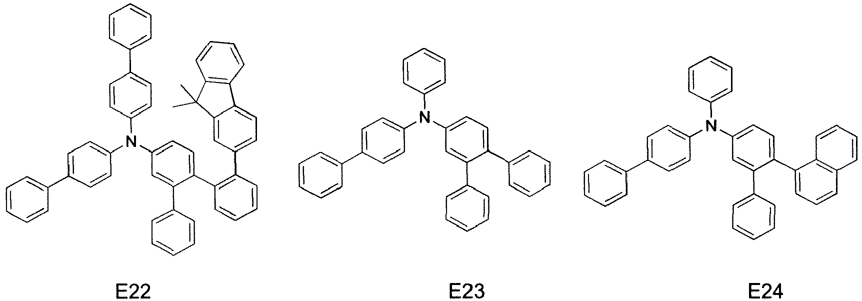

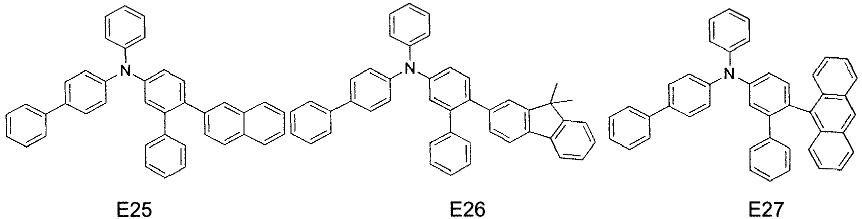

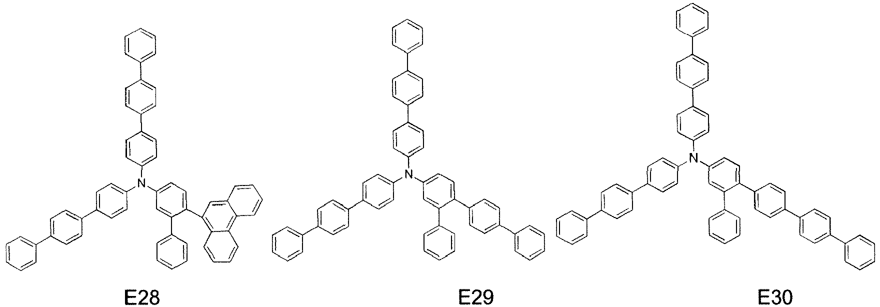

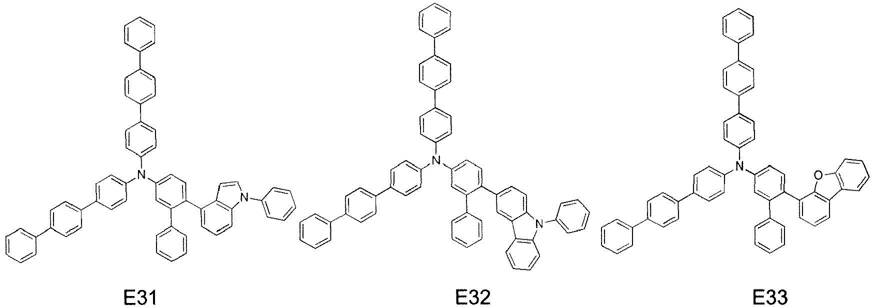

A specific structure of the organic electroluminescent device according to the present invention, a method for fabricating the device, and materials for the organic layers will be described below.

First, a material for the anode is coated on the substrate to form the anode. The substrate may be any of those used in general electroluminescent devices. The substrate is preferably an organic substrate or a transparent plastic substrate that is excellent in transparency, surface smoothness, ease of handling, and waterproofness. A highly transparent and conductive metal oxide, such as indium tin oxide (ITO), indium zinc oxide (IZO), tin oxide (SnO₂) or zinc oxide (ZnO), is used as the anode material.

A material for the hole injecting layer is coated on the anode by vacuum thermal evaporation or spin coating to form the hole injecting layer. Then, a material for the hole transport layer is coated on the hole injecting layer by vacuum thermal evaporation or spin coating to form the hole transport layer.

The material for the hole injecting layer is not specially limited so long as it is usually used in the art. Specific examples of such materials include 4,4',4"-tris(2-naphthyl(phenyl)amino)triphenylamine (2-TNATA), N,N'-di(1-naphthyl)-N,N'-diphenylbenzidine (NPD), N,N'-diphenyl-N,N'-bis(3-methylphenyl)-1,1'-biphenyl-4,4'-diamine (TPD), and N,N'-diphenyl-N,N'-bis[4-(phenyl-m-tolylamino)phenyl]biphenyl-4,4'-diamine (DNTPD).

The material for the hole transport layer is not specially limited so long as it is commonly used in the art. Examples of such materials include N,N'-bis(3-methylphenyl)-N,N'-diphenyl-[1,1-biphenyl]-4,4'-diamine (TPD) and N,N'-di(naphthalen-1-yl)-N,N'-diphenylbenzidine (α-NPD).

Subsequently, a hole auxiliary layer and the light emitting layer are sequentially laminated on the hole transport layer. A hole blocking layer may be optionally formed on the organic light emitting layer by vacuum thermal evaporation or spin coating. The hole blocking layer blocks holes from entering the cathode through the organic light emitting layer. This role of the hole blocking layer prevents the lifetime and efficiency of the device from deteriorating. A material having a very low highest occupied molecular orbital (HOMO) energy level is used for the hole blocking layer. The hole blocking material is not particularly limited so long as it has the ability to transport electrons and a higher ionization potential than the light emitting compound. Representative examples of suitable hole blocking materials include BAIq, BCP, and TPBI.

Examples of materials for the hole blocking layer include, but are not limited to, BAIq, BCP, Bphen, TPBI, NTAZ, BeBq₂, OXD-7, Liq, and the compounds of Formulae 501 to 507:

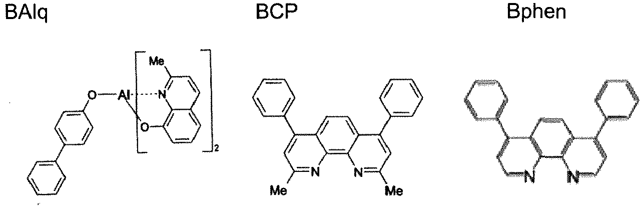

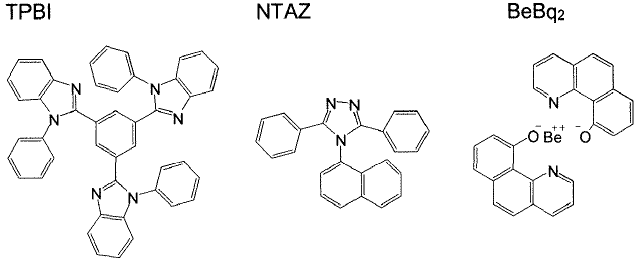

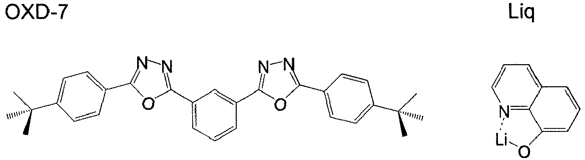

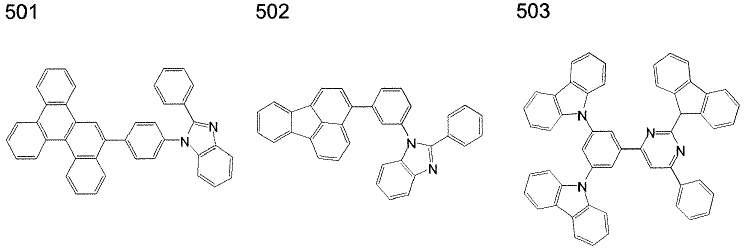

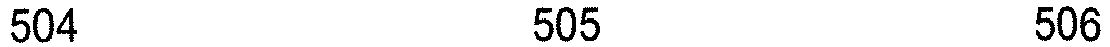

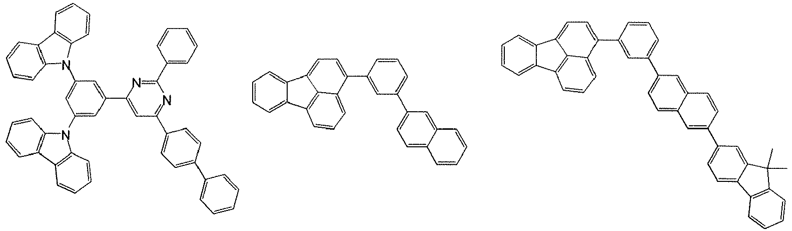

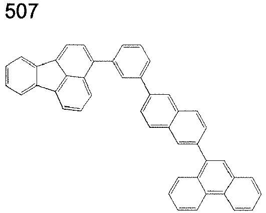

The electron transport layer is deposited on the hole blocking layer by vacuum thermal evaporation or spin coating, and the electron injecting layer is formed thereon. A metal for the cathode is deposited on the electron injecting layer by vacuum thermal evaporation to form the cathode, completing the fabrication of the organic electroluminescent device.

As the metal for the formation of the cathode, there may be used, for example, lithium (Li), magnesium (Mg), aluminum (Al), aluminum-lithium (Al-Li), calcium (Ca), magnesium-indium (Mg-In) or magnesium-silver (Mg-Ag). The organic electroluminescent device may be of top emission type. In this case, a transmissive material, such as ITO or IZO, may be used to form the cathode.

The material for the electron transport layer functions to stably transport electrons injected from the cathode. The electron transport material may be any of those known in the art and examples thereof include, but are not limited to, quinoline derivatives, particularly, tris(8-quinolinolate)aluminum (Alq3), TAZ, BAIq, beryllium bis(benzoquinolin-10-olate (Bebq2), ADN, the compounds of Formulae 401 and 402, and oxadiazole derivatives, such as PBD, BMD, and BND:

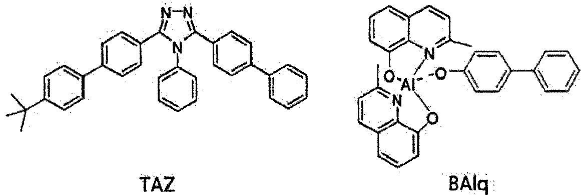

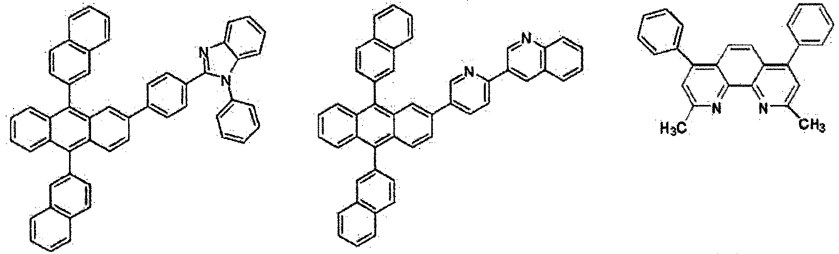

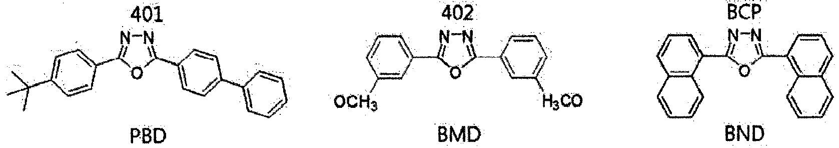

The light emitting layer may further include various host materials and various dopant materials.

Each of the organic layers can be formed by a monomolecular deposition or solution process. According to the monomolecular deposition process, the material for each layer is evaporated under heat and vacuum or reduced pressure to form the layer in the form of a thin film. According to the solution process, the material for each layer is mixed with a suitable solvent, and then the mixture is formed into a thin film by a suitable method, such as ink-jet printing, roll-to-roll coating, screen printing, spray coating, dip coating or spin coating.

The organic electroluminescent device of the present invention can be used in a display or lighting system selected from flat panel displays, flexible displays, monochromatic flat panel lighting systems, white flat panel lighting systems, flexible monochromatic lighting systems, and flexible white lighting systems.

The present invention will be explained in more detail with reference to the following examples.

However, it will be obvious to those skilled in the art that these examples are in no way intended to limit the scope of the invention.

### <Synthesis of the compounds represented by Formula A-1/Formula A-2>

### Synthesis Example 1: Synthesis of Compound 1

### Synthesis Example 1-1: Synthesis of Intermediate 1-a

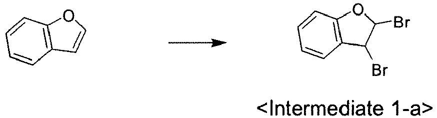

Benzofuran (50 g, 423 mmol) and dichloromethane (500 mL) were stirred in a 1 L reactor. The mixture was cooled to -10 °C and a dilute solution of bromine (67.7 g, 423 mmol) in dichloromethane (100 mL) was added dropwise thereto. The resulting mixture was stirred at 0 °C for 2 h. After completion of the reaction, the reaction mixture was added with an aqueous sodium thiosulfate solution, stirred, and extracted with ethyl acetate and H₂O. The organic layer was recrystallized from ethanol to afford Intermediate 1-a (100 g, yield 93%).

### Synthesis Example 1-2: Synthesis of Intermediate 1-b

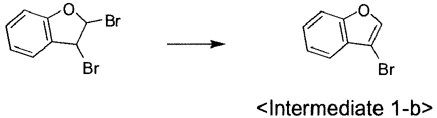

Potassium hydroxide (48.6 g, 866 mmol) and ethanol (400 mL) were dissolved in a 1 L reactor and a solution of Intermediate 1-a (120 g, 433 mmol) in ethanol was added dropwise thereto at 0 °C. After the dropwise addition was finished, the mixture was refluxed with stirring for 2 h. After completion of the reaction, the reaction mixture was concentrated under reduced pressure to remove the ethanol and extracted with ethyl acetate and water. The organic layer was concentrated and purified by column chromatography to afford Intermediate 1-b (42 g, yield 50%)

### Synthesis Example 1-3: Synthesis of Intermediate 1-c

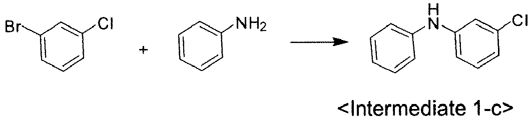

1-Bromo-3-iodobenzene (4.5 g, 16 mmol), aniline (5.8 g, 16 mmol), palladium acetate (0.1 g, 1 mmol), sodium tert-butoxide (3 g, 32 mmol), bis(diphenylphosphino)-1,1'-binaphthyl (0.2 g, 1 mmol), and toluene (45 mL) were placed in a 100 mL reactor. The mixture was refluxed with stirring for 24 h. After completion of the reaction, the reaction mixture was filtered. The filtrate was concentrated and purified by column chromatography to afford Intermediate 1-c (5.2 g, yield 82%).

### Synthesis Example 1-4: Synthesis of Intermediate 1-d

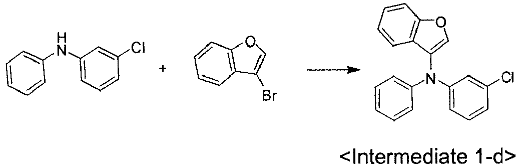

Intermediate 1-c (20 g, 98 mmol), Intermediate 1-b (18.4 g, 98 mmol), palladium acetate (0.5 g, 2 mmol), sodium tert-butoxide (18.9 g, 196 mmol), tri-tert-butylphosphine (0.8 g, 4 mmol), and toluene (200 mL) were placed in a 250 mL reactor. The mixture was refluxed with stirring. After completion of the reaction, the reaction mixture was filtered. The filtrate was concentrated and purified by column chromatography to afford Intermediate 1-d (22 g, yield 75%)

### Synthesis Example 1-5: Synthesis of Intermediate 1-e

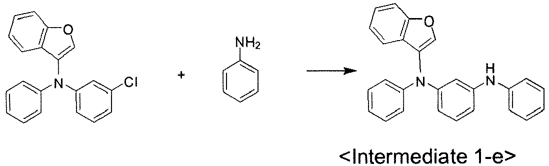

Intermediate 1-e (18.5 g, yield 74.1%) was synthesized in the same manner as in Synthesis Example 1-3, except that Intermediate 1-d was used instead of 1-bromo-4-iodobenzene.

### Synthesis Example 1-6: Synthesis of Intermediate 1-f

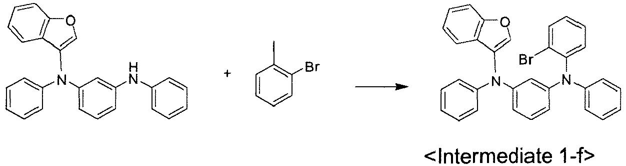

Intermediate 1-f (12 g, yield 84.1%) was synthesized in the same manner as in Synthesis Example 1-4, except that Intermediate 1-e and 1-bromo-2-iodobenzene were used instead of Intermediate 1-c and Intermediate 1-b.

### Synthesis Example 1-7: Synthesis of Compound 1

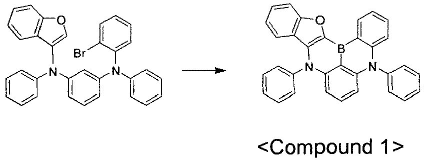

Intermediate 1-f (12 g, 23 mmol) and tert-butylbenzene (120 mL) were placed in a 300 mL reactor, and n-butyllithium (42.5 mL, 68 mmol) was added dropwise thereto at -78 °C. After the dropwise addition was finished, the mixture was stirred at 60 °C for 3 h. Thereafter, the reactor was flushed with nitrogen to remove heptane. After dropwise addition of boron tribromide (11.3 g, 45 mmol) at -78 °C, the resulting mixture was stirred at room temperature for 1 h and N,N-diisopropylethylamine (5.9 g, 45 mmol) was added dropwise thereto at 0 °C. After the dropwise addition was finished, the mixture was stirred at 120 °C for 2 h. After completion of the reaction, the reaction mixture was added with an aqueous sodium acetate solution at room temperature, stirred, and extracted with ethyl acetate. The organic layer was concentrated and purified by column chromatography to give Compound 1 (0.8 g, yield 13%).
MS (MALDI-TOF): m/z 460.17 [M+]

### Synthesis Example 2: Synthesis of Compound 2

### Synthesis Example 2-1: Synthesis of Intermediate 2-a

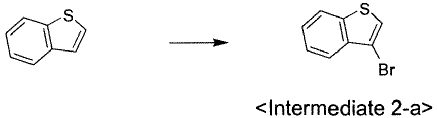

Benzothiophene (50 g, 373 mmol) and chloroform (500 mL) were stirred in a 1 L reactor. The mixture was cooled to 0 °C and a dilute solution of bromine (59.5 g, 373 mmol) in chloroform (100 mL) was added dropwise thereto. After the dropwise addition was finished, the resulting mixture was stirred at room temperature for 4 h. After completion of the reaction, the reaction mixture was added with an aqueous sodium thiosulfate solution, stirred, and extracted. The organic layer was concentrated under reduced pressure and purified by column chromatography to afford Intermediate 2-a (70 g, yield 91%)

### Synthesis Example 2-2: Synthesis of Intermediate 2-b

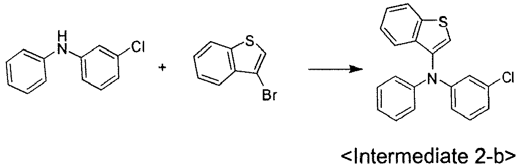

Intermediate 2-b (32 g, yield 75.4%) was synthesized in the same manner as in Synthesis Example 1-4, except that Intermediate 2-a was used instead of Intermediate 1-b.

### Synthesis Example 2-3: Synthesis of Intermediate 2-c

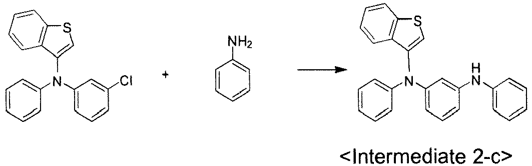

Intermediate 2-c (24.5 g, yield 73.1%) was synthesized in the same manner as in Synthesis Example 1-3, except that Intermediate 2-b was used instead of 1-bromo-4-iodobenzene.

### Synthesis Example 2-4: Synthesis of Intermediate 2-d

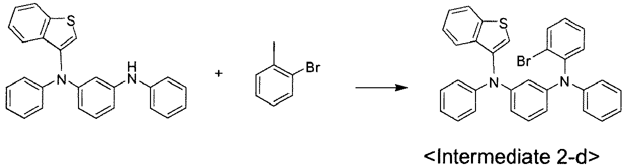

Intermediate 2-d (21 g, yield 77.5%) was synthesized in the same manner as in Synthesis Example 1-4, except that Intermediate 2-c and 1-bromo-2-iodobenzene were used instead of Intermediate 1-c and Intermediate 1-b.

### Synthesis Example 2-5: Synthesis of Compound 2

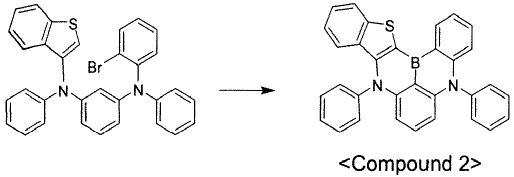

Compound 2 (1.5 g, yield 10.1%) was synthesized in the same manner as in Synthesis Example 1-7, except that Intermediate 2-d was used instead of Intermediate 1-f.
MS (MALDI-TOF) : m/z 467.15 [M⁺]

### Synthesis Example 3: Synthesis of Compound 13

### Synthesis Example 3-1: Synthesis of Intermediate 3-a

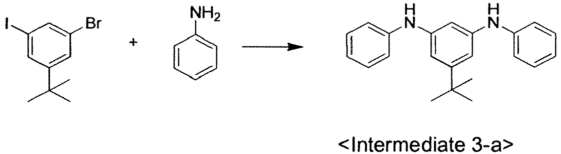

1-Bromo-3(tert-butyl)-5-iodobenzene (50 g, 177 mmol), aniline (36.2 g, 389 mmol), palladium acetate (1.6 g, 7 mmol), sodium tert-butoxide (51 g, 530 mmol), bis(diphenylphosphino)-1,1'-binaphthyl (4.4 g, 7 mmol), and toluene (500 mL) were placed in a 1 L reactor. The mixture was refluxed with stirring for 24 h. After completion of the reaction, the reaction mixture was filtered, concentrated, and purified by column chromatography to afford Intermediate 3-a (42.5 g, yield 50%).

### Synthesis Example 3-2: Synthesis of Intermediate 3-b

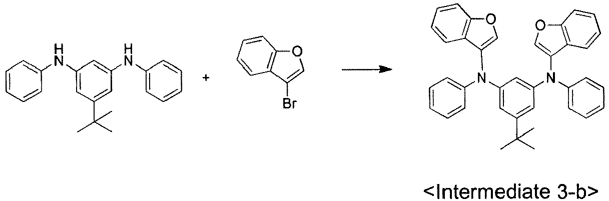

Intermediate 3-a (11 g, 42 mmol), Intermediate 1-b (20 g, 101 mmol), palladium acetate (1 g, 2 mmol), sodium tert-butoxide (12.2 g, 127 mmol), tri-tert-butylphosphine (0.7 g, 3 mmol), and toluene (150 mL) were placed in a 250 mL reactor. The mixture was refluxed with stirring for 5 h. After completion of the reaction, the reaction mixture was filtered. The filtrate was concentrated and purified by column chromatography to afford Intermediate 3-b (11 g, yield 65%)

### Synthesis Example 3-3: Synthesis of Compound 13

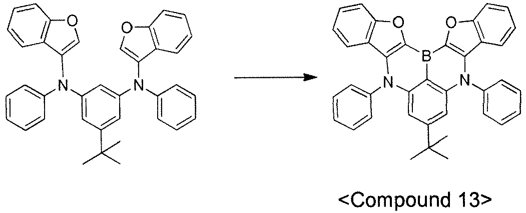

Compound 13 (0.5 g, yield 8%) was synthesized in the same manner as in Synthesis Example 1-7, except that Intermediate 3-b was used instead of Intermediate 1-f.
MS (MALDI-TOF) : m/z 556.23 [M⁺]

### Synthesis Example 4: Synthesis of Compound 65

### Synthesis Example 4-1: Synthesis of Intermediate 4-a

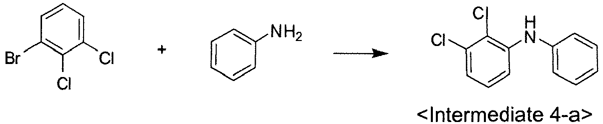

Intermediate 4-a (35.6 g, yield 71.2%) was synthesized in the same manner as in Synthesis Example 1-3, except that 1-bromo-2,3-dichlorobenzene was used instead of 1-bromo-4-iodobenzene.

### Synthesis Example 4-2: Synthesis of Intermediate 4-b

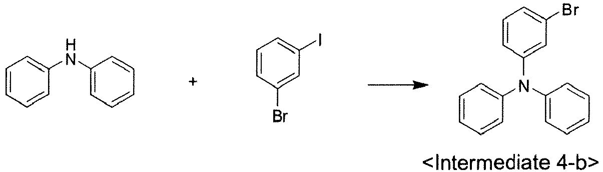

Diphenylamine (60.0 g, 355 mmol), 1-bromo-3-iodobenzene (100.3 g, 355 mmol), palladium acetate (0.8 g, 4 mmol), xantphos (2 g, 4 mmol), sodium tert-butoxide (68.2 g, 709 mmol), and toluene (700 mL) were placed in a 2 L reactor. The mixture was refluxed with stirring for 2 h. After completion of the reaction, the reaction mixture was filtered at room temperature, concentrated under reduced pressure, and purified by column chromatography to afford Intermediate 4-b (97 g, yield 91.2%).

### Synthesis Example 4-3: Synthesis of Intermediate 4-c

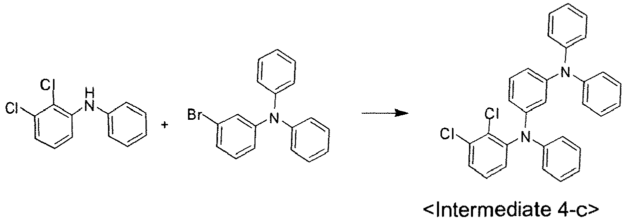

Intermediate 4-c (31 g, yield 77.7%) was synthesized in the same manner as in Synthesis Example 1-4, except that Intermediate 4-a and Intermediate 4-b were used instead of Intermediate 1-c and Intermediate 1-b.

### Synthesis Example 4-4: Synthesis of Intermediate 4-d

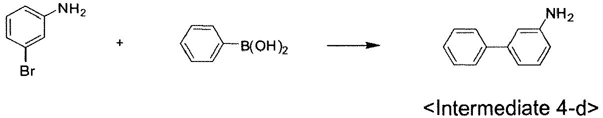

3-Bromoaniline (30 g, 174 mmol), phenylboronic acid (25.5 g, 209 mmol), tetrakis(triphenylphosphine)palladium (4 g, 3 mmol), potassium carbonate (48.2 g, 349 mmol), 1,4-dioxane (150 mL), toluene (150 mL), and distilled water (90 mL) were placed in a 1 L reactor. The mixture was refluxed with stirring for 4 h. After completion of the reaction, the reaction mixture was allowed to stand for layer separation. The organic layer was concentrated under reduced pressure and purified by column chromatography to afford Intermediate 4-d (24 g, yield 80%).

### Synthesis Example 4-5: Synthesis of Intermediate 4-e

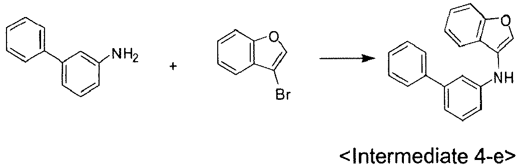

Intermediate 4-e (31.6 g, yield 68.2%) was synthesized in the same manner as in Synthesis Example 1-3, except that Intermediate 4-d and Intermediate 1-b were used instead of 1-bromo-4-iodobenzene and aniline.

### Synthesis Example 4-6: Synthesis of Intermediate 4-f

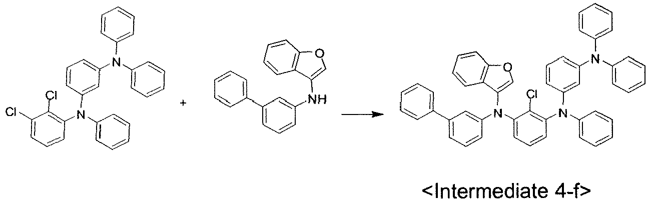

Intermediate 4-f (21 g, yield 67.7%) was synthesized in the same manner as in Synthesis Example 1-4, except that Intermediate 4-c and Intermediate 4-e were used instead of Intermediate 1-c and Intermediate 1-b.

### Synthesis Example 4-7: Synthesis of Compound 65

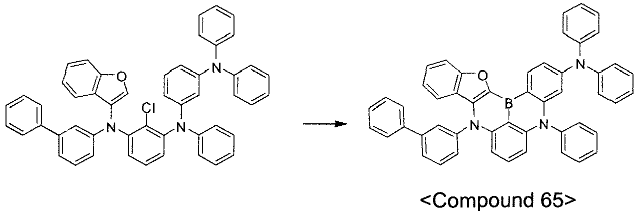

Intermediate 4-f (21 g, 37 mmol) and tert-butylbenzene were placed in a 250 mL reactor, and tert-butyllithium (42.4 mL, 74 mmol) was added dropwise thereto at -78 °C. After the dropwise addition was finished, the mixture was stirred at 60 °C for 3 h. Thereafter, the reactor was flushed with nitrogen to remove pentane. After dropwise addition of boron tribromide (7.1 mL, 74 mmol) at -78 °C, the resulting mixture was stirred at room temperature for 1 h and N,N-diisopropylethylamine (6 g, 74 mmol) was added dropwise thereto at 0 °C. The mixture was stirred at 120 °C for 2 h. After completion of the reaction, the reaction mixture was added with an aqueous sodium acetate solution, stirred, and extracted with ethyl acetate. The organic layer was concentrated and purified by column chromatography to give Compound 65 (2.0 g, yield 17.4%).
MS (MALDI-TOF) : m/z 703.28 [M⁺]

### Synthesis Example 5: Synthesis of Compound 73

### Synthesis Example 5-1: Synthesis of Intermediate 5-a

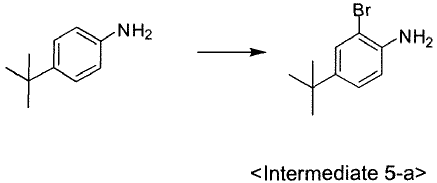

4-tert-butylaniline (40 g, 236 mmol) was dissolved in methylene chloride (400 mL) in a 1 L reactor. The mixture was stirred at 0 °C. Thereafter, N-bromosuccinimide (42 g, 236 mmol) was added to the reactor. The resulting mixture was stirred at room temperature for 4 h. After completion of the reaction, H₂O was added dropwise to the reaction mixture at room temperature, followed by extraction with methylene chloride. The organic layer was concentrated and purified by column chromatography to afford Intermediate 5-a (48 g, yield 80%).

### Synthesis Example 5-2: Synthesis of Intermediate 5-b

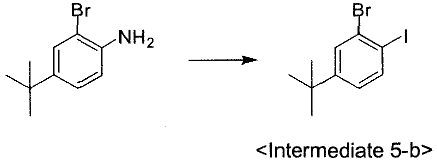

Intermediate 5-a (80 g, 351 mmol) and water (450 mL) were stirred in a 2 L reactor. The mixture was added with sulfuric acid (104 mL) and a solution of sodium nitrite (31.5 g, 456 mmol) in water (240 mL) was added dropwise thereto at 0 °C. After the dropwise addition was finished, the resulting mixture was stirred at 0 °C for 2 h. After dropwise addition of a solution of potassium iodide (116.4 g, 701 mmol) in water (450 mL), the mixture was stirred at room temperature for 6 h. After completion of the reaction, the reaction mixture was added with an aqueous sodium thiosulfate solution at room temperature, stirred, and extracted with ethyl acetate. The organic layer was purified by column chromatography to afford Intermediate 5-b (58 g, yield 51%).

### Synthesis Example 5-3: Synthesis of Intermediate 5-c

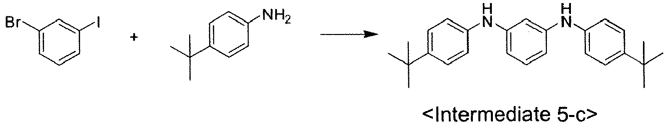

Intermediate 5-c (95 g, yield 80.4%) was synthesized in the same manner as in Synthesis Example 3-1, except that 4-tert-butylaniline was used instead of aniline.

### Synthesis Example 5-4: Synthesis of Intermediate 5-d

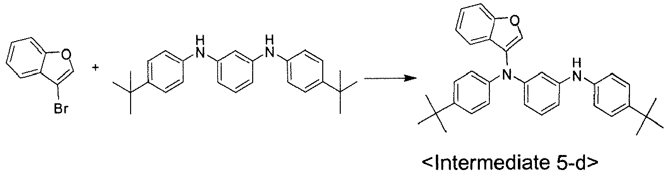

Intermediate 5-d (31 g, yield 71.5%) was synthesized in the same manner as in Synthesis Example 1-4, except that Intermediate 5-c was used instead of Intermediate 1-c.

### Synthesis Example 5-5: Synthesis of Intermediate 5-e

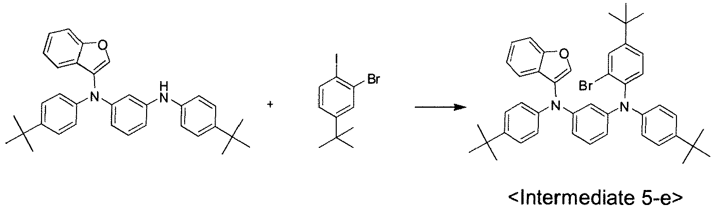

Intermediate 5-e (24 g, yield 67.1%) was synthesized in the same manner as in Synthesis Example 1-4, except that Intermediate 5-d and Intermediate 5-b were used instead of Intermediate 1-c and Intermediate 1-b.

### Synthesis Example 5-6: Synthesis of Compound 73

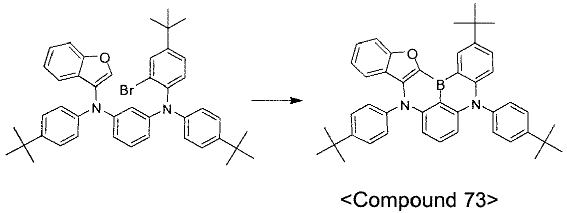

Compound 73 (2.4 g, yield 15%) was synthesized in the same manner as in Synthesis Example 1-7, except that Intermediate 5-e was used instead of Intermediate 1-f.
MS (MALDI-TOF) : m/z 628.36 [M⁺]

### Synthesis Example 6: Synthesis of Compound 109

### Synthesis Example 6-1: Synthesis of Intermediate 6-a

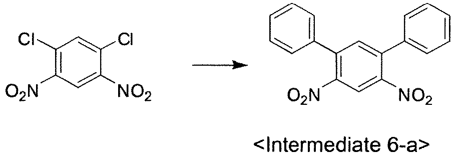

1,5-Dichloro-2,4-dinitrobenzene (40.0 g, 123 mmol), phenylboronic acid (44.9 g, 368 mmol), tetrakis(triphenylphosphine)palladium (2.8 g, 2.5 mmol), potassium carbonate (50.9 g, 368 mmol), 1,4-dioxane (120 mL), toluene (200 mL), and water (120 mL) were placed in a 1 L reactor. The mixture was refluxed with stirring. After completion of the reaction, the reaction mixture was extracted. The organic layer was purified by column chromatography to afford Intermediate 6-a (27.5 g, yield 70%).

### Synthesis Example 6-2: Synthesis of Intermediate 6-b

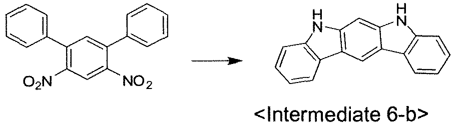

Intermediate 6-a (27.5 g, 86 mmol), triphenylphosphine (57.8 g, 348 mmol), and dichlorobenzene (300 mL) were placed in a 1 L reactor. The mixture was refluxed with stirring for 3 days. After completion of the reaction, the dichlorobenzene was removed, followed by column chromatography to afford Intermediate 6-b (10.8 g, yield 49.0%).

### Synthesis Example 6-3: Synthesis of Intermediate 6-c

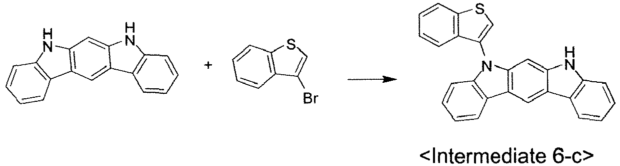

Intermediate 6-b (10.8 g, 42 mmol), Intermediate 2-a (11.0 g, 10.8 mmol), a copper powder (10.7 g, 1 mmol), 18-crown-6-ether (4.5 g, 17 mmol), and potassium carbonate (34.9 g, 253 mmol) were placed in a 250 mL reactor, and dichlorobenzene (110 mL) was added thereto. The mixture was refluxed with stirring at 180 °C for 24 h. After completion of the reaction, the dichlorobenzene was removed, followed by column chromatography to afford Intermediate 6-c (9.5 g, yield 52%).

### Synthesis Example 6-4: Synthesis of Intermediate 6-d

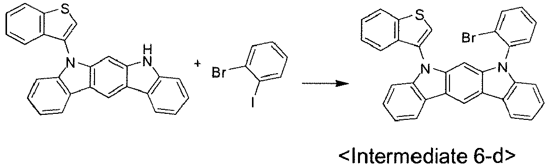

Intermediate 6-d (14 g, yield 67.1%) was synthesized in the same manner as in Synthesis Example 6-3, except that Intermediate 6-c and 1-bromo-2-iodobenzene were used instead of Intermediate 1-c and Intermediate 2-a.

### Synthesis Example 6-5: Synthesis of Compound 109

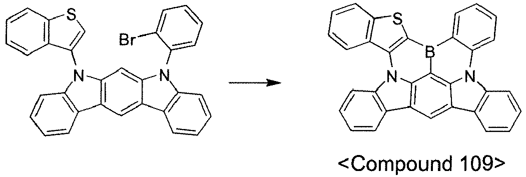

Compound 109 (2.1 g, yield 14%) was synthesized in the same manner as in Synthesis Example 1-7, except that Intermediate 6-d was used instead of Intermediate 1-f.
MS (MALDI-TOF) : m/z 472.12 [M⁺]

### Synthesis Example 7: Synthesis of Compound 126

### Synthesis Example 7-1: Synthesis of Intermediate 7-a

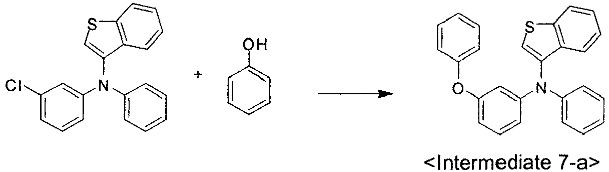

Intermediate 2-b (30.0 g, 150 mmol), phenol (31.2 g, 160 mmol), potassium carbonate (45.7 g, 300 mmol), and NMP (250 mL) were placed in a 500 mL reactor. The mixture was refluxed with stirring at 160 °C for 12 h. After completion of the reaction, the reaction mixture was cooled to room temperature, distilled under reduced pressure to remove the NMP, and extracted with water and ethyl acetate. The organic layer was concentrated under reduced pressure and purified by column chromatography to afford Intermediate 7-a (22 g, yield 68%).

### Synthesis Example 7-2: Synthesis of Compound 126

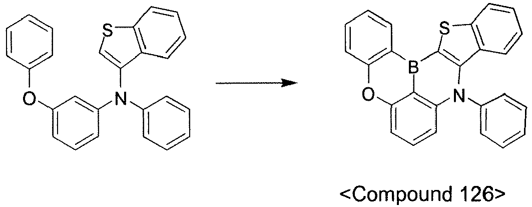

Compound 126 (1.2 g, yield 13.4%) was synthesized in the same manner as in Synthesis Example 1-7, except that Intermediate 7-a was used instead of Intermediate 1-f.
MS (MALDI-TOF) : m/z 401.10 [M⁺]

### Synthesis Example 8: Synthesis of Compound 145

### Synthesis Example 8-1: Synthesis of Intermediate 8-a

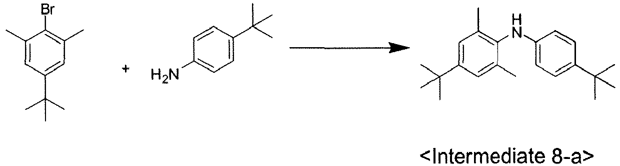

Intermediate 8-a (41.6 g, yield 88.2%) was synthesized in the same manner as in Synthesis Example 1-3, except that 2-bromo-5-tert-butyl-1,3-dimethylbenzene and 4-tert-butylaniline were used instead of 1-bromo-3-iodobenzene and aniline.

### Synthesis Example 8-2: Synthesis of Intermediate 8-b

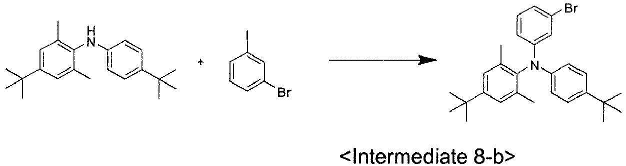

Intermediate 8-b (37.6 g, yield 78.4%) was synthesized in the same manner as in Synthesis Example 4-2, except that Intermediate 8-a was used instead of diphenylamine.

### Synthesis Example 8-3: Synthesis of Intermediate 8-c

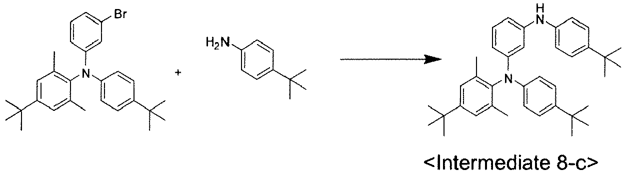

Intermediate 8-c (31.2 g, yield 74.2%) was synthesized in the same manner as in Synthesis Example 1-3, except that Intermediate 8-b and 4-tert-butylaniline were used instead of 1-bromo-3-iodobenzene and aniline.

### Synthesis Example 8-4: Synthesis of Intermediate 8-d

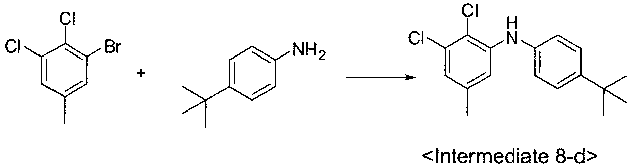

Intermediate 8-d (30.3 g, yield 89.8%) was synthesized in the same manner as in Synthesis Example 1-3, except that 1-bromo-2,3-dichloro-5-methylbenzene and 4-tert-butylaniline were used instead of 1-bromo-3-iodobenzene and aniline.

### Synthesis Example 8-5: Synthesis of Intermediate 8-e

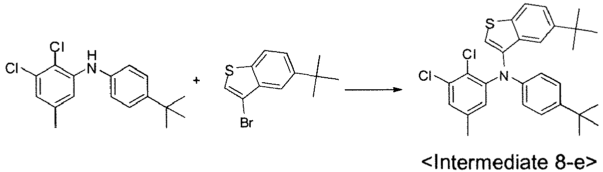

Intermediate 8-e (27.4 g, yield 77.1%) was synthesized in the same manner as in Synthesis Example 1-4, except that Intermediate 8-d and 3-bromo-5-tert-butylbenzothiophene were used instead of Intermediate 1-c and Intermediate 1-b.

### Synthesis Example 8-6: Synthesis of Intermediate 8-f

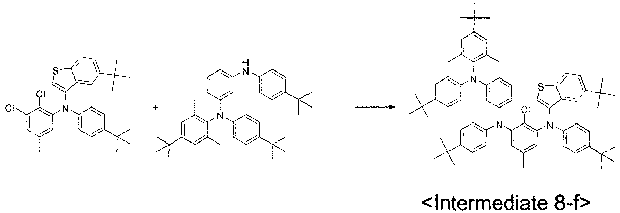

Intermediate 8-f (21 g, yield 74.1%) was synthesized in the same manner as in Synthesis Example 1-4, except that Intermediate 8-e and Intermediate 8-c were used instead of Intermediate 1-c and Intermediate 1-b.

### Synthesis Example 8-7: Synthesis of Compound 145

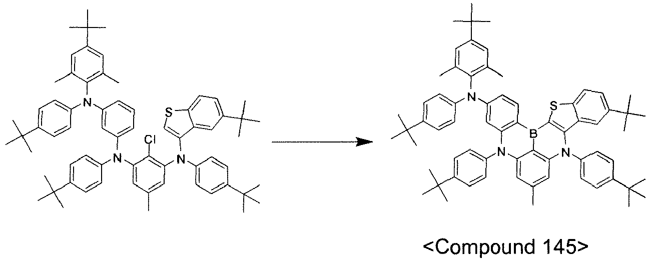

Compound 145 (3.4 g, yield 19.4%) was synthesized in the same manner as in Synthesis Example 1-7, except that Intermediate 8-f was used instead of Intermediate 1-f.
MS (MALDI-TOF) : m/z 979.60 [M]⁺

### Synthesis Example 9: Synthesis of Compound 150

### Synthesis Example 9-1: Synthesis of Intermediate 9-a

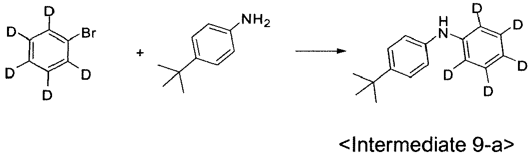

Intermediate 9-a (32.7 g, yield 78.2%) was synthesized in the same manner as in Synthesis Example 1-3, except that 1-bromobenzene-d5 and 4-tert-butylaniline were used instead of 1-bromo-3-iodobenzene and aniline.

### Synthesis Example 9-2: Synthesis of Intermediate 9-b

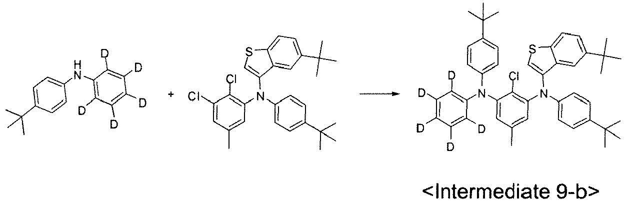

Intermediate 9-b (34.2 g, yield 84.1%) was synthesized in the same manner as in Synthesis Example 1-4, except that Intermediate 8-e and Intermediate 9-a were used instead of Intermediate 1-c and Intermediate 1-b.

### Synthesis Example 9-3: Synthesis of Compound 150

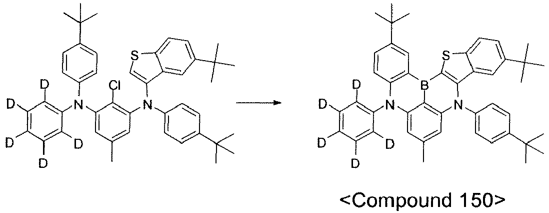

Compound 150 (2.7 g, yield 11.4%) was synthesized in the same manner as in Synthesis Example 1-7, except that Intermediate 9-b was used instead of Intermediate 1-f.
MS (MALDI-TOF) : m/z 663.39 [M]⁺

### Synthesis Example 10: Synthesis of Compound 153

### Synthesis Example 10-1: Synthesis of Intermediate 10-a

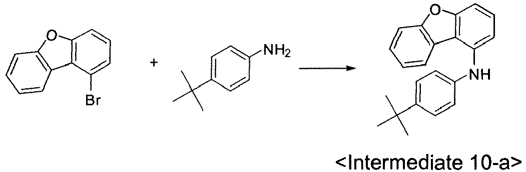

Intermediate 10-a (25.6 g, yield 79.2%) was synthesized in the same manner as in Synthesis Example 1-3, except that 1-bromo-dibenzofuran and 4-tert-butylaniline were used instead of 1-bromo-3-iodobenzene and aniline.

### Synthesis Example 10-2: Synthesis of Intermediate 10-b

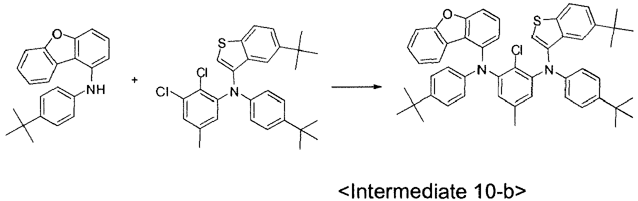

Intermediate 10-b (18.6 g, yield 74.1%) was synthesized in the same manner as in Synthesis Example 1-4, except that Intermediate 8-e and Intermediate 10-a were used instead of Intermediate 1-c and Intermediate 1-b.

### Synthesis Example 10-3: Synthesis of Compound 153

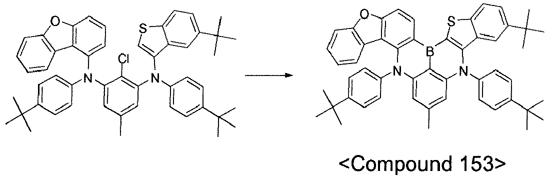

Compound 153 (3.4 g, yield 15.4%) was synthesized in the same manner as in Synthesis Example 1-7, except that Intermediate 10-b was were used instead of Intermediate 1-f.
MS (MALDI-TOF) : m/z 748.37 [M]⁺

### Synthesis Example 11: Synthesis of the Compound 185

Compound 185 (2.1 g, yield 12%) was synthesized in the same manner as in Synthesis Example 3, except that 1-bromo-3-iodobenzene and 4-tert-butylaniline were used instead of 1-bromo-3-(tert-butyl)-5-iodobenzene and aniline (Synthesis Example 3-1), respectively, and 3-bromo-5-methylbenzofuran was used instead of 3-bromobenzofuran (Intermediate 1-b) (Synthesis Example 3-2).
MS (MALDI-TOF) : m/z 640.33 [M]⁺

### Synthesis Example 12: Synthesis of the Compound 4

Compound 4 (1.1 g, yield 19%) was synthesized in the same manner as in Synthesis Examples 1-4 to 1-7, except that 3-bromo-1-phenyl-1H-indole was used instead of Intermediate 1-b (Synthesis Example 1-4).
MS (MALDI-TOF) : m/z 535.22 [M]⁺

### <Synthesis of the compounds represented by Formula B>

### Synthesis Example 13: Synthesis of the Compound B101

4.2 g of 2-(4-bromophenyl)-2H-benzo[1,2,3]triazole, 2.3 g of N,N'-diphenylbenzidine, 2.0 g of sodium tert-butoxide, and 50 mL of toluene were placed in a reactor, which had been flushed with nitrogen. Nitrogen gas was passed through the reactor during sonication for 30 min. 62.0 mg of palladium acetate and 0.2 mL of tri-tert-butylphosphine was added to the reactor. The mixture was heated to 91 °C and stirred at the same temperature for 5 h. After cooling to room temperature, the reaction mixture was extracted with 50 mL of toluene. The organic layer was collected, concentrated, purified by column chromatography on NH silica gel (eluent: toluene/n-hexane), and dispersed in and washed with 100 mL of n-hexane to give the Compound B101 (3.3 g, yield 66%) as a yellow powder.

The structure of the yellow powder was identified by NMR. The following 34 hydrogen signals were detected by ¹H-NMR (THF-d₈).

δ (ppm) = 8.26 (4H), 7.89 (4H), 7.60 (4H), 7.39 (4H), 7.33 (4H), 7.24 (4H), 7.21 (8H), 7.10 (2H).

### Synthesis Example 14: Synthesis of the Compound B106

14.0 g of 4,4"-diiodo-1,1':4',1"-terphenyl, 18.3 g of {4-(2H-benzo[1,2,3]triazol-2-yl)phenyl}phenylamine, 13.2 g of potassium carbonate, 0.3 g of copper powder, 0.9 g of sodium hydrogen sulfite, 0.7 g of 3,5-di-tert-butylsalicylic acid, and 30 mL of dodecyl benzene were placed in a reactor, which had been flushed with nitrogen. The mixture was heated to 210 °C and stirred at the same temperature for 44 h. After the reaction mixture was allowed to cool to room temperature, 50 mL of toluene was added thereto. The precipitate was collected by filtration, dissolved in 230 mL of 1,2-dichlorobenzene by heating, and subjected to hot filtration to remove insolubles. The filtrate was concentrated, purified by crystallization from 1,2-dichlorobenzene, and dispersed in and washed with methanol to give the Compound B106 (22.2 g, yield 96%) as a yellow powder.

The structure of the yellow powder was identified by NMR. The following 38 hydrogen signals were detected by ¹H-NMR (CDCl₃).

δ (ppm) = 8.24 (4H), 7.99-7.92 (4H), 7.72-7.58 (7H), 7.50-7.12 (23H).

### Synthesis Example 15: Synthesis of the Compound B119

Compound B119 (12.4 g, yield 47%) as a yellow powder was synthesized in the same manner as in Synthesis Example 14, except that {4-(benzoxazol-2-yl)phenyl}phenylamine was used instead of {4-(2H-benzo[1,2,3]triazol-2-yl)phenyl}phenylamine.

The structure of the yellow powder was identified by NMR. The following 38 hydrogen signals were detected by ¹H-NMR (CDCl₃).

δ (ppm) = 8.13 (4H), 7.80-7.55 (11H), 7.50-7.16 (23H).

### Synthesis Example 16: Synthesis of the Compound B120

Compound of B120 (8.8 g, yield 54%) as a lemon yellow powder was synthesized in the same manner as in Synthesis Example 13, except that 2-(4-bromophenyl)benzoxazole was used instead of 2-(4-bromophenyl)-2H-benzo[1,2,3]triazole.

The structure of the lemon yellow powder was identified by NMR. The following 34 hydrogen signals were detected by ¹H-NMR (CDCl₃).

δ (ppm) = 8.12 (4H), 7.80-7.72 (2H), 7.60-7.53 (5H), 7.41-7.14 (23H).

### Synthesis Example 17: Synthesis of the Compound B122

Compound B122 (9.3 g, yield 62%) as a lemon yellow powder was synthesized in the same manner as in Synthesis Example 13, except that 2-(4-bromophenyl)benzothiazole was used instead of 2-(4-bromophenyl)-2H-benzo[1,2,3]triazole. The structure of the lemon yellow powder was identified by NMR. The following 34 hydrogen signals were detected by ¹H-NMR (CDCl₃).

δ (ppm) = 8.10-7.88 (8H), 7.60-7.13 (26H).

### Synthesis Example 18: Synthesis of the Compound B123

9.3 g of N-{4-(benzothiazol-2-yl)phenyl}phenylamine, 7.1 g of 4,4"-diiodo-1,1':4',1"-terphenyl, 4.6 g of sodium tert-butoxide, and 140 mL of toluene were placed in a reactor, which had been flushed with nitrogen. Nitrogen gas was passed through the reactor during sonication for 30 min. 0.20 g of palladium acetate and 0.5 g of a 50% (v/v) toluene solution of tert-butylphosphine was added. The mixture was heated and refluxed with stirring for 3 h. The reaction mixture was cooled to room temperature. The precipitate was collected by filtration and purified by repeated crystallization from a mixed solvent of 1,2-dichlorobenzene/methanol to give the Compound B123 (7.0 g, yield 58%) as a yellow powder.

The structure of the yellow powder was identified by NMR. The following 38 hydrogen signals were detected by ¹H-NMR (THF-d₈).

δ (ppm) = 8.07-7.88 (8H), 7.70-7.60 (8H), 7.54-7.46 (2H), 7.40-7.15 (20H).

### <Examples 1-12: Fabrication of organic electroluminescent devices>

ITO glass was patterned to have a light emitting area of 2 mm × 2 mm, followed by cleaning. After the cleaned ITO glass was mounted in a vacuum chamber, the base pressure was adjusted to 1 × 10⁻⁷ torr. 4,4',4"-tris[2-naphthyl(phenyl)amino]triphenyl amine (2-TNATA) (700 Å) and the compound of Formula F (600 Å) were deposited in this order on the ITO. A mixture of BH1 as a host and the compound of [Formula A-1] and [Formula A-2] of the present invention (3 wt%) was used to form a 200 Å thick light emitting layer. Thereafter, the compound of Formula E-2 was used to form a 300 Å thick electron transport layer on the light emitting layer. The compound of Formula E-1 was used to form a 10 Å thick electron injecting layer on the electron transport layer. MgAg was deposited on the electron injecting layer to form a 120 Å electrode. Finally, the compound of the present invention was used to form a 600 Å capping layer on the MgAg electrode, completing the fabrication of an organic electroluminescent device. The luminescent properties of the organic electroluminescent device were measured at 0.4 mA.

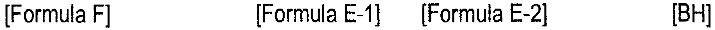

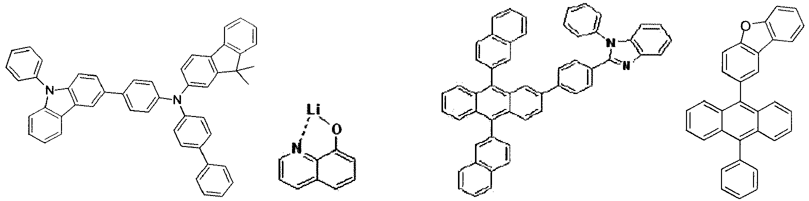

### Comparative Examples 1-8

Organic electroluminescent devices were fabricated in the same manner as in Example 1, except that BD1, BD2, BD3, BD4, and BD5 were used instead of the dopant compound and Alq3 and CPL-1 were used instead of the compound for the capping layer. The luminescent properties of the organic electroluminescent device were measured at 0.4 mA. The structures of BD1, BD2, BD3, BD4, BD5, and CPL-1 are as follows.

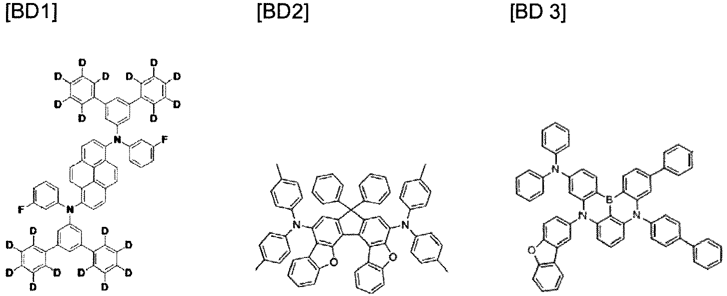

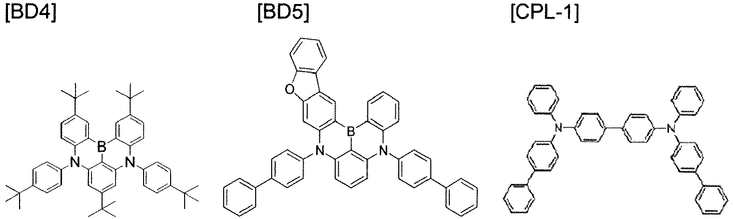

The organic electroluminescent devices of Examples 1-12 and Comparative Examples 1-8 were measured for driving voltage and efficiency. The results are shown in Table 1.

**[Table 1]**

| Example No. | Host | Dopant | CPL | Driving voltage | Efficiency (Cd/A) |
|---|---|---|---|---|---|
| Example 1 | BH1 | 1 | B101 | 3.8 | 8.4 |
| Example 2 | BH1 | 4 | B101 | 3.8 | 9.2 |
| Example 3 | BH1 | 126 | B106 | 3.8 | 8.3 |
| Example 4 | BH1 | 145 | B106 | 3.8 | 8.3 |
| Example 5 | BH1 | 145 | B101 | 3.8 | 8.3 |
| Example 6 | BH1 | 146 | B106 | 3.8 | 9.2 |
| Example 7 | BH1 | 146 | B101 | 3.8 | 9.1 |
| Example 8 | BH1 | 153 | B106 | 3.8 | 9.1 |
| Example 9 | BH1 | 157 | B106 | 3.8 | 8.7 |
| Example 10 | BH1 | 167 | B106 | 3.8 | 8.7 |
| Example 11 | BH1 | 180 | B106 | 3.8 | 8.9 |
| Example 12 | BH1 | 185 | B101 | 3.8 | 10.6 |
| Comparative Example 1 | BH1 | BD1 | B106 | 3.8 | 6.6 |
| Comparative Example 2 | BH1 | BD2 | B106 | 3.8 | 6.8 |
| Comparative Example 3 | BH1 | BD3 | B106 | 3.8 | 6.2 |
| Comparative Example 4 | BH1 | BD4 | B106 | 3.8 | 7.8 |
| Comparative Example 5 | BH1 | BD5 | B106 | 3.8 | 6.8 |
| Comparative Example 6 | BH1 | BD2 | Alq3 | 3.8 | 5.5 |
| Comparative Example 7 | BH1 | BD2 | CPL-1 | 3.8 | 5.7 |
| Comparative Example 8 | BH1 | BD4 | Alq3 | 3.8 | 7.8 |

The organic electroluminescent devices of Examples 1-12, each including the light emitting layer and the capping layer employing the compounds shown in Table 1, showed higher efficiencies than the organic electroluminescent devices of Comparative Examples 1-8.

The formation of the light emitting layer employing the polycyclic aromatic compound and the optional capping layer makes the organic electroluminescent device of the present invention highly efficient. In addition, the organic electroluminescent device of the present invention is suitable for use in a display or lighting system selected from flat panel displays, flexible displays, monochromatic flat panel lighting systems, white flat panel lighting systems, flexible monochromatic lighting systems, and flexible white lighting systems.

## Claims

1. An organic electroluminescent device comprising a first electrode, a second electrode opposite to the first electrode, a light emitting layer interposed between the first and second electrodes, and a capping layer formed on one of the surfaces of the first and second electrodes opposite to the light emitting layer, wherein the light emitting layer comprises any one of compounds represented by Formula A-1 or Formula A-2 and the capping layer comprises a compound represented by Formula B: 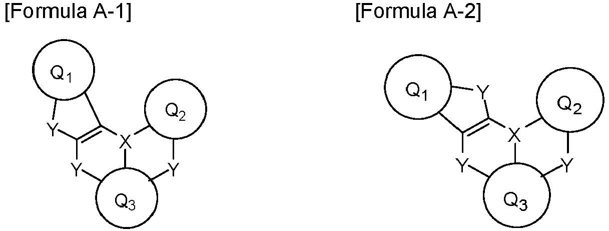 wherein Q₁ to Q₃ are identical to or different from each other and are each independently a substituted or unsubstituted C₆-C₅₀ aromatic hydrocarbon ring or a substituted or unsubstituted C₂-C₅₀ heteroaromatic ring, the linkers Y are identical to or different from each other and are each independently selected from N-R₁, CR₂R₃, O, and S, X is B, and R₁ to R₃ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that each of R₁ to R₅ is optionally bonded to Q₁, Q₂ or Q₃ to form an alicyclic or aromatic monocyclic or polycyclic ring, R₂ and R₃ are optionally linked to each other to form an alicyclic or aromatic monocyclic or polycyclic ring, and 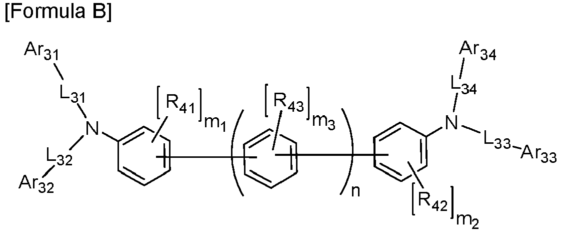 wherein R₄₁ to R₄₃ are identical to or different from each other and are each independently selected from hydrogen, deuterium, substituted or unsubstituted C₁-C₂₀ alkyl, substituted or unsubstituted C₆-C₅₀ aryl, substituted or unsubstituted C₇-C₅₀ arylalkyl, substituted or unsubstituted C₃-C₃₀ cycloalkyl, substituted or unsubstituted C₁-C₃₀ alkylsilyl, substituted or unsubstituted C₆-C₃₀ arylsilyl, and halogen, L₃₁ to L₃₄ are identical to or different from each other and are each independently single bonds or selected from substituted or unsubstituted C₆-C₅₀ arylene and substituted or unsubstituted C₂-C₅₀ heteroarylene, Ar₃₁ to Ar₃₄ are identical to or different from each other and are each independently selected from substituted or unsubstituted C₆-C₅₀ aryl and substituted or unsubstituted C₂-C₅₀ heteroaryl, n is an integer from 0 to 4, provided that when n is 2 or greater, the aromatic rings containing R₄₃ are identical to or different from each other, m₁ to m₃ are integers from 0 to 4, provided that when both m₁ and m₃ are 2 or more, the R₄₁, R₄₂, and R₄₃ groups are identical to or different from each other, and hydrogen or deuterium atoms are bonded to the carbon atoms of the aromatic rings to which R₄₁ to R₄₃ are not attached.

2. The organic electroluminescent device according to claim 1, wherein the compound of Formula A-1 or A-2 is represented by Formula A-3 or Formula A-4: 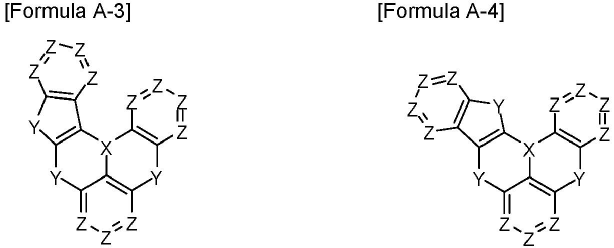 wherein each Z is independently CR or N, the substituents R are identical to or different from each other and are independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that the substituents R are optionally bonded to each other or are optionally linked to other adjacent substituents to form alicyclic or aromatic monocyclic or polycyclic rings whose carbon atoms are optionally substituted with one or more heteroatoms selected from N, S, and O atoms, and X and Y are as defined in Formulae A-1 and A-2.

3. The organic electroluminescent device according to claim 1, wherein the compound of Formula A-1 or A-2 is represented by Formula A-5 or Formula A-6: 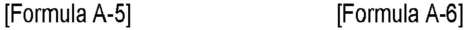 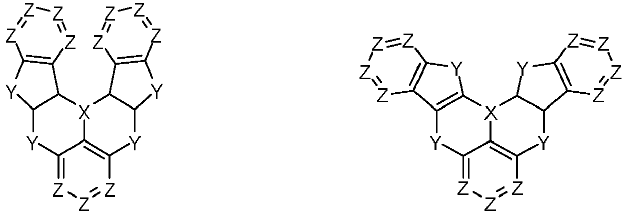 wherein each Z is independently CR or N, the substituents R are identical to or different from each other and are independently selected from hydrogen, deuterium, substituted or unsubstituted C₁-C₃₀ alkyl, substituted or unsubstituted C₆-C₅₀ aryl, substituted or unsubstituted C₃-C₃₀ cycloalkyl, substituted or unsubstituted C₂-C₅₀ heteroaryl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, with the proviso that the substituents R are optionally bonded to each other or are optionally linked to other adjacent substituents to form alicyclic or aromatic monocyclic or polycyclic rings whose carbon atoms are optionally substituted with one or more heteroatoms selected from N, S, and O atoms, and X and Y are as defined in Formulae A-1 and A-2.

4. The organic electroluminescent device according to claim 1, wherein at least one of Ar₃₁ to Ar₃₄ in Formula B is represented by Formula C: 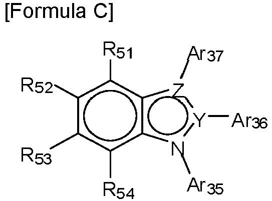 wherein R₅₁ to R₅₄ are identical to or different from each other and are each independently selected from hydrogen, deuterium, substituted or unsubstituted C₁-C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁-C₃₀ alkoxy, substituted or unsubstituted C₆-C₃₀ aryloxy, substituted or unsubstituted C₁-C₃₀ alkylthioxy, substituted or unsubstituted C₅-C₃₀ arylthioxy, substituted or unsubstituted C₁-C₃₀ alkylamine, substituted or unsubstituted C₅-C₃₀ arylamine, substituted or unsubstituted C₁-C₃₀ alkylsilyl, substituted or unsubstituted C₅-C₃₀ arylsilyl, nitro, cyano, and halogen, which are optionally linked to each other to form a ring, Y is a carbon or nitrogen atom, Z is a carbon, oxygen, sulfur or nitrogen atom, Ar₃₅ to Ar₃₇ are identical to or different from each other and are each independently selected from substituted or unsubstituted C₅-C₅₀ aryl and substituted or unsubstituted C₃-C₅₀ heteroaryl, provided that when Z is an oxygen or sulfur atom, Ar₃₇ is nothing, provided that when Y and Z are nitrogen atoms, only one of Ar₃₅, Ar₃₆, and Ar₃₇ is present, provided that when Y is a nitrogen atom and Z is a carbon atom, Ar₃₆ is nothing, with the proviso that one of R₅₁ to R₅₄ and Ar₃₅ to Ar₃₇ is a single bond linked to one of the linkers L₃₁ to L₃₄ in Formula B.

5. The organic electroluminescent device according to claim 1, wherein the compound of Formula A-1 or A-2 is selected from the compounds:

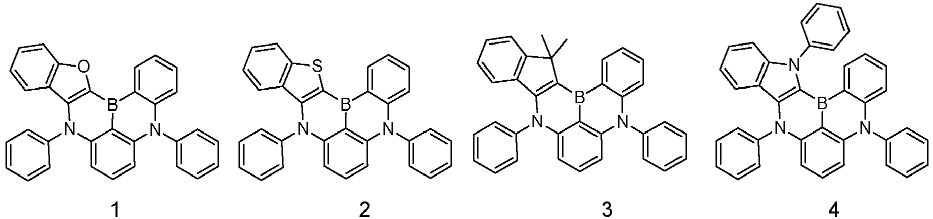

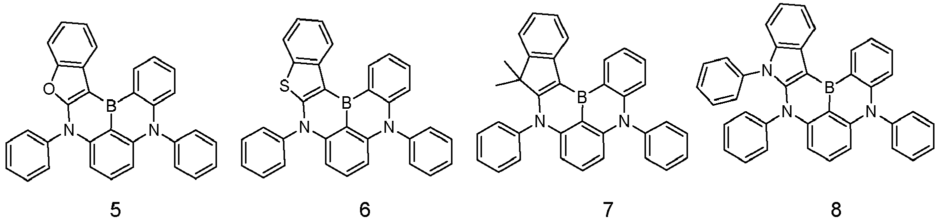

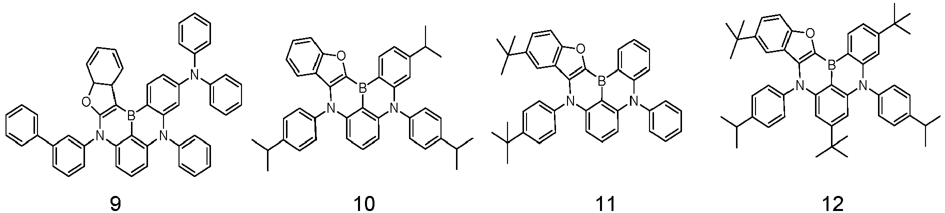

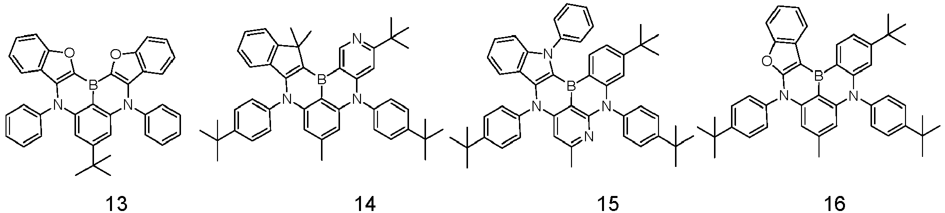

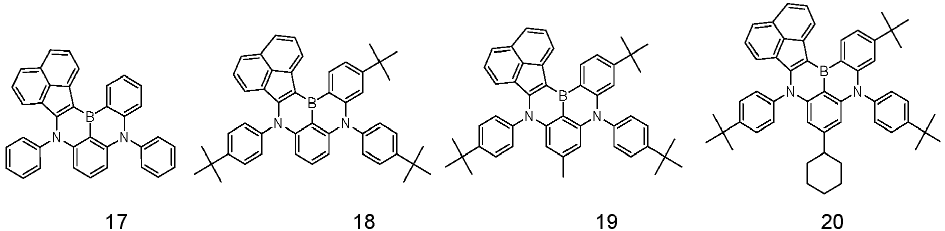

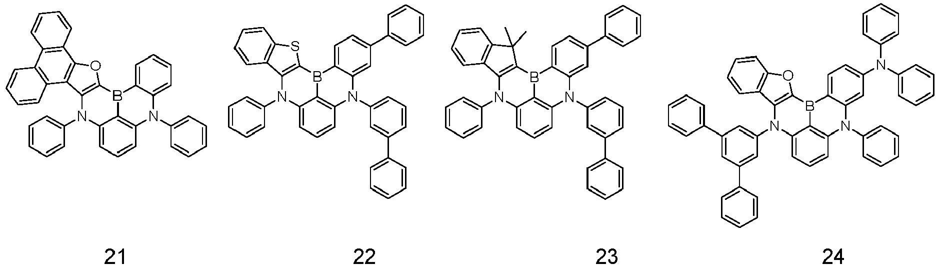

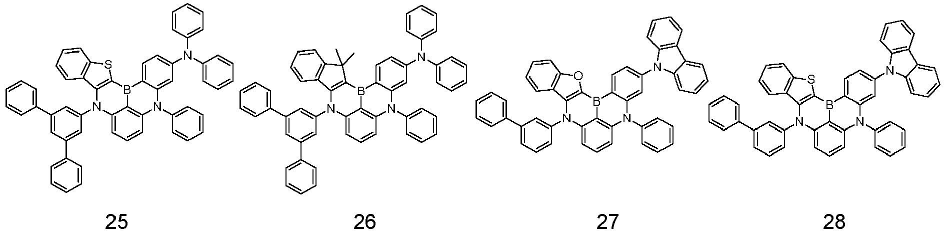

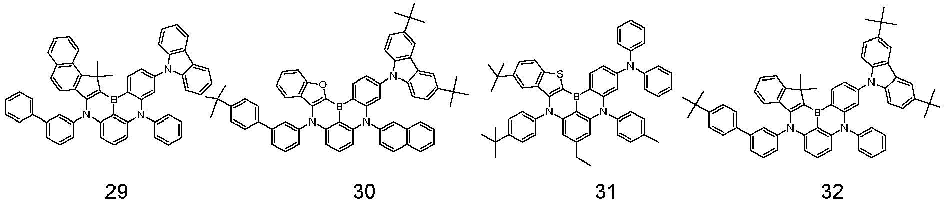

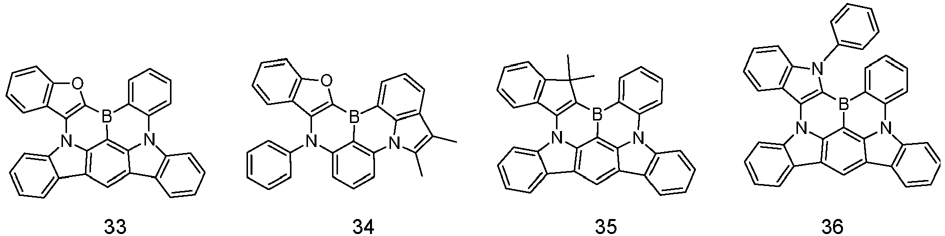

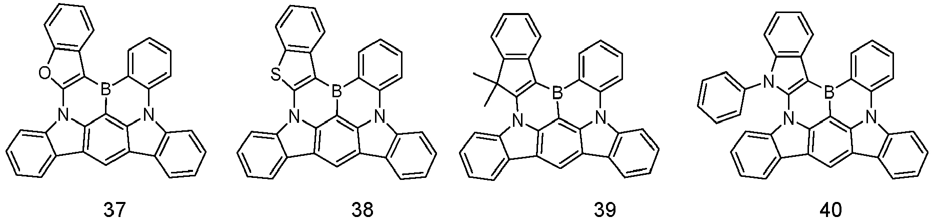

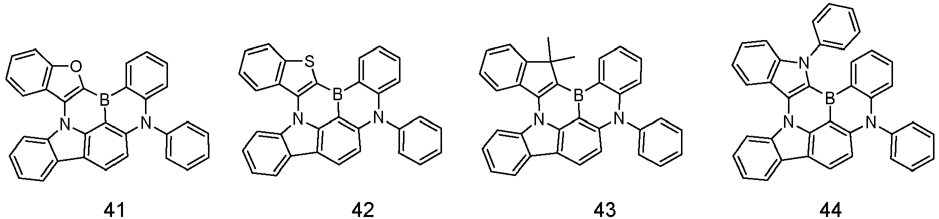

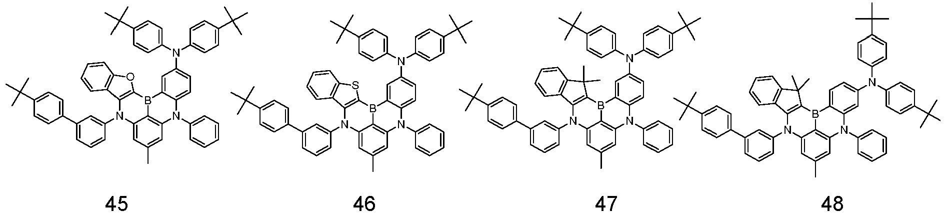

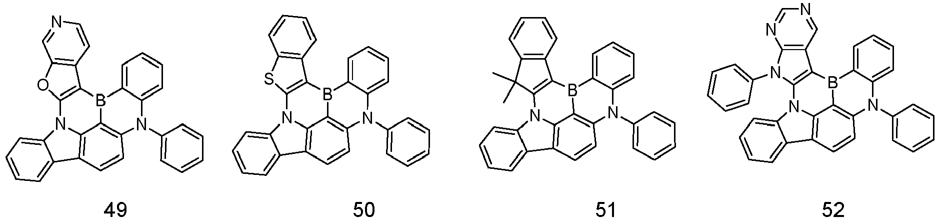

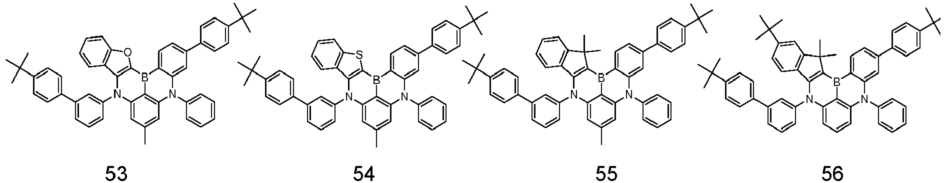

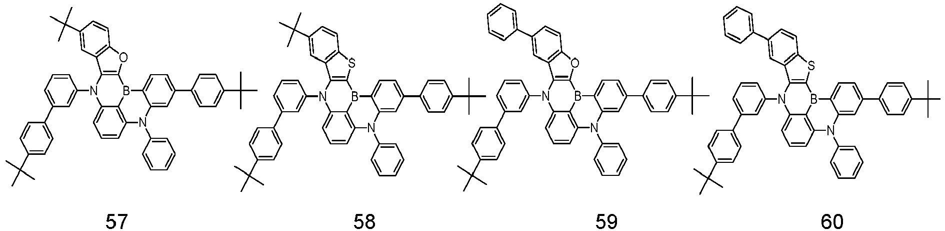

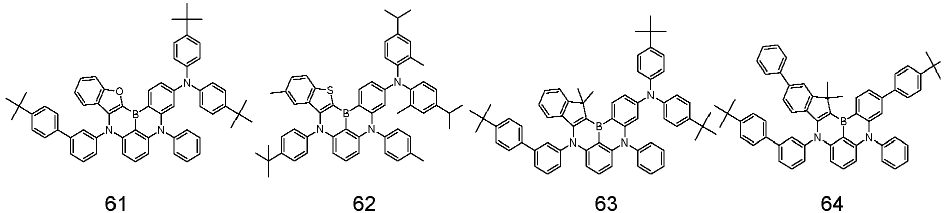

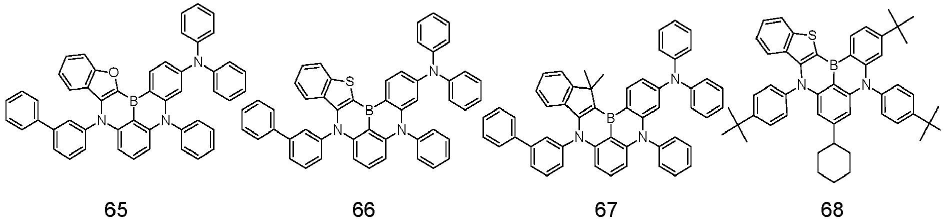

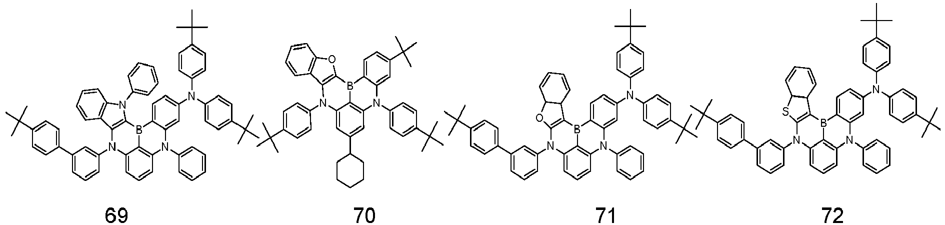

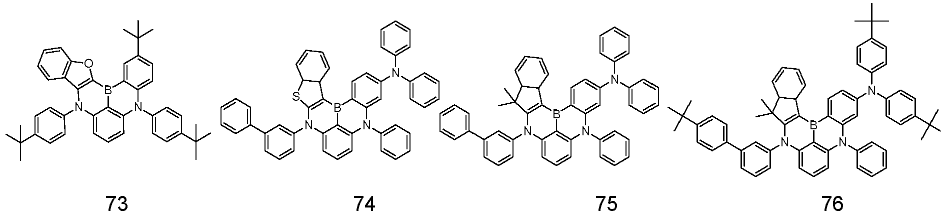

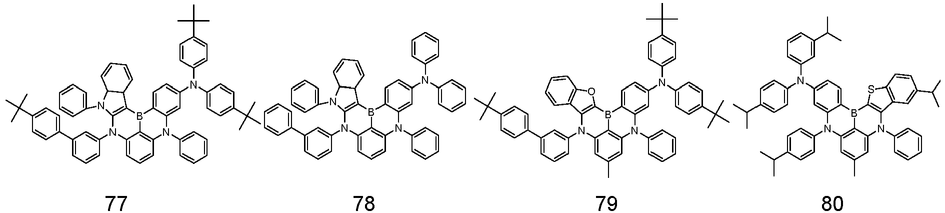

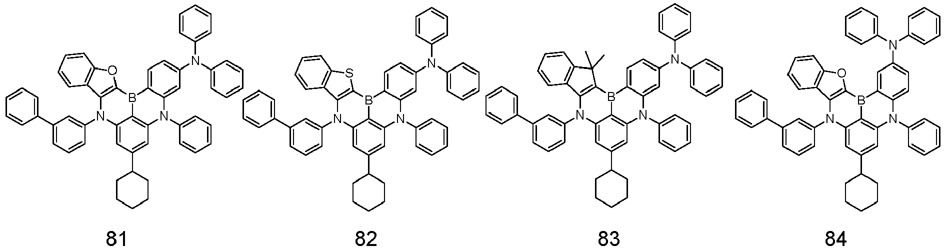

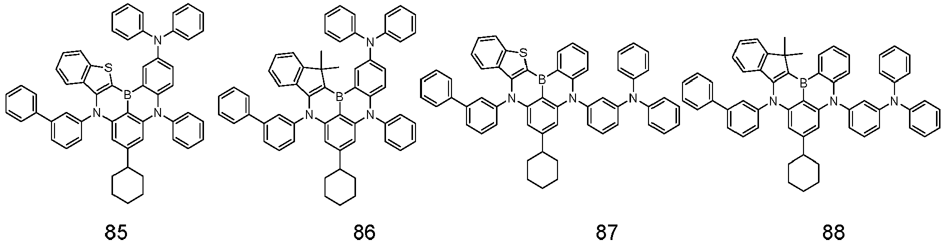

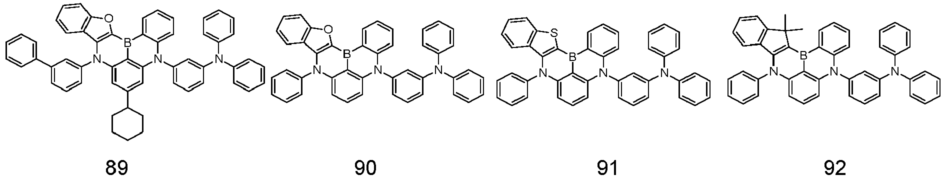

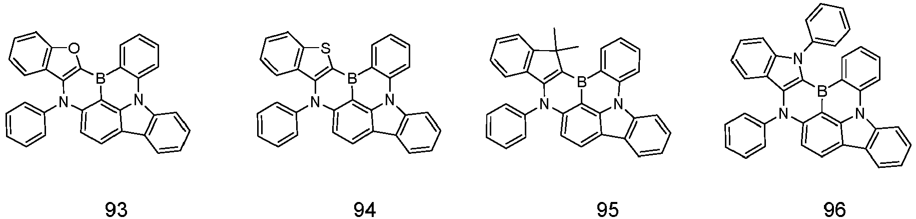

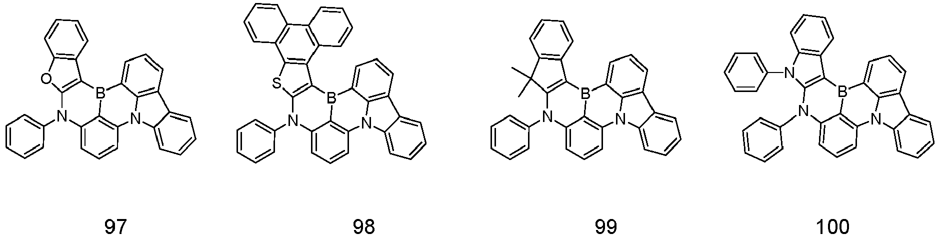

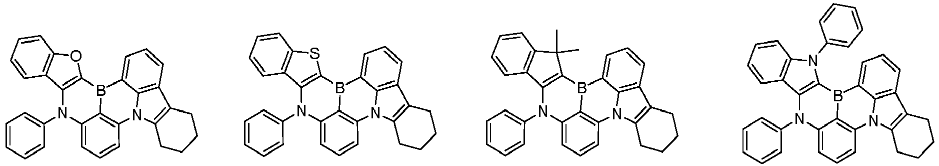

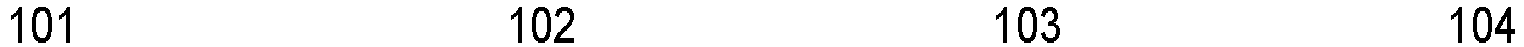

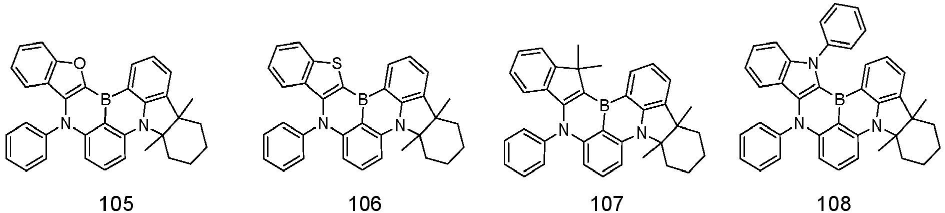

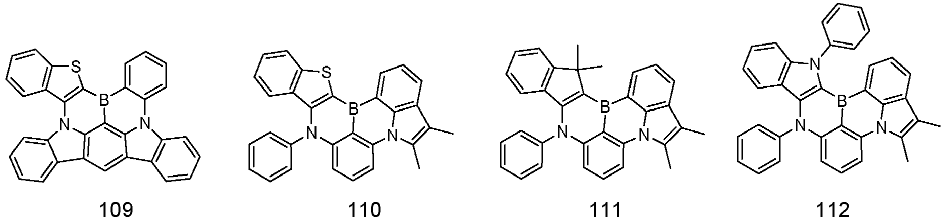

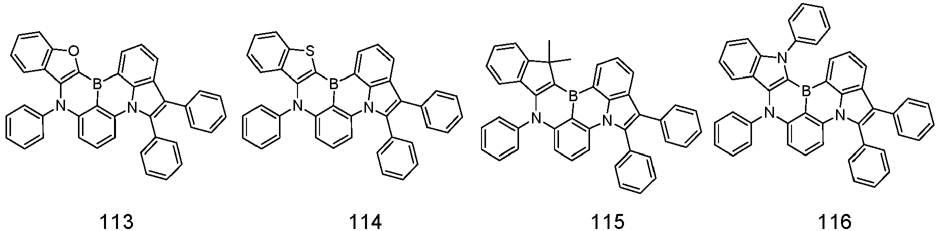

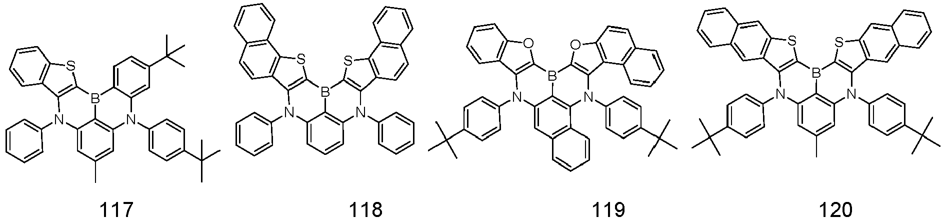

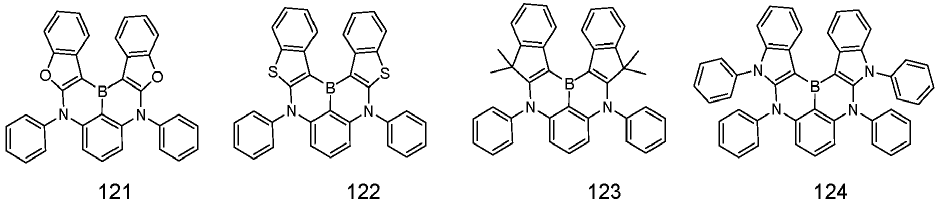

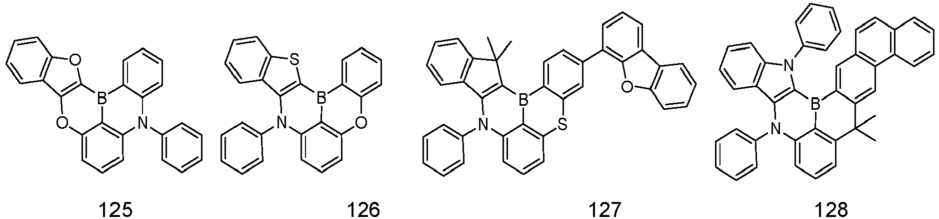

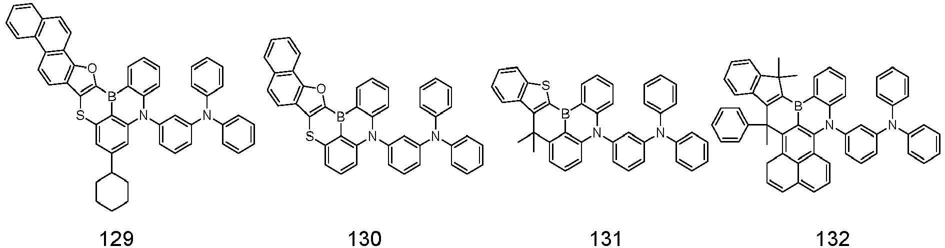

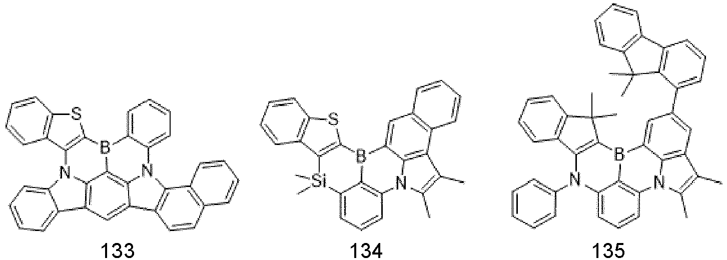

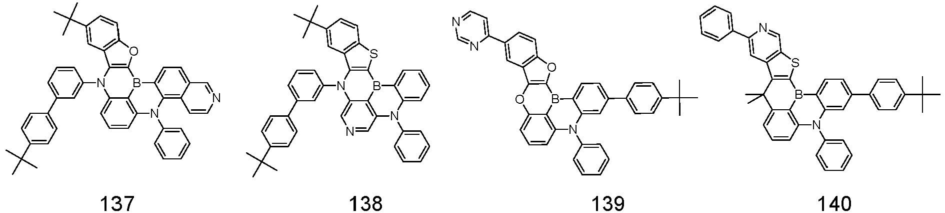

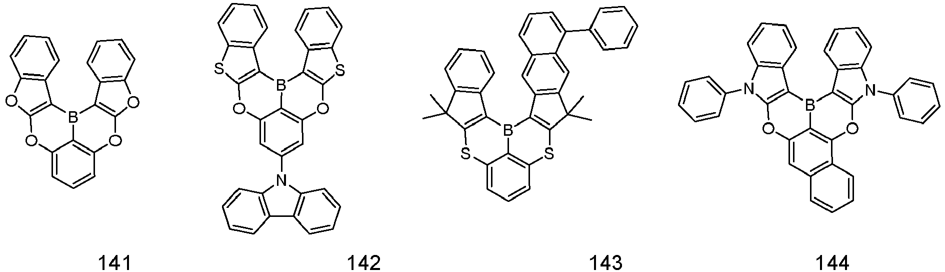

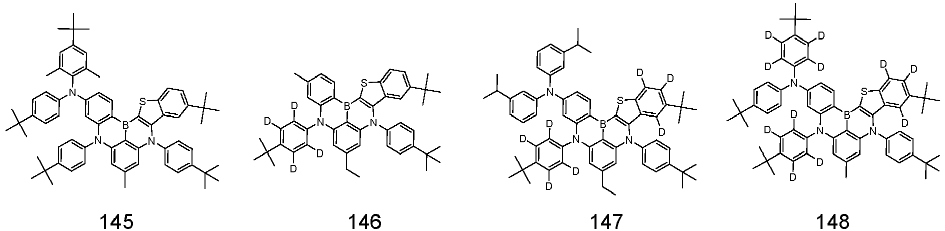

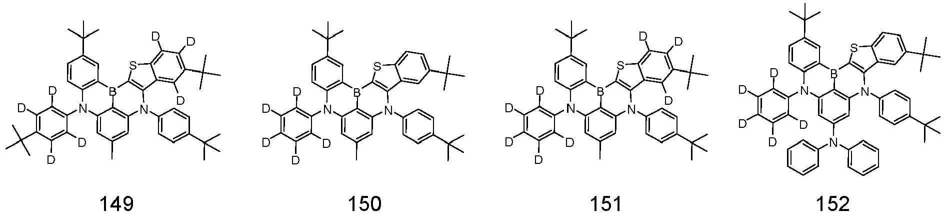

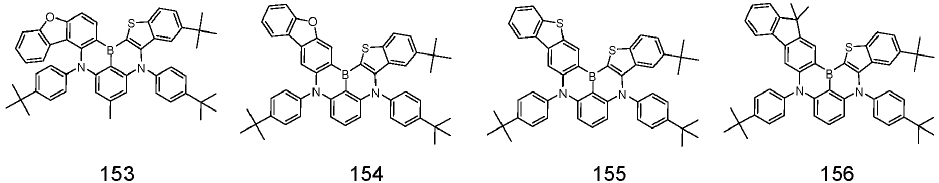

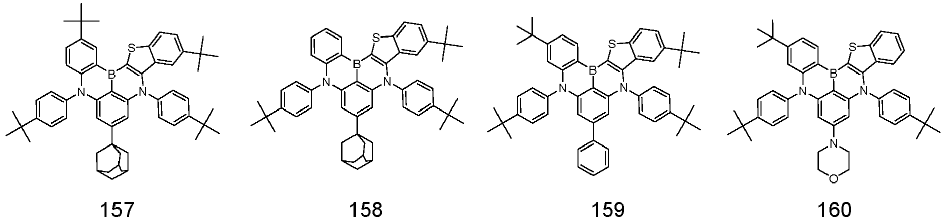

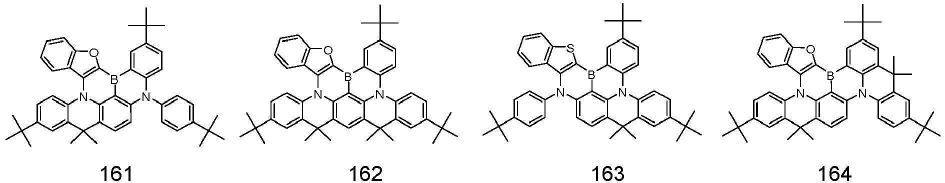

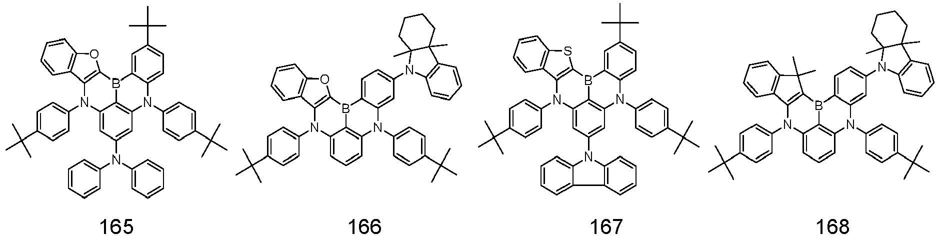

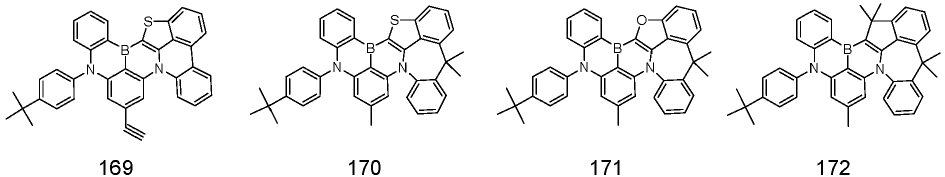

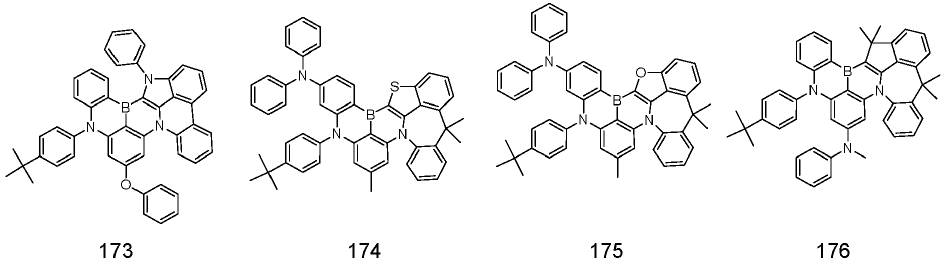

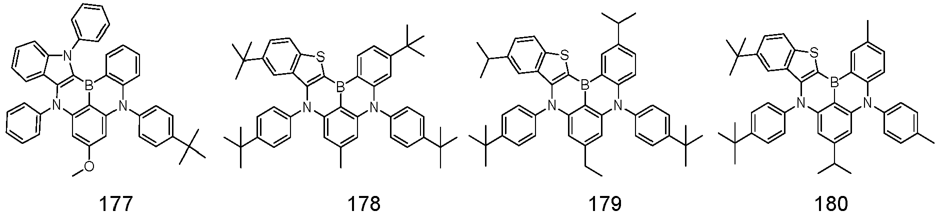

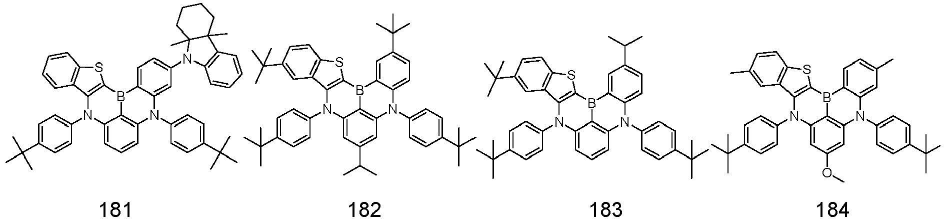

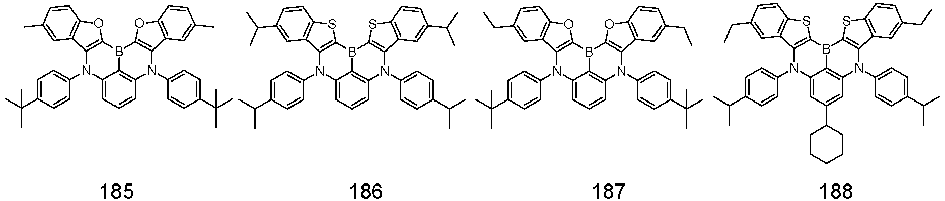

6. The organic electroluminescent device according to claim 1, wherein the compound of Formula B is selected from the following the compounds of Formula B1 to B79:

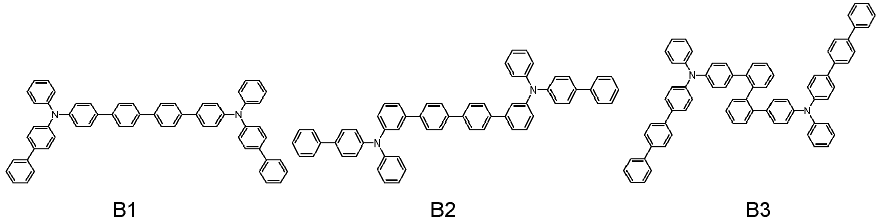

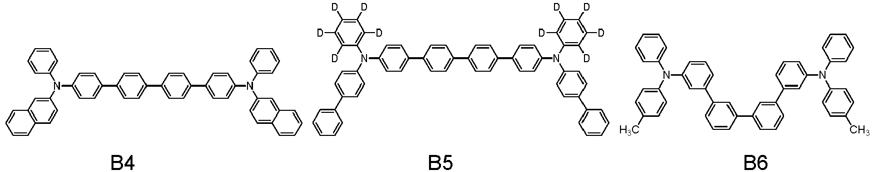

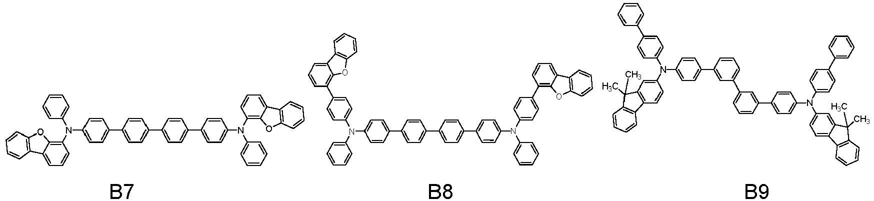

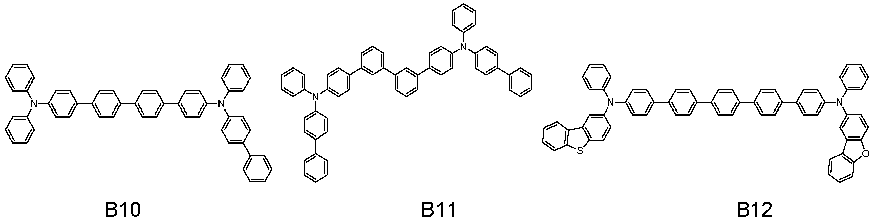

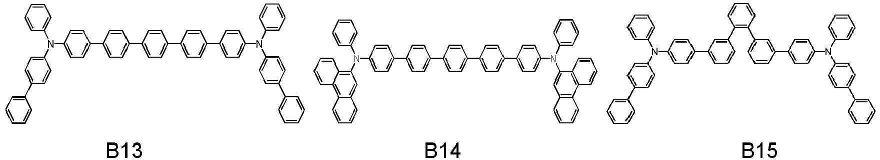

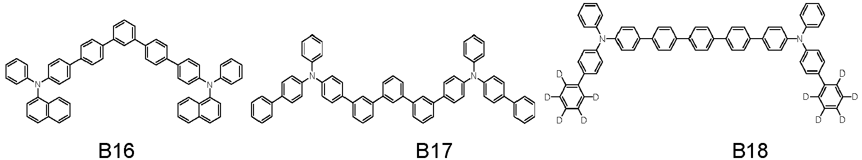

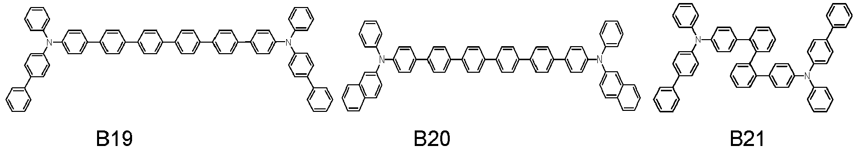

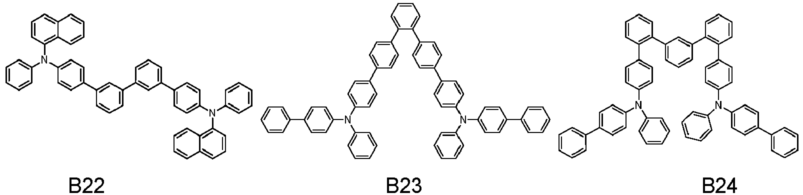

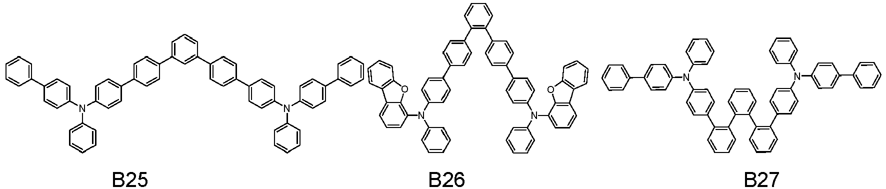

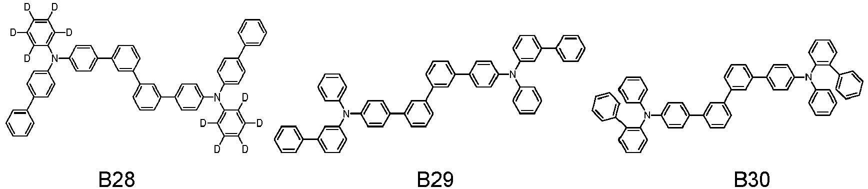

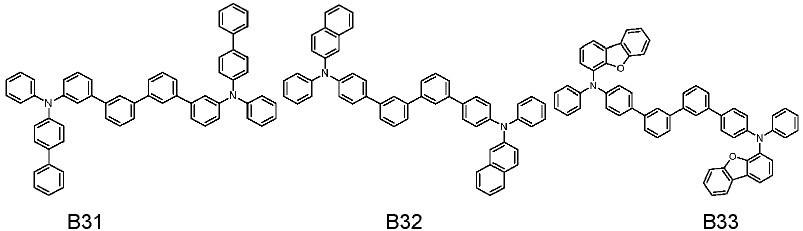

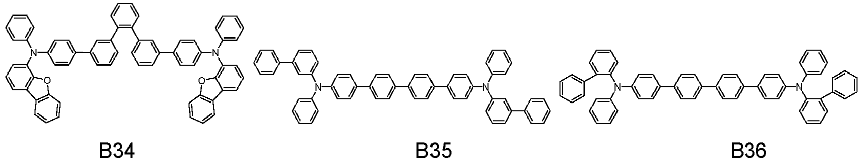

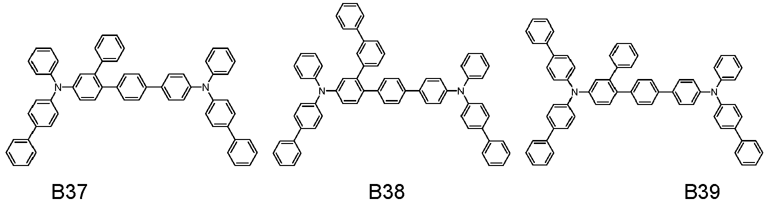

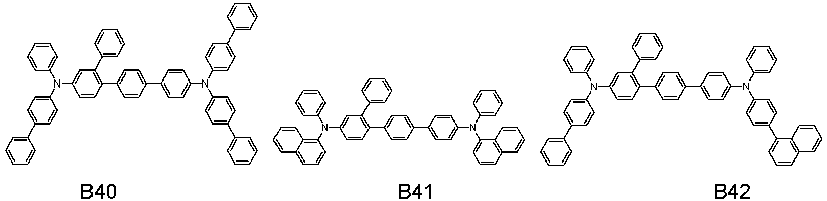

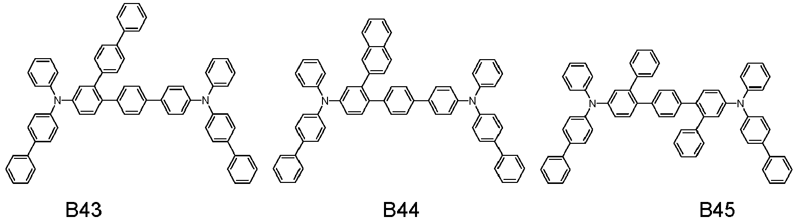

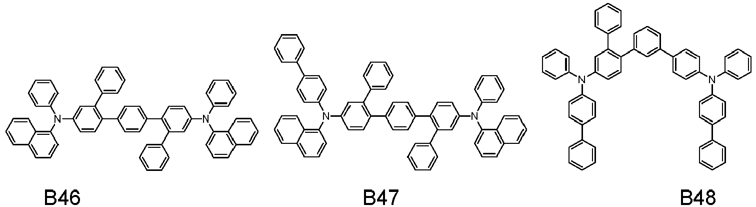

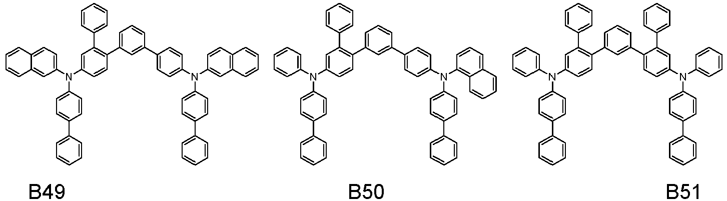

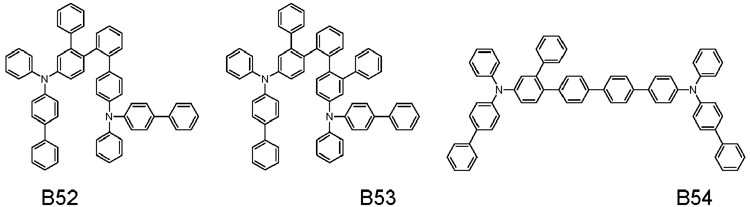

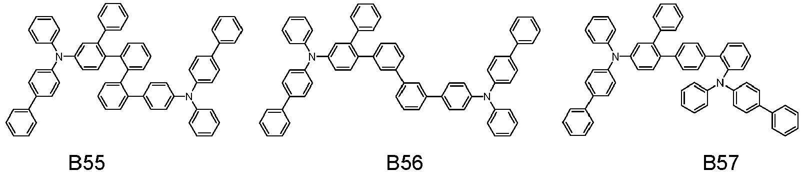

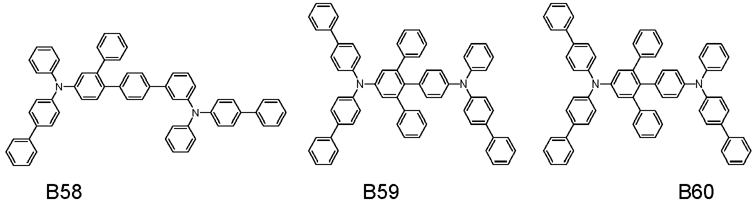

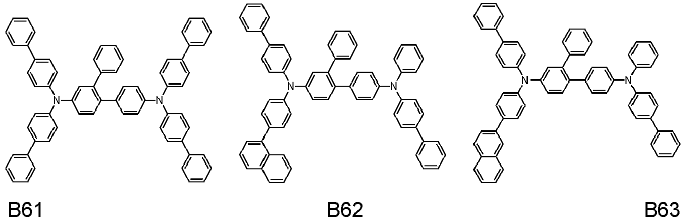

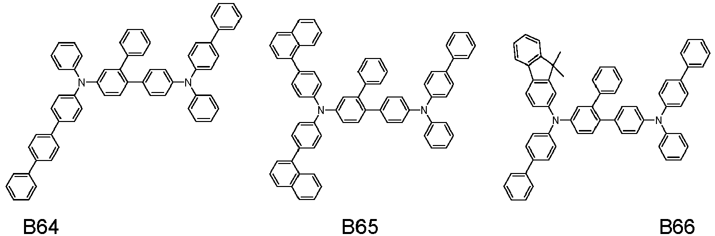

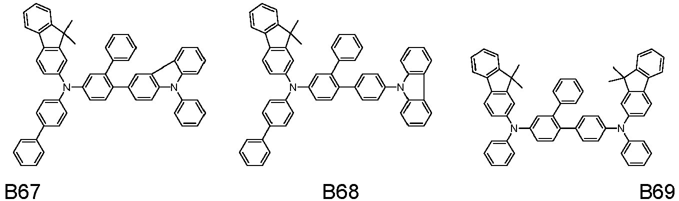

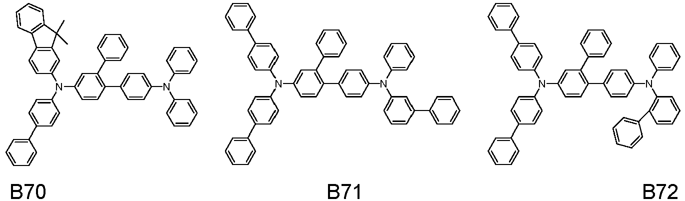

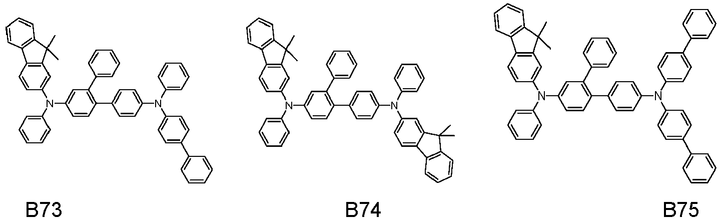

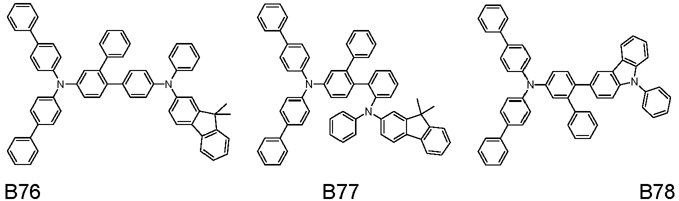

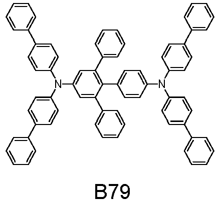

7. The organic electroluminescent device according to claim 1, wherein the compound of Formula B is selected from the following the compounds of Formula B101 to B145:

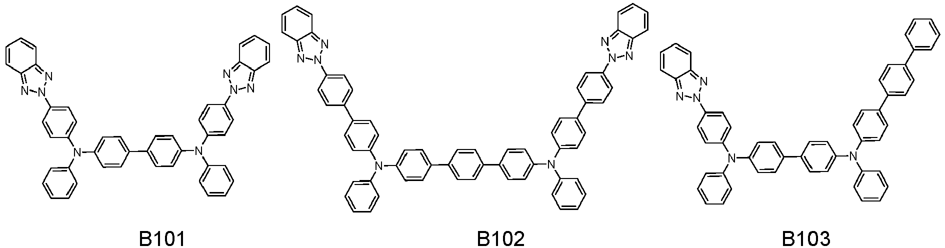

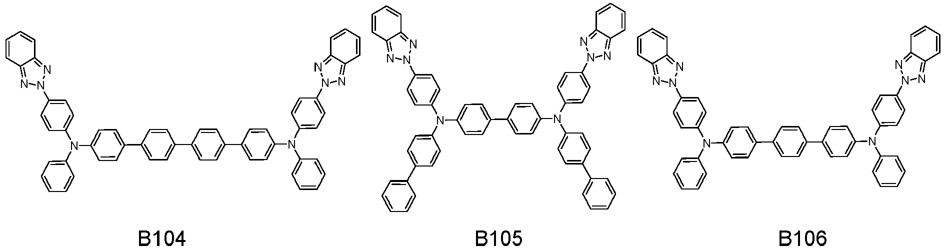

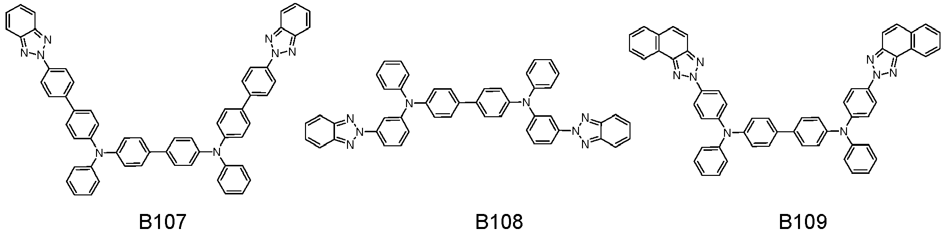

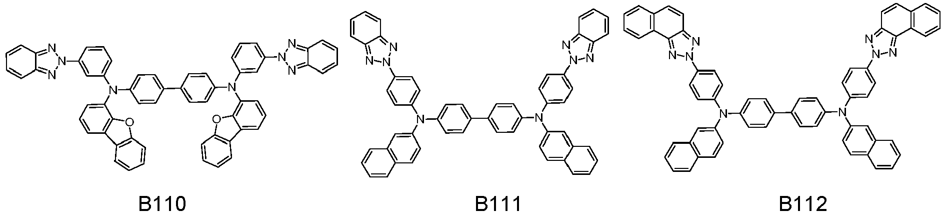

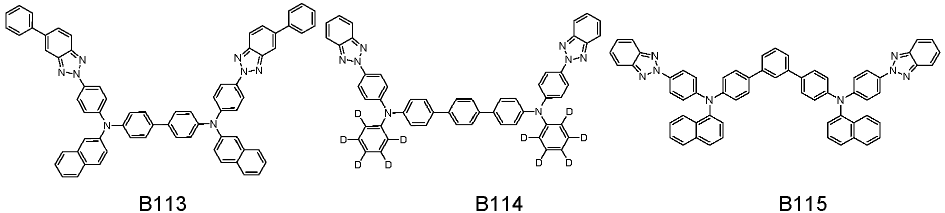

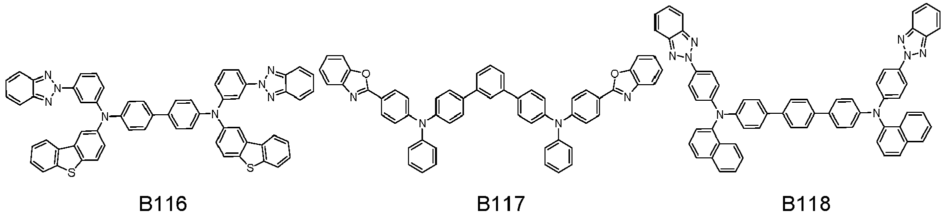

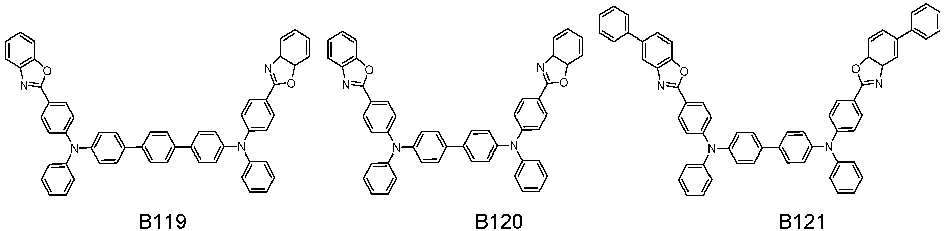

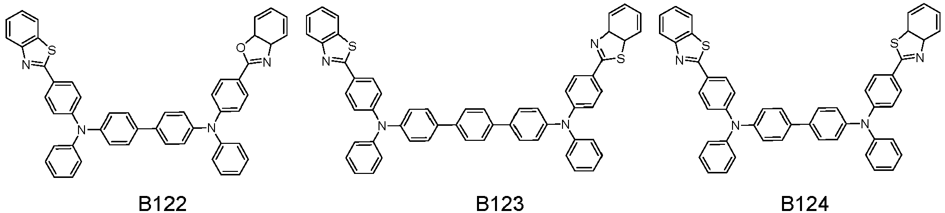

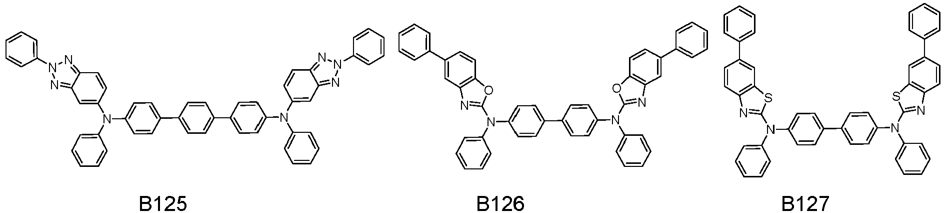

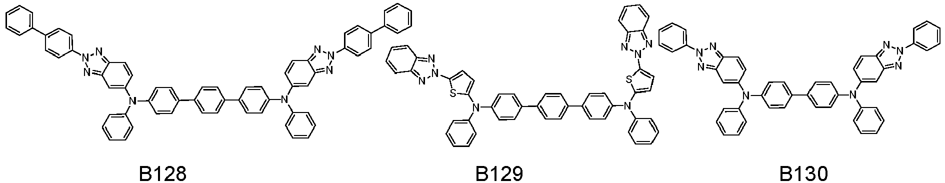

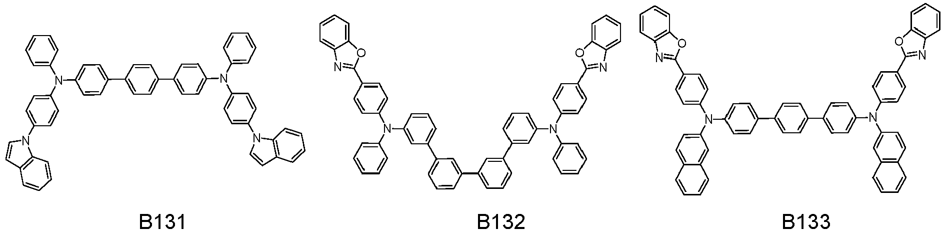

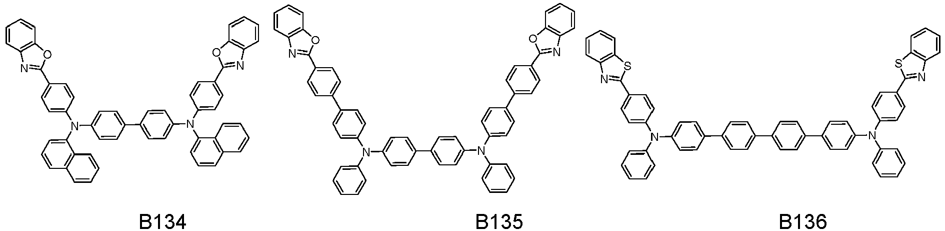

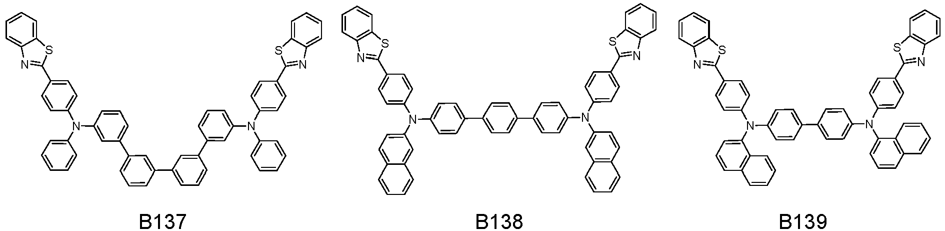

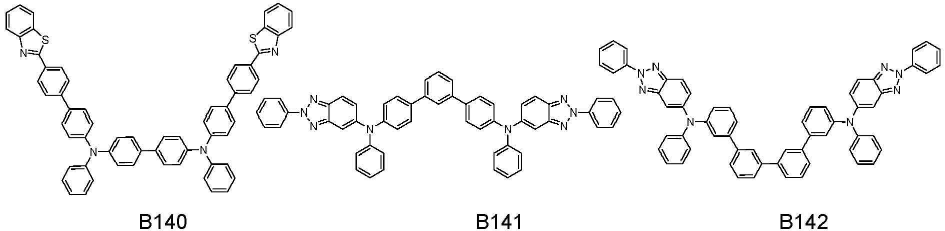

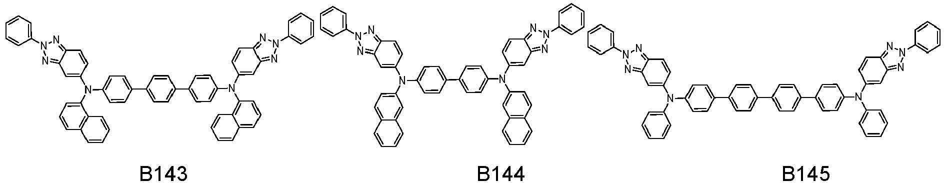

8. The organic electroluminescent device according to claim 1, wherein the light emitting layer comprises, as a host compound, an anthracene derivative represented by Formula D: 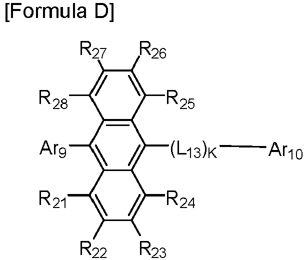 wherein R₂₁ to R₂₈ are identical to or different from each other and are as defined for R₁ to R₃ in Formula A-1 or A-2, Ar₉ and Ar₁₀ are identical to or different from each other and are each independently selected from hydrogen, deuterium, substituted or unsubstituted C₁₋C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁₋C₃₀ alkoxy, substituted or unsubstituted C₆-C₃₀ aryloxy, substituted or unsubstituted C₁₋C₃₀ alkylthioxy, substituted or unsubstituted C₆-C₃₀ arylthioxy, substituted or unsubstituted C₁₋C₃₀ alkylamine, substituted or unsubstituted C₆-C₃₀ arylamine, substituted or unsubstituted C₁₋C₃₀ alkylsilyl, and substituted or unsubstituted C₆-C₃₀ arylsilyl, L₁₃ is a single bond or is selected from substituted or unsubstituted C₆-C₂₀ arylene and substituted or unsubstituted C₂-C₂₀ heteroarylene, and k is an integer from 1 to 3, provided that when k is 2 or more, the linkers L₁₃ are identical to or different from each other.

9. The organic electroluminescent device according to claim 8, wherein the compound of Formula D is selected from the compounds of Formulae D1 to D48:

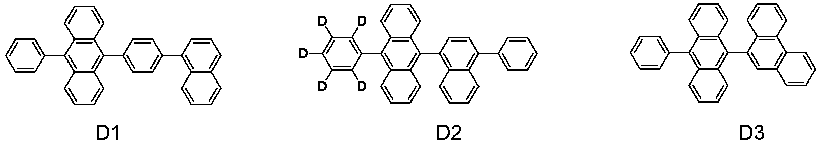

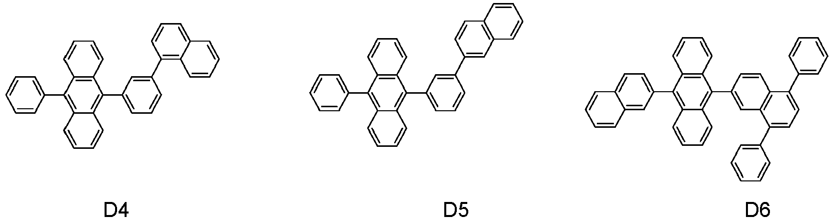

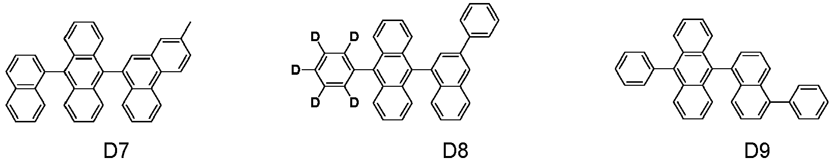

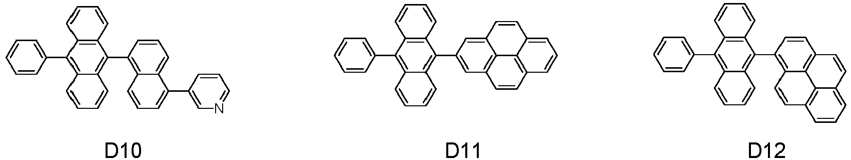

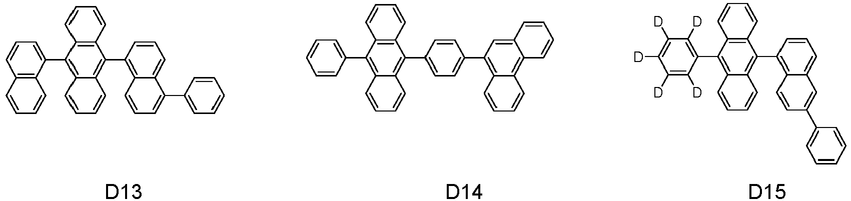

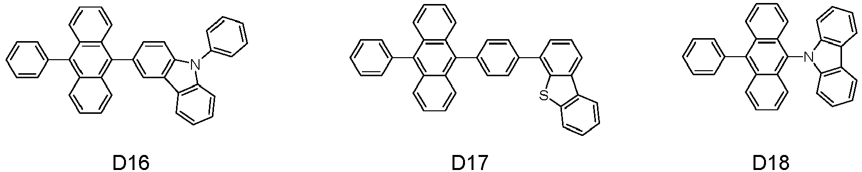

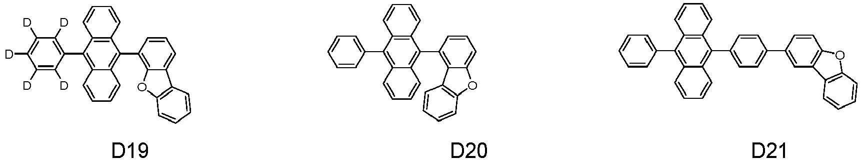

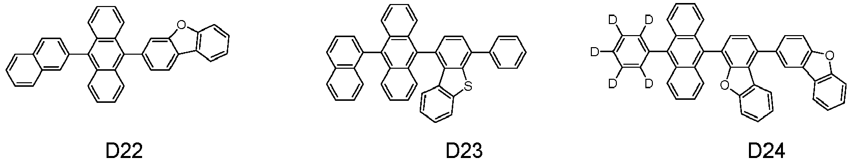

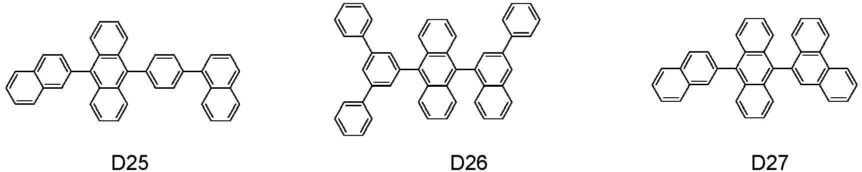

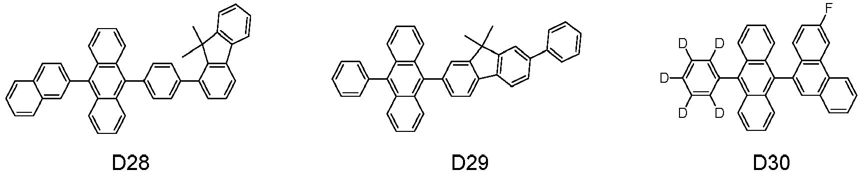

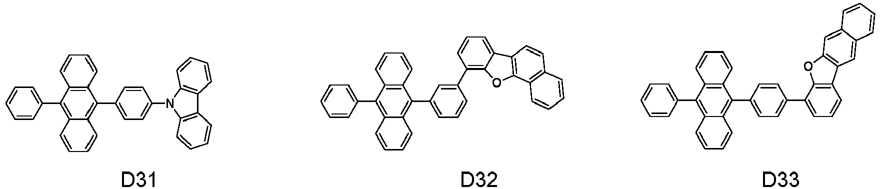

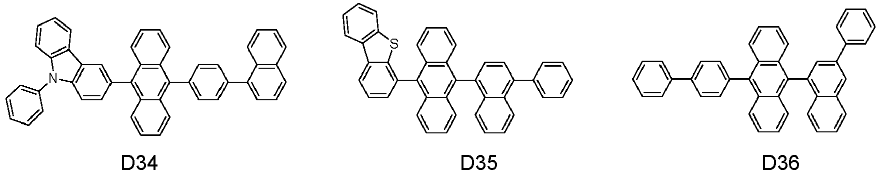

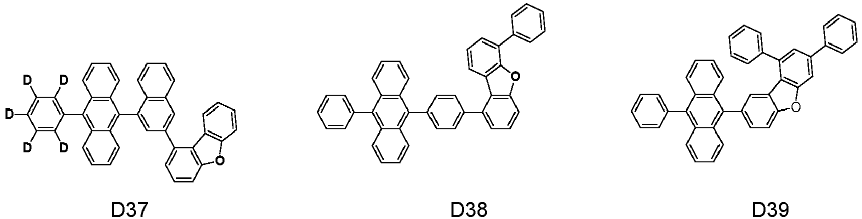

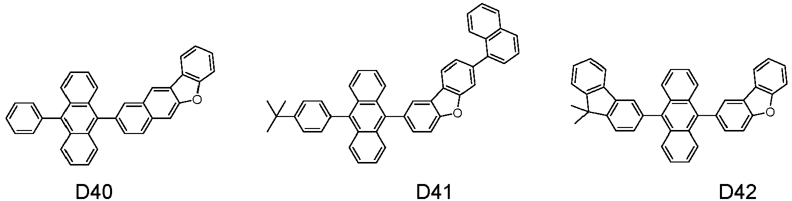

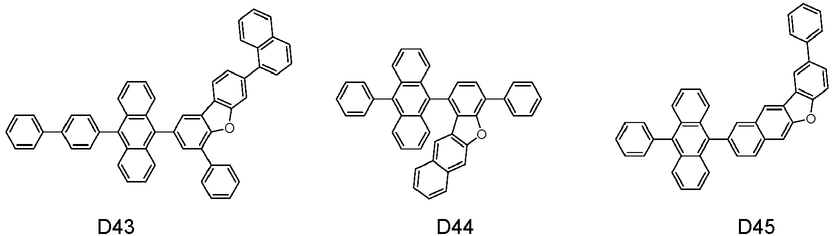

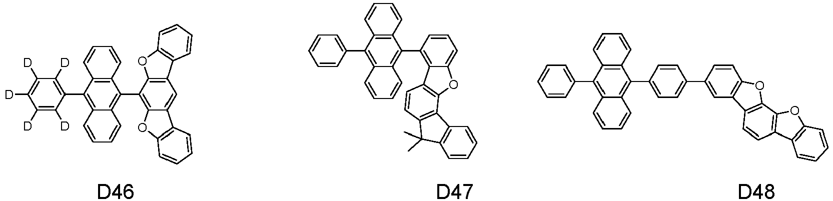

10. The organic electroluminescent device according to claim 1, further comprising a hole transport layer and an electron blocking layer interposed between the first electrode and the second electrode wherein each of the hole transport layer and the electron blocking layer comprises a compound represented by Formula E: 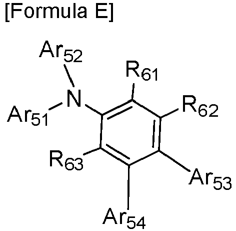 wherein R₆₁ to R₆₃ are identical to or different from each other and are each independently selected from hydrogen, deuterium, substituted or unsubstituted C₁₋C₃₀ alkyl, substituted or unsubstituted C₆-C₅₀ aryl, substituted or unsubstituted C₂-C₃₀ alkenyl, substituted or unsubstituted C₂-C₂₀ alkynyl, substituted or unsubstituted C₃-C₃₀ cycloalkyl, substituted or unsubstituted C₅-C₃₀ cycloalkenyl, substituted or unsubstituted C₂-C₅₀ heteroaryl, substituted or unsubstituted C₂-C₃₀ heterocycloalkyl, substituted or unsubstituted C₁₋C₃₀ alkoxy, substituted or unsubstituted C₆-C₃₀ aryloxy, substituted or unsubstituted C₁₋C₃₀ alkylthioxy, substituted or unsubstituted C₆-C₃₀ arylthioxy, substituted or unsubstituted C₁₋C₃₀ alkylamine, substituted or unsubstituted C₆-C₃₀ arylamine, substituted or unsubstituted C₁₋C₃₀ alkylsilyl, substituted or unsubstituted C₆-C₃₀ arylsilyl, substituted or unsubstituted C₁₋C₃₀ alkylgermanium, substituted or unsubstituted C₁₋C₃₀ arylgermanium, cyano, nitro, and halogen, and Ar₅₁ to Ar₅₄ are identical to or different from each other and are each independently substituted or unsubstituted C₆-C₄₀ aryl or substituted or unsubstituted C₂-C₃₀ heteroaryl.

11. The organic electroluminescent device according to claim 10, wherein the compound of Formula E is selected from the compounds of Formulae E1 to E33:

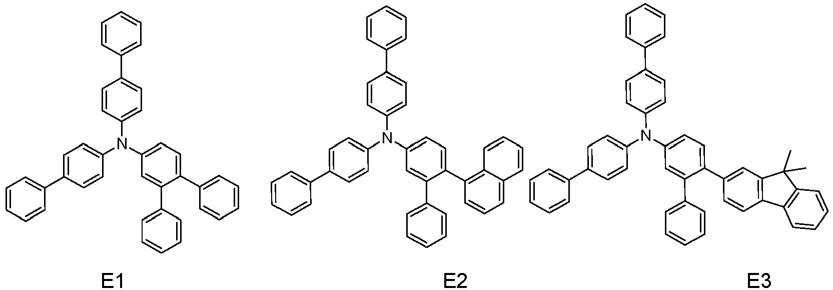

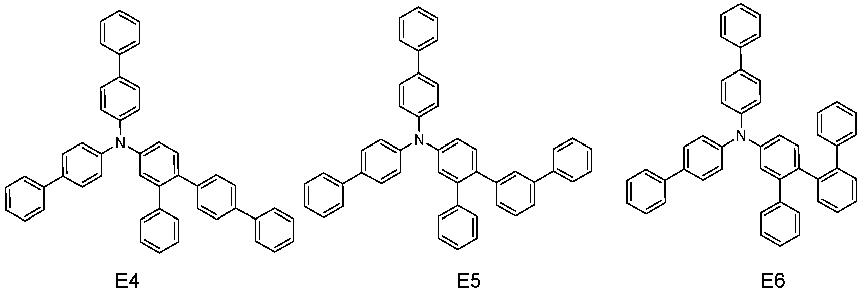

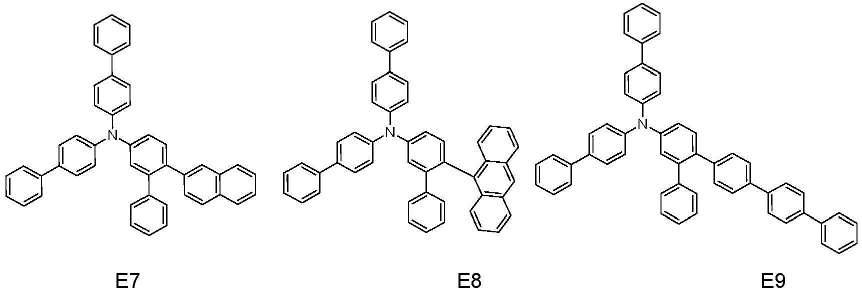

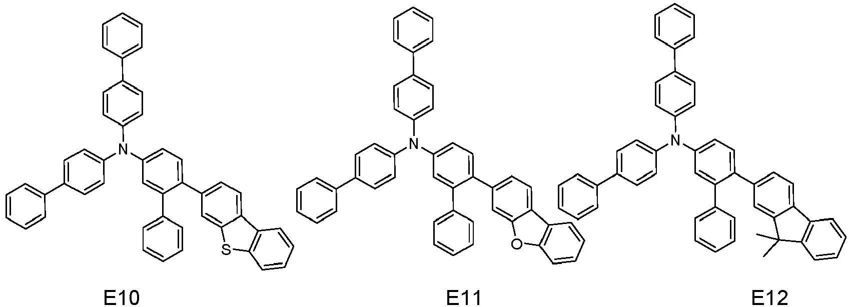

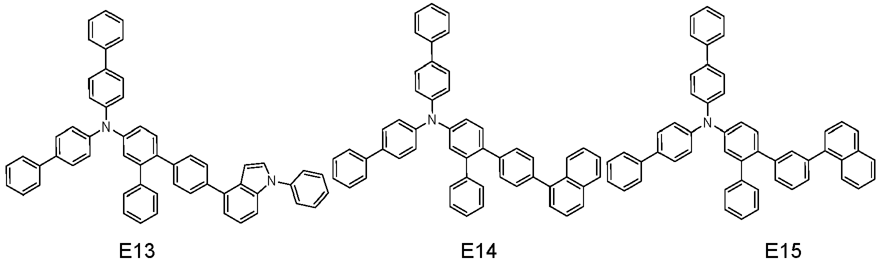

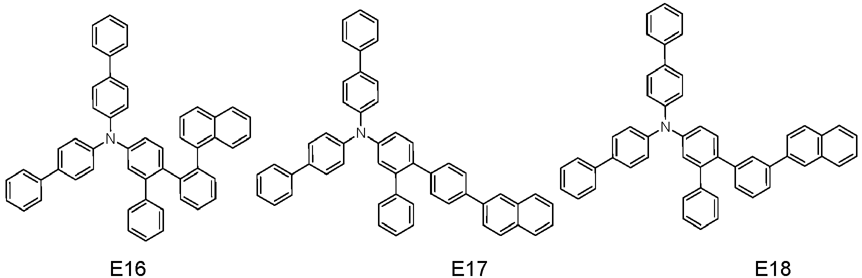

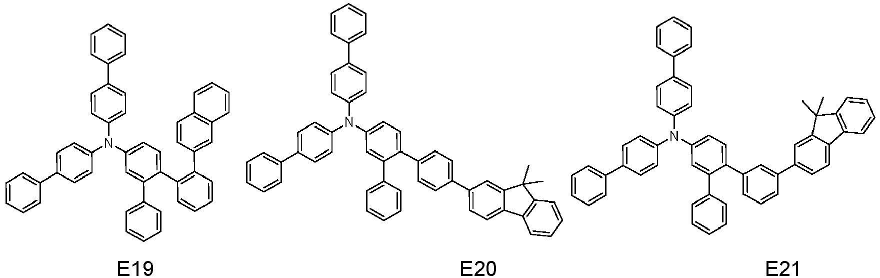

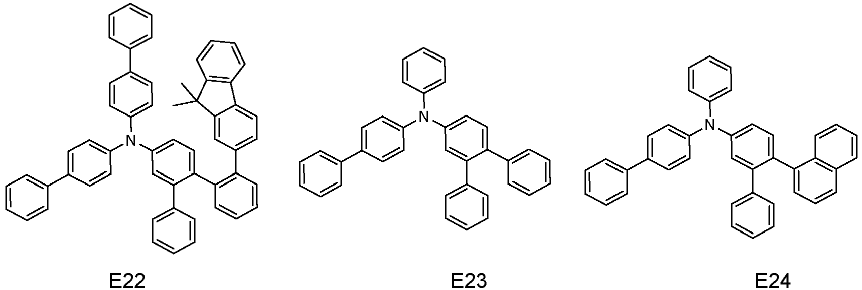

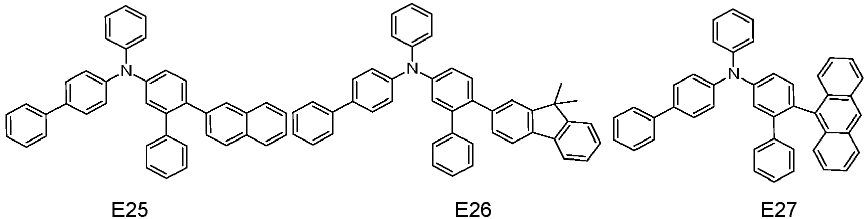

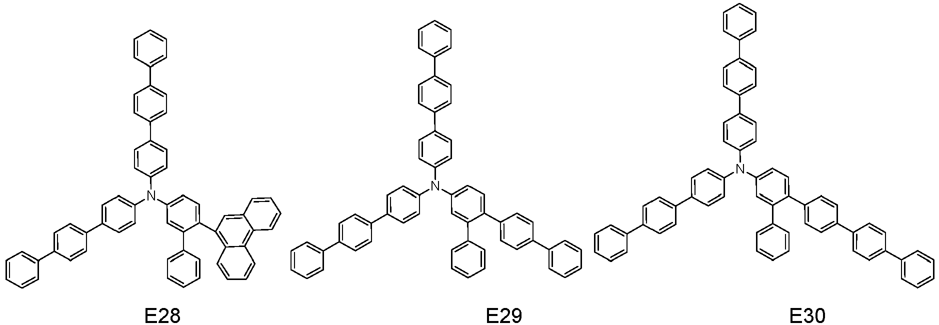

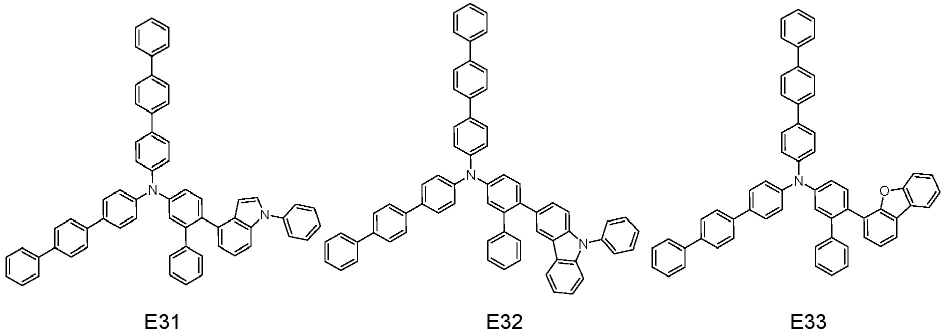

## Patentansprüche

1. Organische elektrolumineszente Vorrichtung, umfassend eine erste Elektrode, eine zweite Elektrode, die der ersten Elektrode gegenüberliegt, eine lichtemittierende Schicht, die zwischen der ersten und der zweiten Elektrode angeordnet ist, und eine Deckschicht, die auf einer der Oberflächen der ersten und der zweiten Elektrode, die der lichtemittierenden Schicht gegenüberliegt, gebildet ist, wobei die lichtemittierende Schicht eine der Verbindungen der Formel A-1 oder der Formel A-2 umfasst und die Deckschicht eine Verbindung der Formel B umfasst: 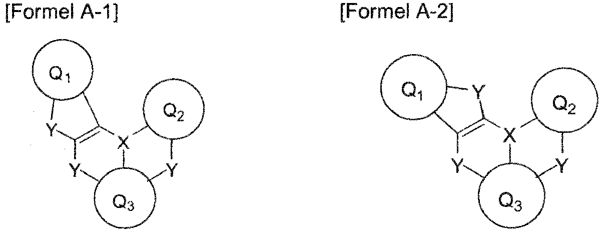 wobei Q₁ bis Q₃ identisch oder voneinander verschieden sind und jeweils unabhängig voneinander ein substituierter oder unsubstituierter aromatischer C₆-C₅₀-Kohlenwasserstoffring oder ein substituierter oder unsubstituierter heteroaromatischer C₂-C₅₀-Ring sind, die Verbindungsglieder Y identisch oder voneinander verschieden sind und jeweils unabhängig voneinander ausgewählt sind aus N-R₁, CR₂R₃, O und S, das X B ist, und R₁ bis R₃ identisch oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₆-C₅₀-Aryl, substituiertem oder unsubstituiertem C₃-C₃₀-Cycloalkyl, substituiertem oder unsubstituiertem C₂-C₅₀-Heteroaryl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem C₁-C₃₀-Alkylamin, substituiertem oder unsubstituiertem C₅-C₃₀-Arylamin, substituiertem oder unsubstituiertem C₁-C₃₀-Alkylsilyl, substituiertem oder unsubstituiertem C₅-C₃₀-Arylsilyl, Nitro, Cyano und Halogen, mit der Maßgabe, dass jedes von R₁ bis R₅ gegebenenfalls an Q₁, Q₂ oder Q₃ gebunden ist, um einen alicyclischen oder aromatischen monocyclischen oder polycyclischen Ring zu bilden, R₂ und R₃ gegebenenfalls miteinander verbunden sind, um einen alicyclischen oder aromatischen monocyclischen oder polycyclischen Ring zu bilden, und 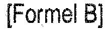 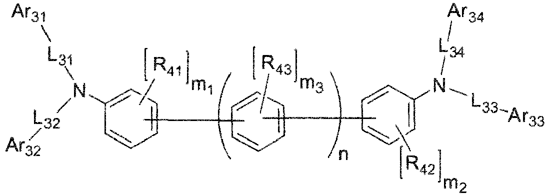 wobei R₄₁ bis R₄₃ gleich oder voneinander verschieden sind und jeweils unabhängig voneinander ausgewählt sind aus Wasserstoff, Deuterium, substituiertem oder unsubstituiertem C₁-C₂₀-Alkyl, substituiertem oder unsubstituiertem C₆-C₅₀-Aryl, substituiertem oder unsubstituiertem C₇-C₅₀-Arylalkyl, substituiertem oder unsubstituiertem C₃-C₃₀-Cycloalkyl, substituiertem oder unsubstituiertem C₁-C₃₀-Alkylsilyl, substituiertem oder unsubstituiertem C₆-C₃₀-Arylsilyl, und Halogen, L₃₁ bis L₃₄ sind gleich oder voneinander verschieden und sind jeweils unabhängig voneinander Einfachbindungen oder ausgewählt aus substituiertem oder unsubstituiertem C₆-C₅₀-Arylen und substituiertem oder unsubstituiertem C₂-C₅₀-Heteroarylen, Ar₃, bis Ar₃₄ sind gleich oder voneinander verschieden und sind jeweils unabhängig voneinander ausgewählt aus substituiertem oder unsubstituiertem C₆-C₅₀-Aryl und substituiertem oder unsubstituiertem C₂-C₅₀-Heteroaryl, n ist eine ganze Zahl von 0 bis 4, mit der Maßgabe, dass, wenn n 2 oder größer ist, die aromatischen Ringe, die R₄₃ enthalten, identisch oder voneinander verschieden sind, m1 bis m3 sind ganze Zahlen von 0 bis 4, mit der Maßgabe, dass, wenn sowohl m₁ als auch m₃ 2 oder mehr sind, die Gruppen R₄₁, R₄₂ und R₄₃ identisch oder voneinander verschieden sind, und Wasserstoff- oder Deuteriumatome sind an die Kohlenstoffatome der aromatischen Ringe gebunden, an die R₄₁ bis R₄₃ nicht gebunden sind.

2. Die organische elektrolumineszente Vorrichtung nach Anspruch 1, wobei die Verbindung der Formel A-1 oder A-2 von der Formel A-3 oder Formel A-4 verkörpert wird: 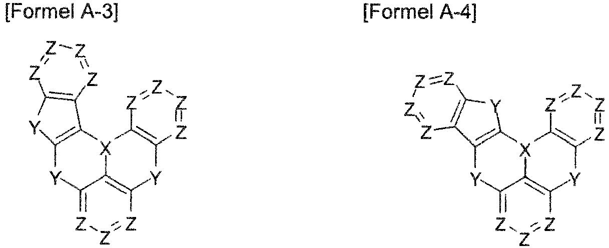 wobei jedes Z unabhängig CR oder N ist, die Substituenten R gleich oder voneinander verschieden sind und unabhängig voneinander ausgewählt sind aus Wasserstoff, Deuterium, substituiertem oder unsubstituiertem C₁-C₃₀-Alkyl, substituiertem oder unsubstituiertem C₆-C₅₀-Aryl, substituiertem oder unsubstituiertem C₃-C₃₀-Cycloalkyl, substituiertem oder unsubstituiertem C₂-C₅₀-Heteroaryl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem C₁-C₃₀-Alkylamin, substituiertem oder unsubstituiertem C₅-C₃₀-Arylamin, substituiertem oder unsubstituiertem C₁-C₃₀-Alkylsilyl, substituiertem oder unsubstituiertem C₅-C₃₀-Arylsilyl, Nitro, Cyano und Halogen, mit der Maßgabe, dass die Substituenten R wahlweise aneinander gebunden sind oder wahlweise mit anderen benachbarten Substituenten verbunden sind, um alicyclische oder aromatische monocyclische oder polycyclische Ringe zu bilden, deren Kohlenstoffatome wahlweise mit einem oder mehreren Heteroatomen, ausgewählt aus N-, S- und O-Atomen, substituiert sind, und X und Y wie in den Formeln A-1 und A-2 definiert sind.

3. Die organische elektrolumineszente Vorrichtung nach Anspruch 1, wobei die Verbindung der Formel A-1 oder A-2 von der Formel A-5 oder Formel A-6 verkörpert wird: 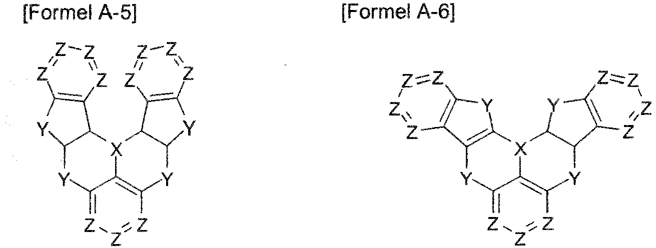 wobei jedes Z unabhängig CR oder N ist, die Substituenten R gleich oder voneinander verschieden sind und unabhängig ausgewählt sind aus Wasserstoff, Deuterium, substituiertem oder unsubstituiertem C₁-C₃₀-Alkyl, substituiertem oder unsubstituiertem C₆-C₅₀-Aryl, substituiertem oder unsubstituiertem C₃-C₃₀-Cycloalkyl, substituiertem oder unsubstituiertem C₂-C₅₀-Heteroaryl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem C₁-C₃₀-Alkylamin, substituiertem oder unsubstituiertem C₅-C₃₀-Arylamin, substituiertem oder unsubstituiertem C₁-C₃₀-Alkylsilyl, substituiertem oder unsubstituiertem C₅-C₃₀-Aryisilyl, Nitro, Cyano und Halogen, mit der Maßgabe, daß die Substituenten R wahlweise aneinander gebunden sind oder wahlweise mit anderen benachbarten Substituenten verbunden sind, um alicyclische oder aromatische monocyclische oder polycyclische Ringe zu bilden, deren Kohlenstoffatome wahlweise mit einem oder mehreren Heteroatomen, ausgewählt aus N-, S- und O-Atomen, substituiert sind, und X und Y wie in den Formeln A-1 und A-2 definiert sind.

4. Die organische elektrolumineszente Vorrichtung nach Anspruch 1, wobei mindestens eines von Ar₃₁ bis Ar₃₄ in Formel B durch die Formel C repräsentiert wird: 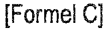 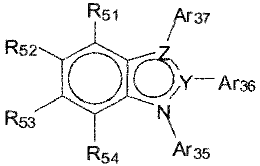 wobei R₅₁ bis R₅₄ gleich oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₆-C₅₀-Aryl, substituiertem oder unsubstituiertem C₂-C₃₀-Alkenyl, substituiertem oder unsubstituiertem C₂-C₂₀-Alkinyl, substituiertem oder unsubstituiertem C₃-C₃₀-Cycloalkyl, substituiertem oder unsubstituiertem C₅-C₃₀-Cycloalkenyl, substituiertem oder unsubstituiertem C₂-C₅₀-Heteroaryl, substituiertem oder unsubstituiertem C₂-C₃₀-Heterocycloalkyl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₅-C₃₀-Arylthioxy, substituiertem oder unsubstituiertem C₁-C₃₀-Alkylamin, substituiertem oder unsubstituiertem C₅-C₃₀-Arylamin, substituiertem oder unsubstituiertem C₁-C₃₀-Alkylsilyl, substituiertem oder unsubstituiertem C₅-C₃₀-Arylsilyl, Nitro, Cyano und Halogen, die wahlweise miteinander verbunden sind, um einen Ring zu bilden, Y ein Kohlenstoff- oder Stickstoffatom ist, Z ein Kohlenstoff-, Sauerstoff-, Schwefel- oder Stickstoffatom ist, Ar₃₅ bis Ar₃₇ gleich oder voneinander verschieden sind und jeweils unabhängig voneinander ausgewählt sind aus substituiertem oder unsubstituiertem C₅-C₅₀-Aryl und substituiertem oder unsubstituiertem C₃-C₅₀-Heteroaryl, mit der Maßgabe, dass, wenn Z ein Sauerstoff- oder Schwefelatom ist, Ar₃₇ nichts ist, mit der Maßgabe, dass, wenn Y und Z Stickstoffatome sind, nur eines von Ar₃₅, Ar₃₆ und Ar₃₇ vorhanden ist, mit der Maßgabe, dass, wenn Y ein Stickstoffatom ist und Z ein Kohlenstoffatom ist, Ar₃₆ nichts ist, mit der Maßgabe, dass eines von R₅₁ bis R₅₄ und Ar₃₅ bis Ar₃₇ eine Einfachbindung ist, die mit einem der Verbindungsglieder L₃₁ bis L₃₄ in Formel B verbunden ist.

5. Die organische elektrolumineszente Vorrichtung nach Anspruch 1, wobei die Verbindung der Formel A-1 oder A-2 ausgewählt ist aus den Verbindungen:

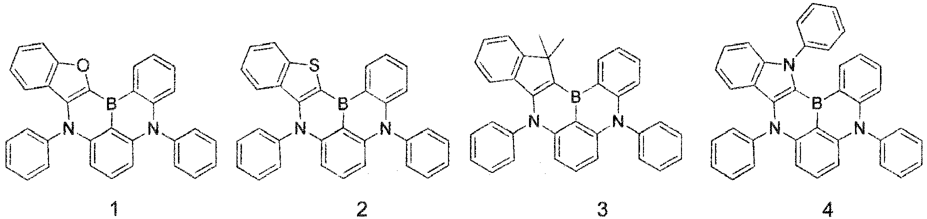

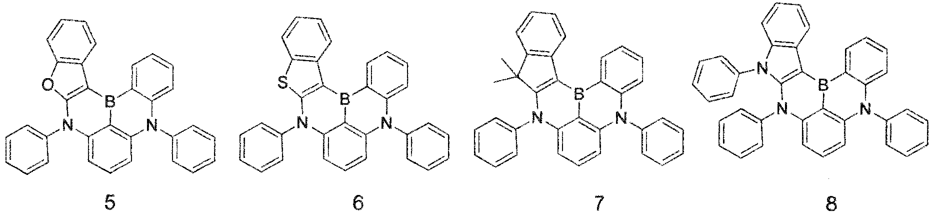

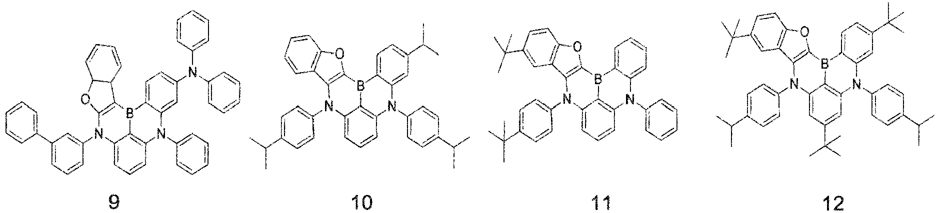

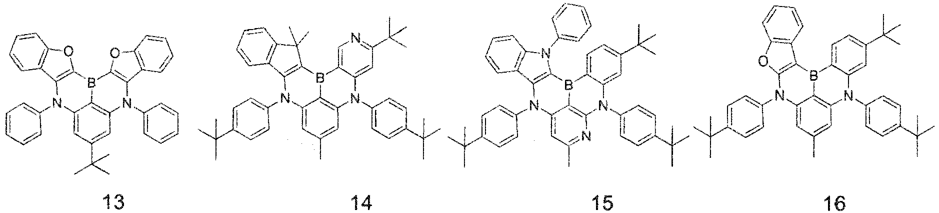

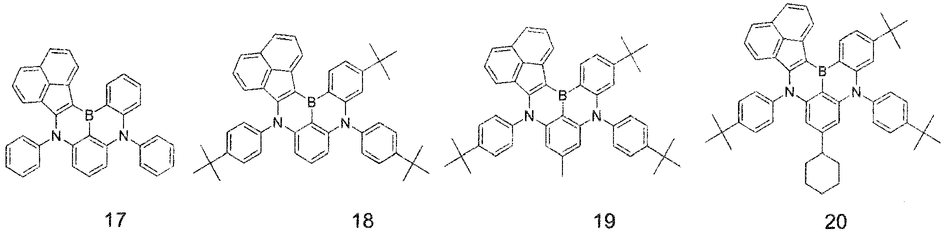

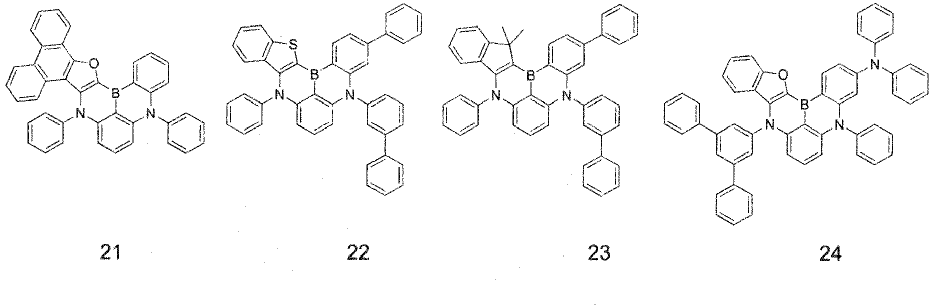

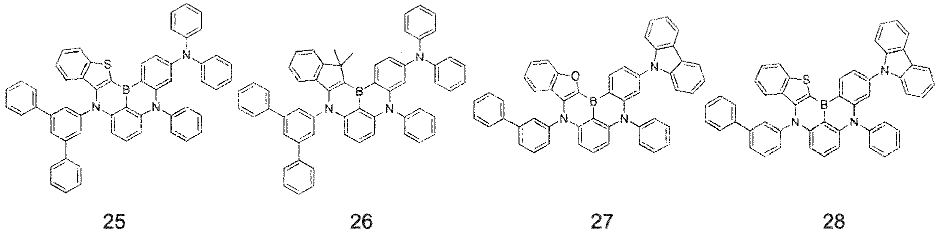

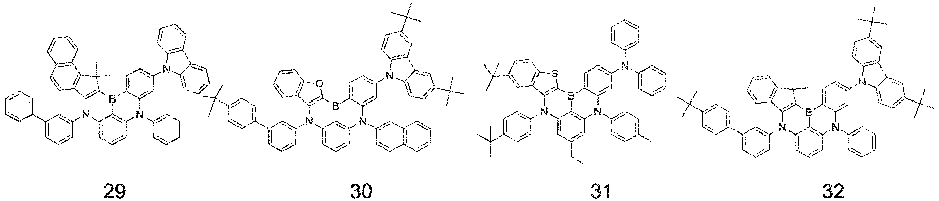

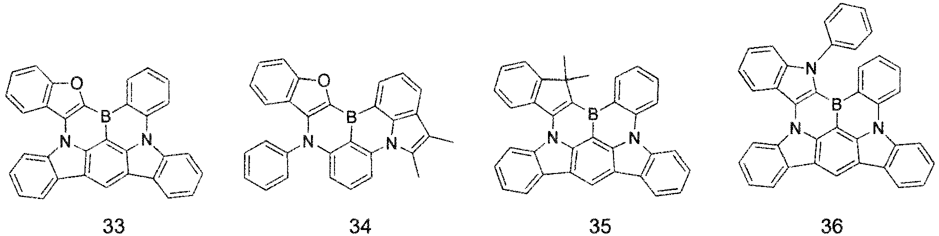

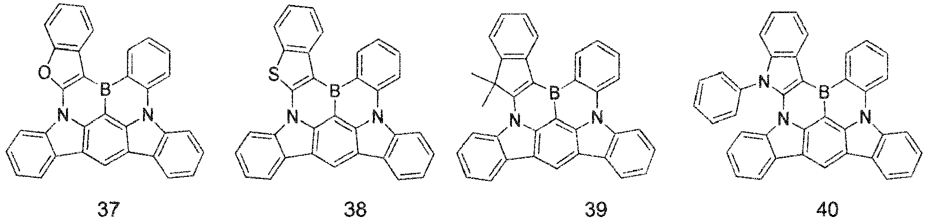

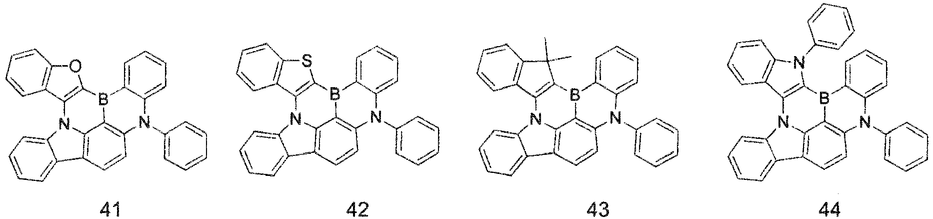

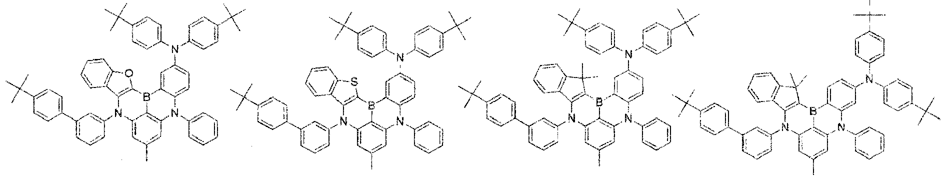

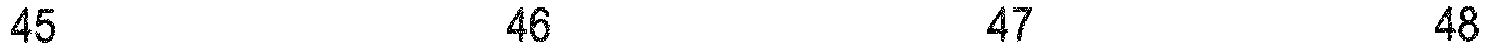

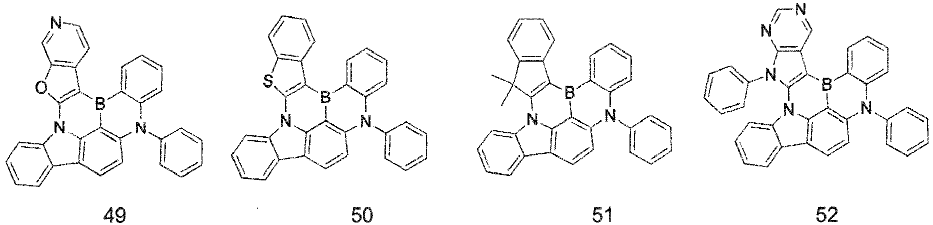

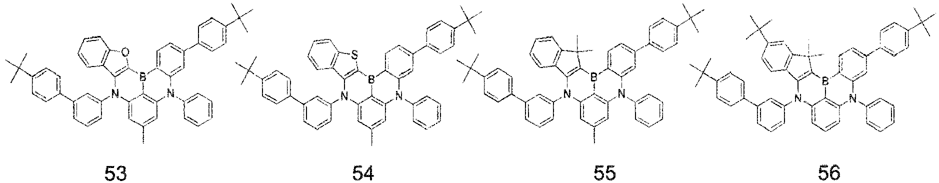

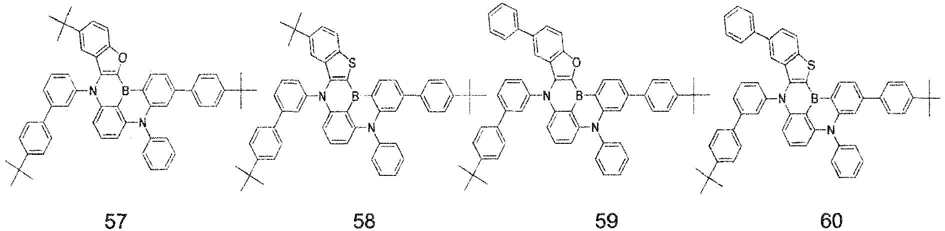

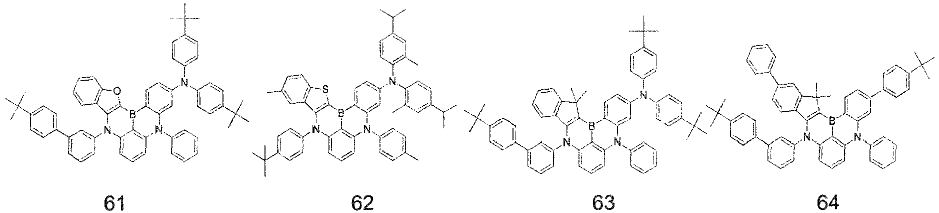

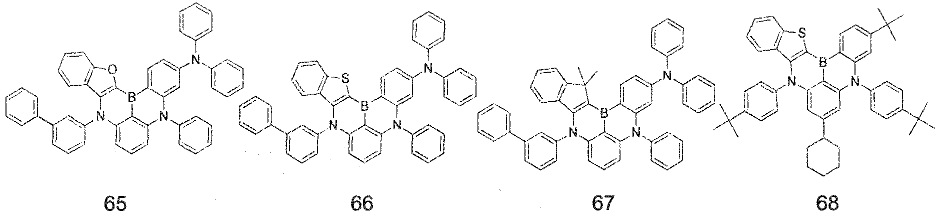

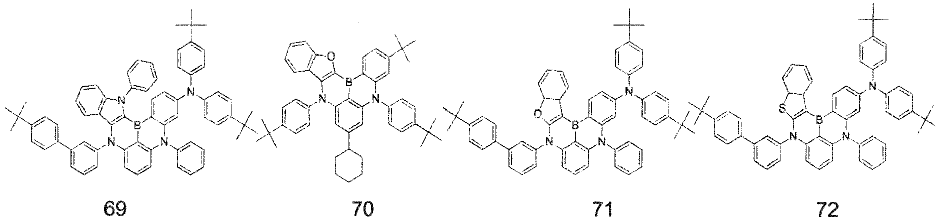

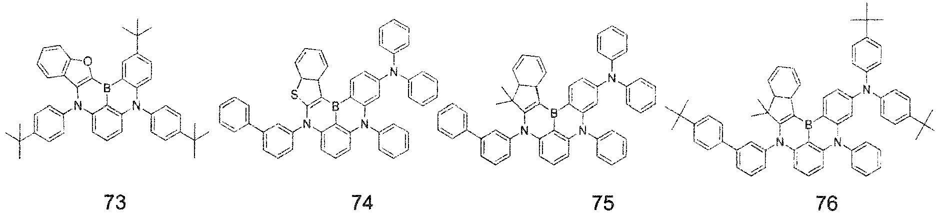

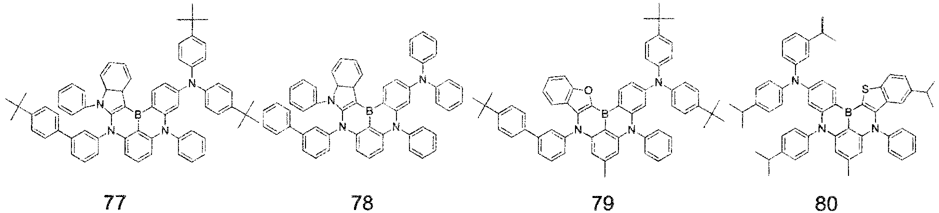

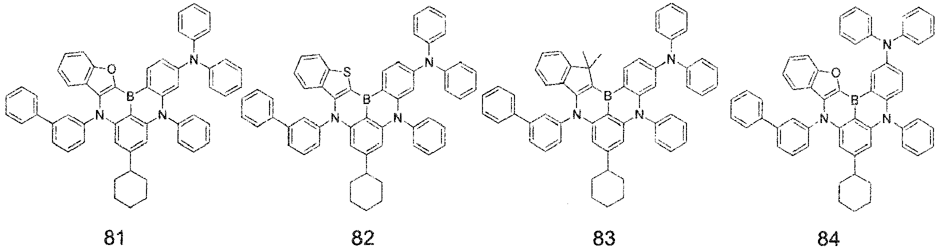

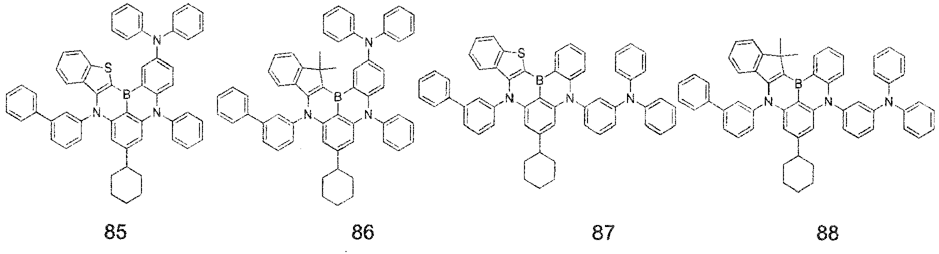

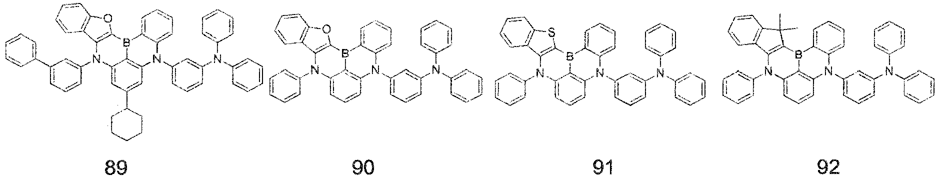

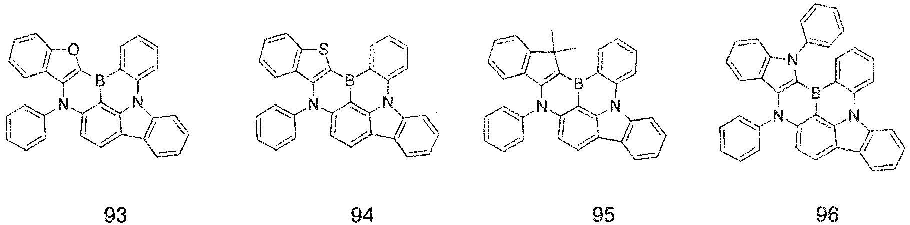

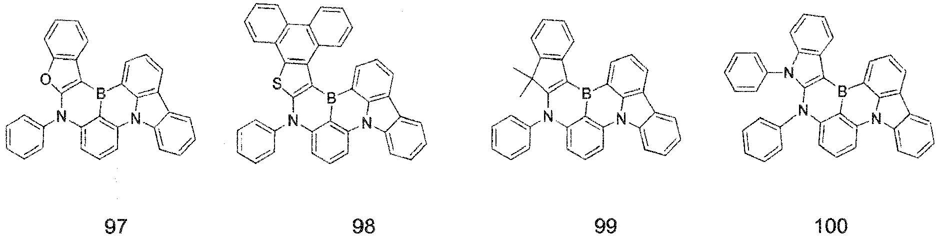

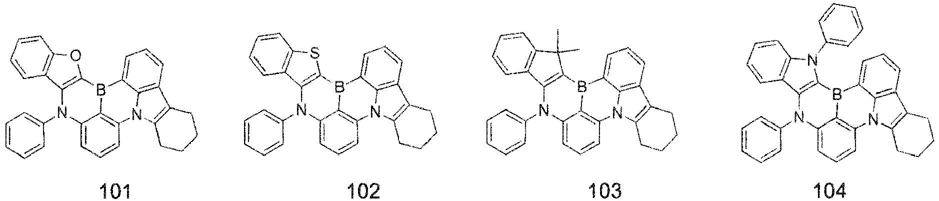

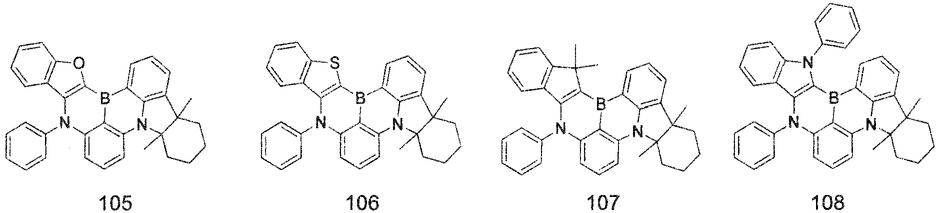

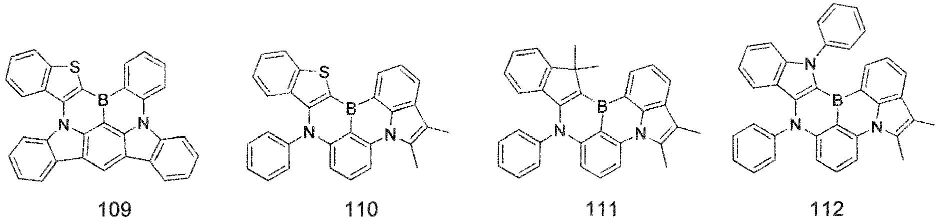

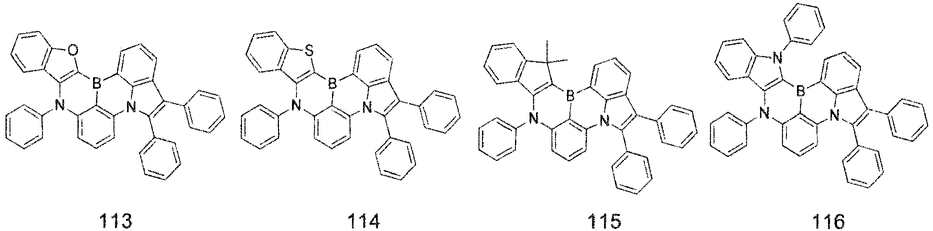

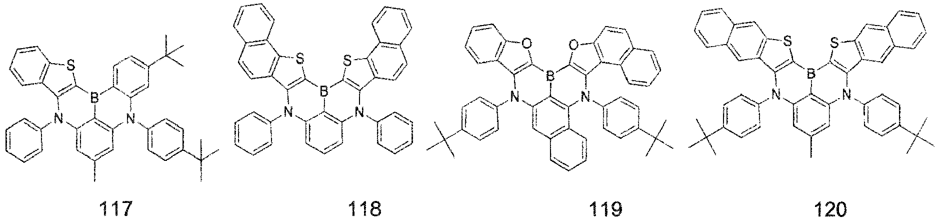

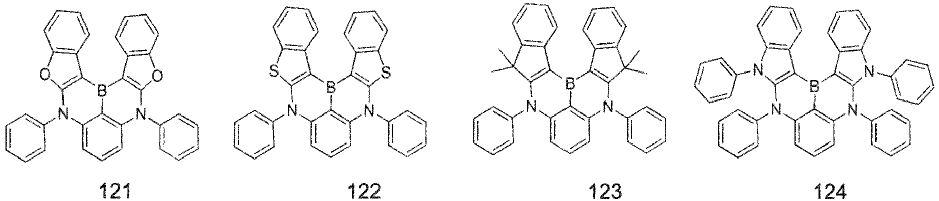

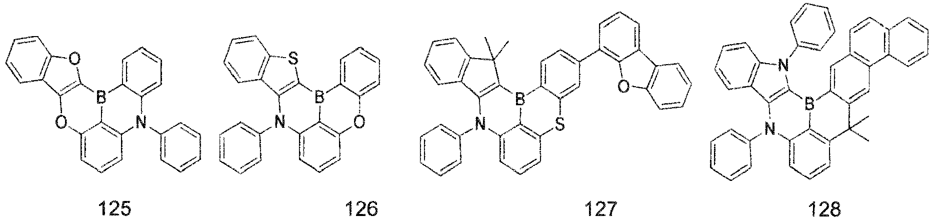

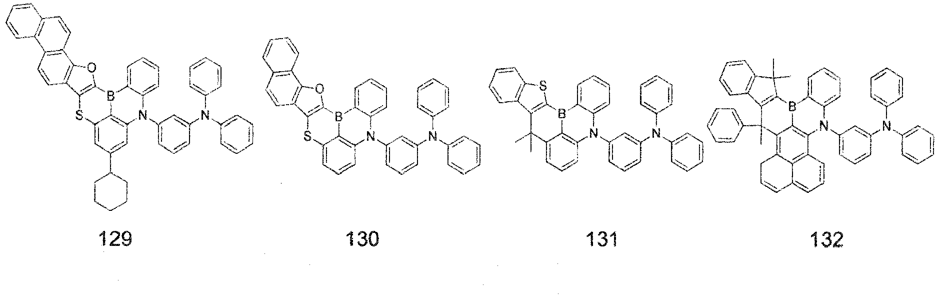

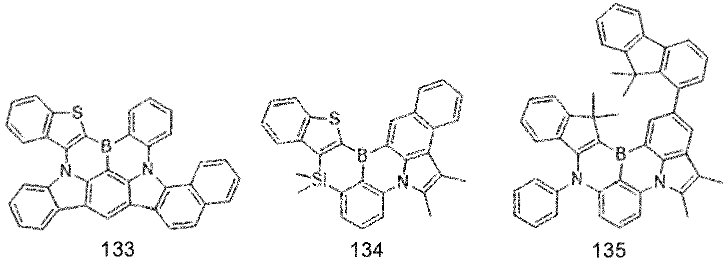

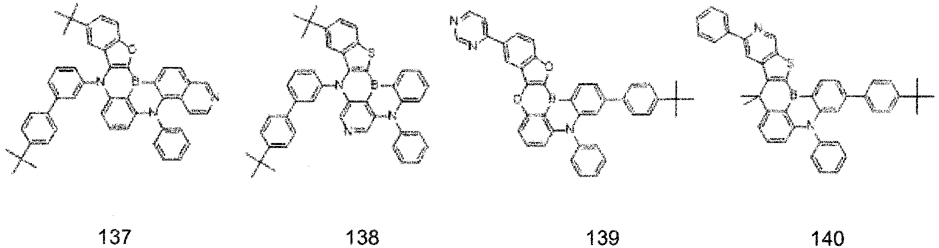

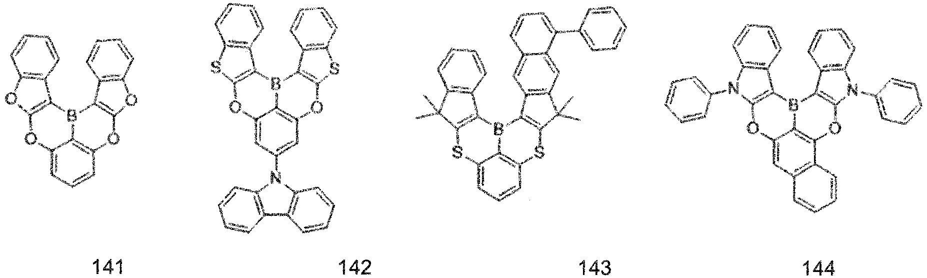

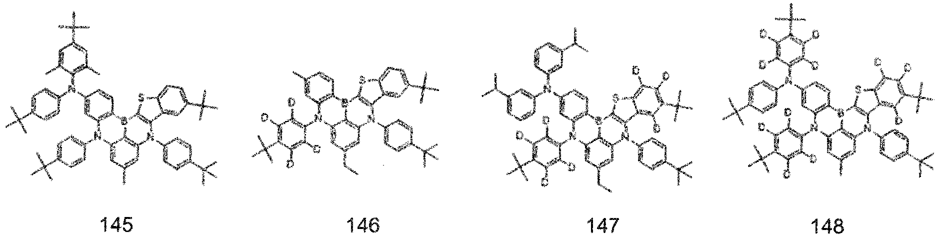

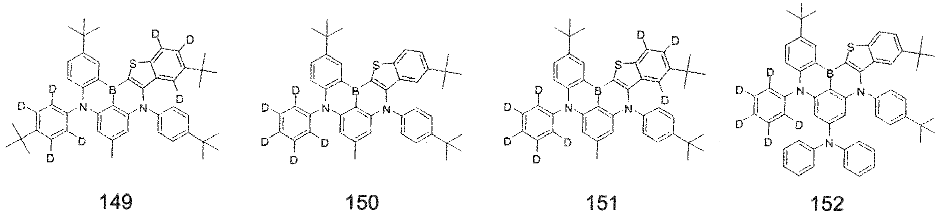

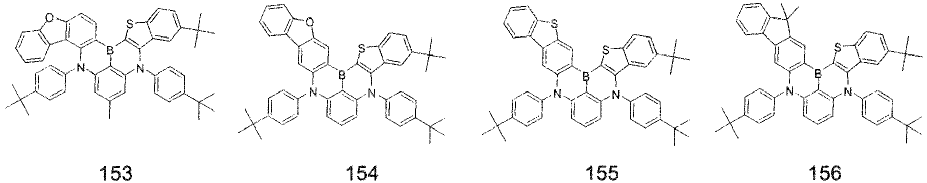

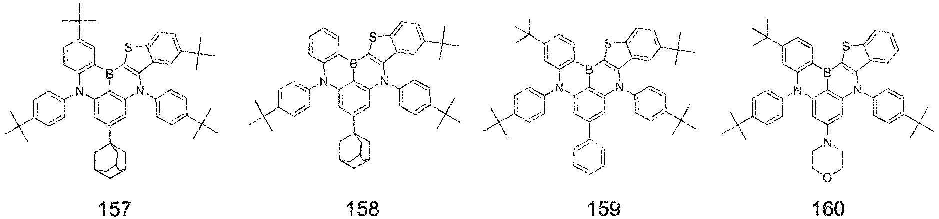

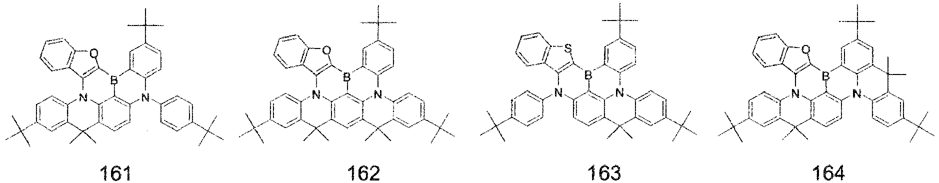

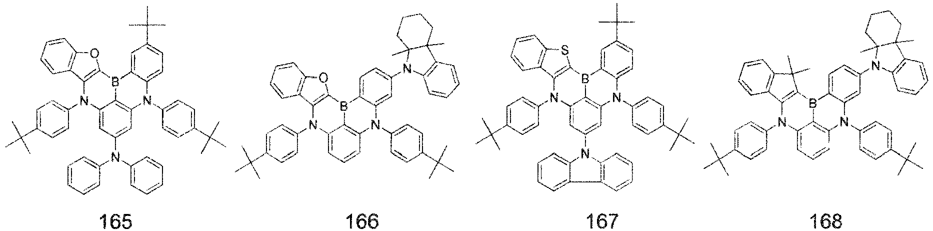

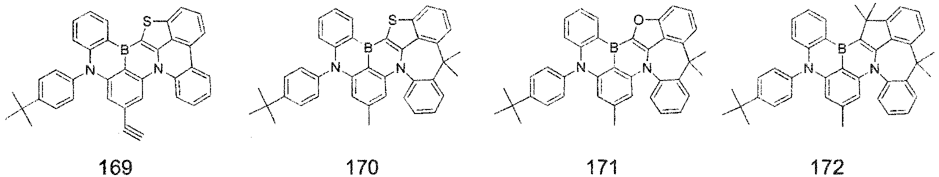

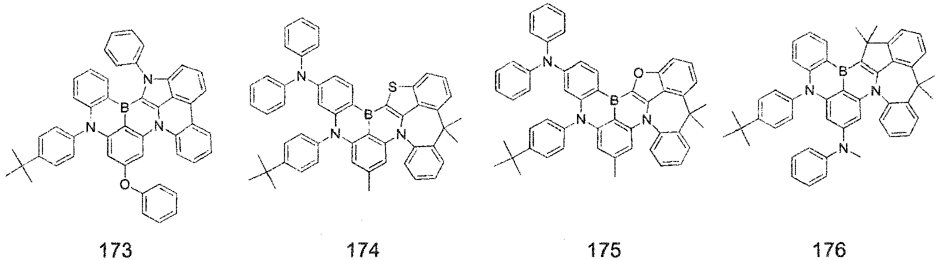

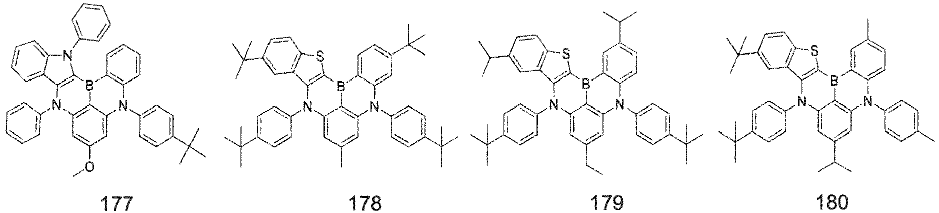

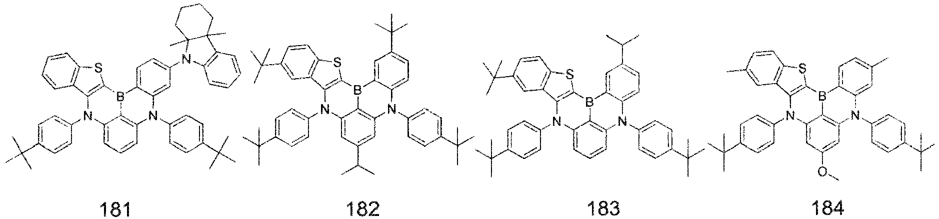

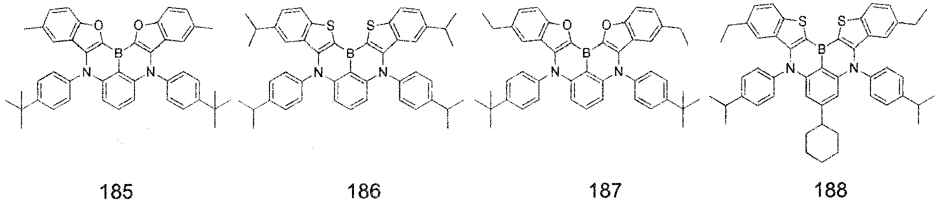

6. Die organische elektrolumineszente Vorrichtung nach Anspruch 1, wobei die Verbindung der Formel B ausgewählt ist aus den folgenden Verbindungen der Formeln B1 bis B79:

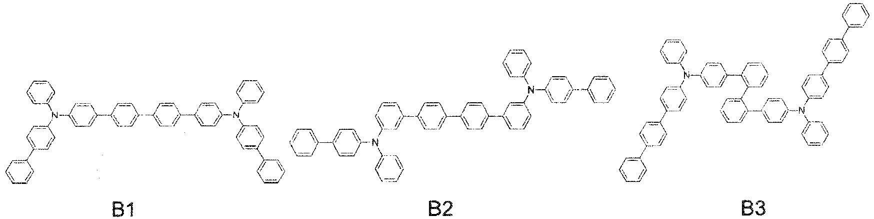

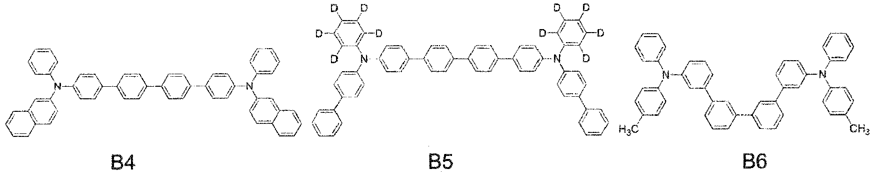

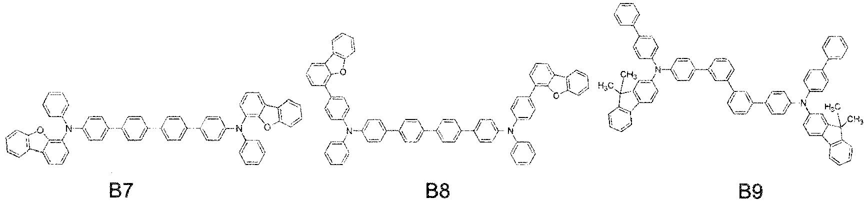

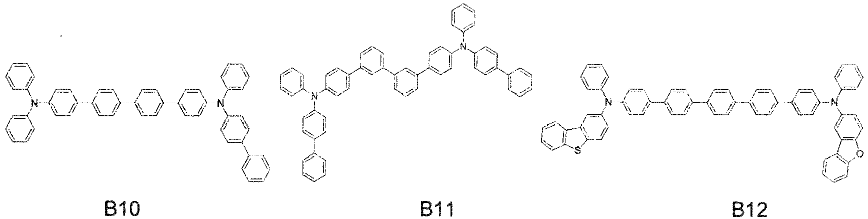

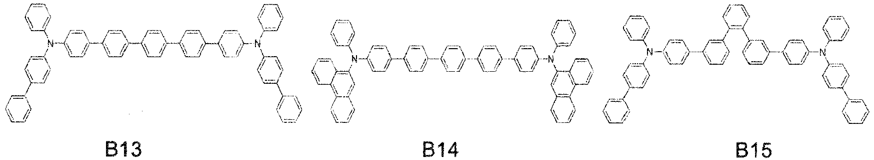

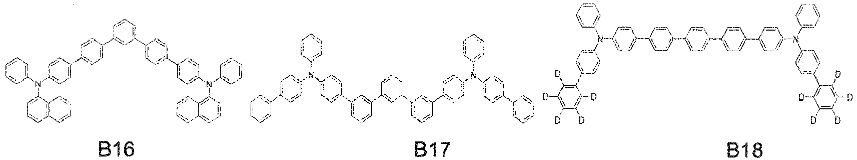

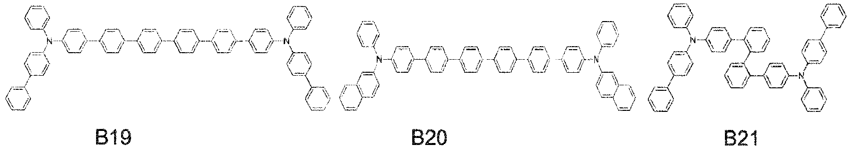

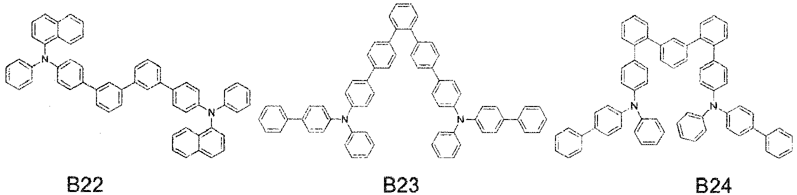

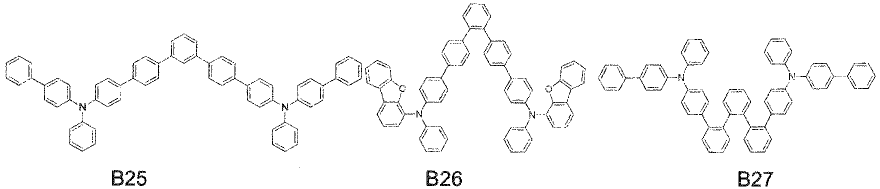

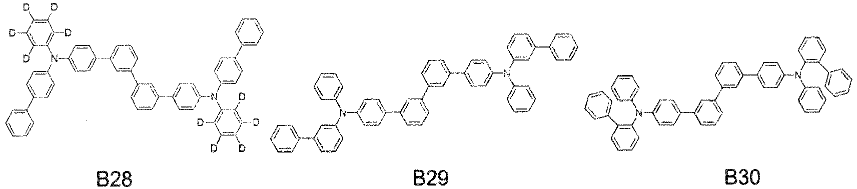

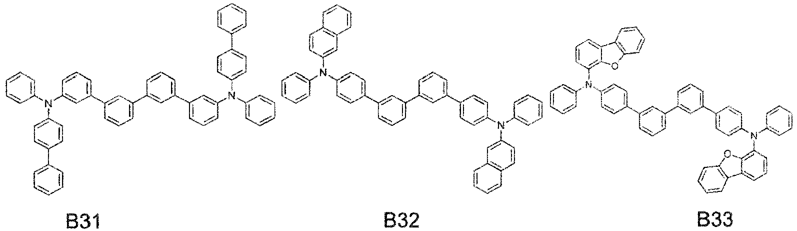

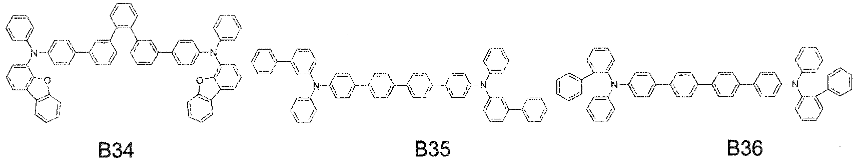

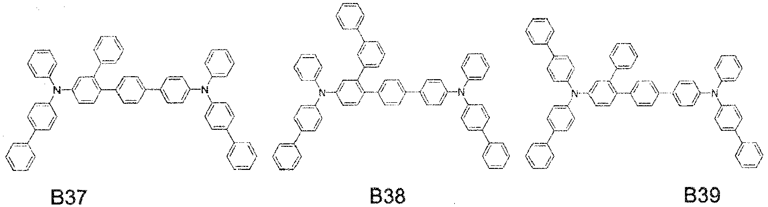

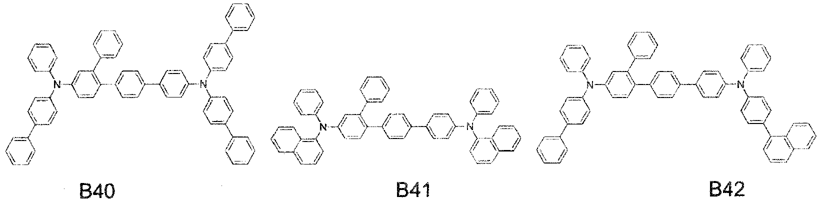

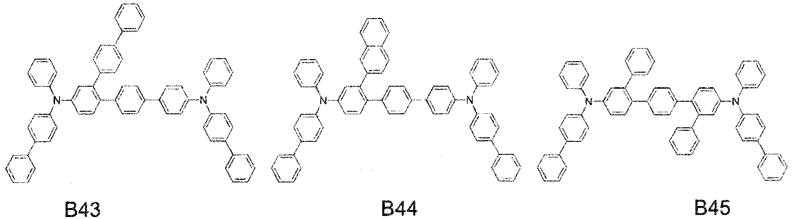

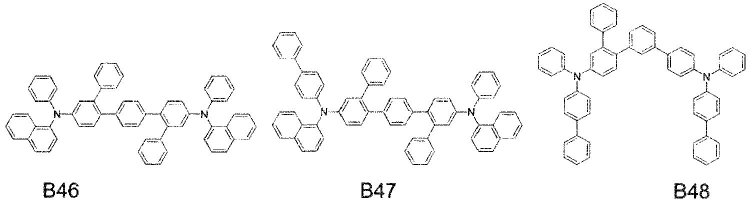

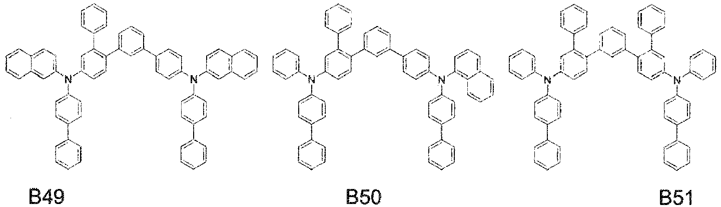

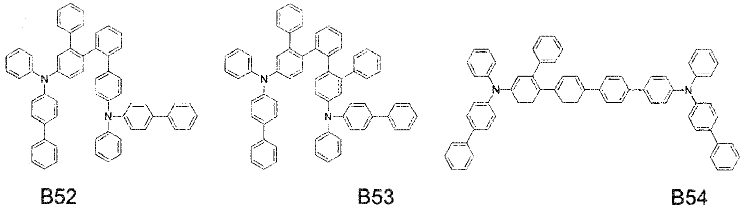

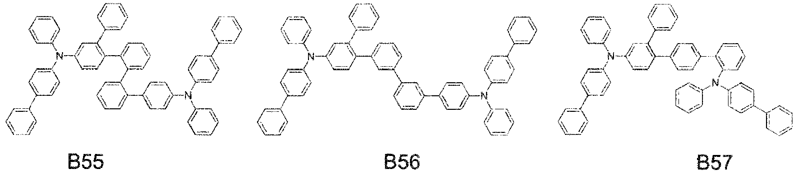

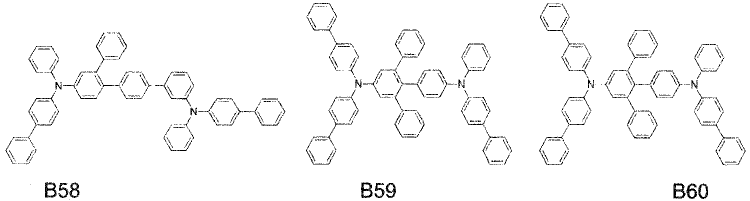

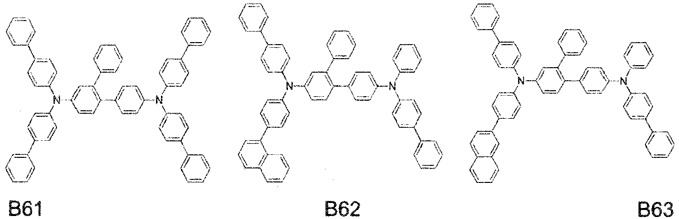

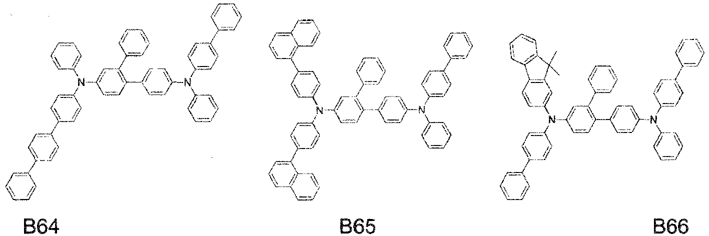

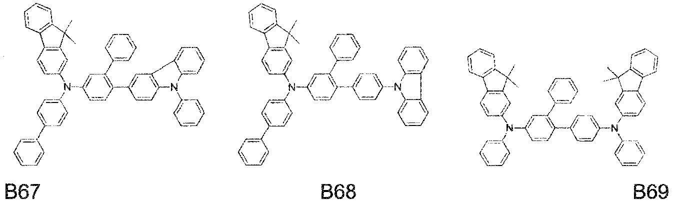

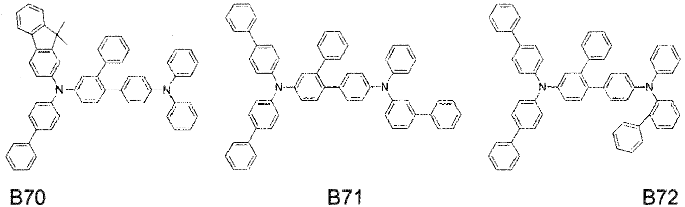

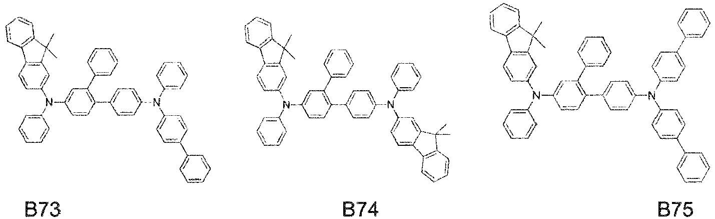

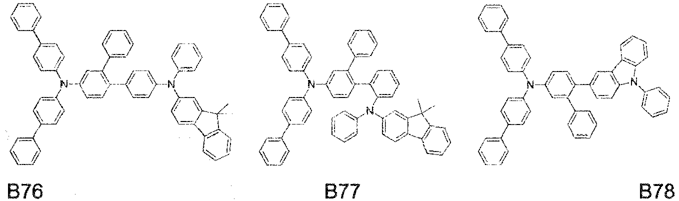

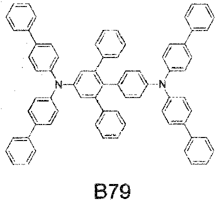

7. Die organische elektrolumineszente Vorrichtung nach Anspruch 1, wobei die Verbindung der Formel B aus den folgenden Verbindungen der Formel B101 bis B145 ausgewählt ist:

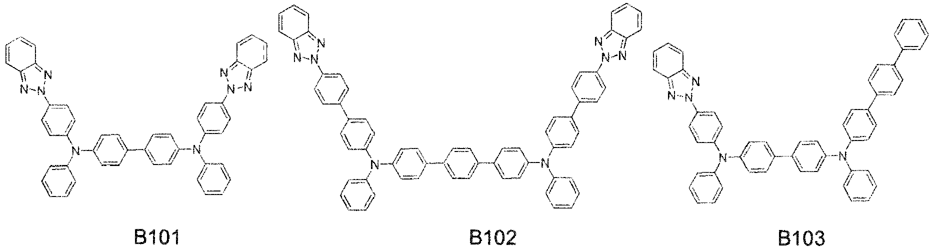

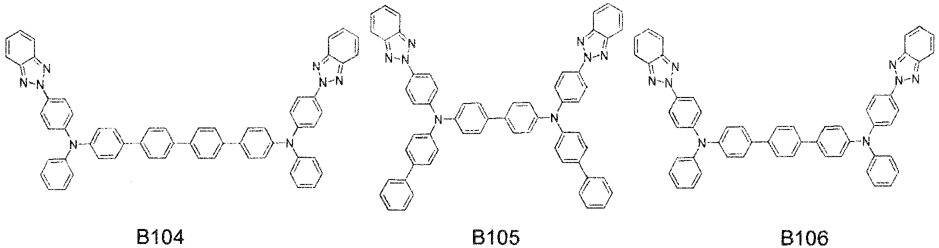

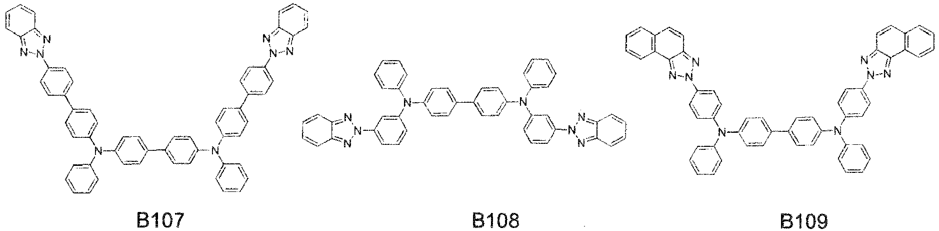

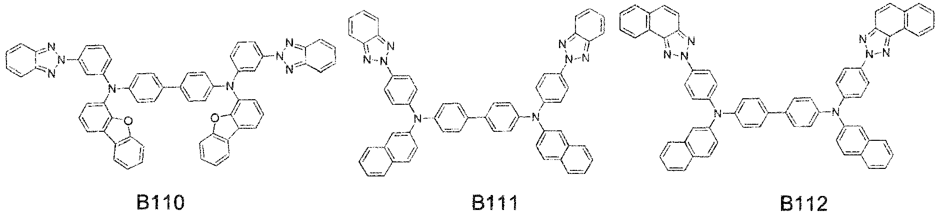

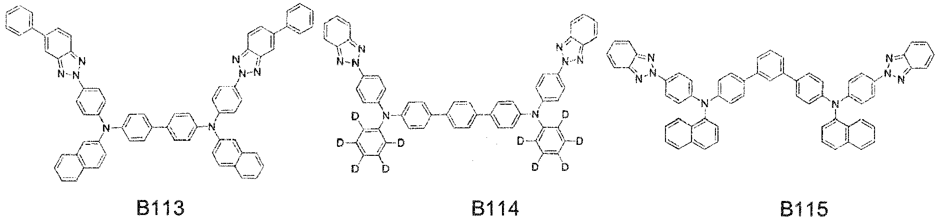

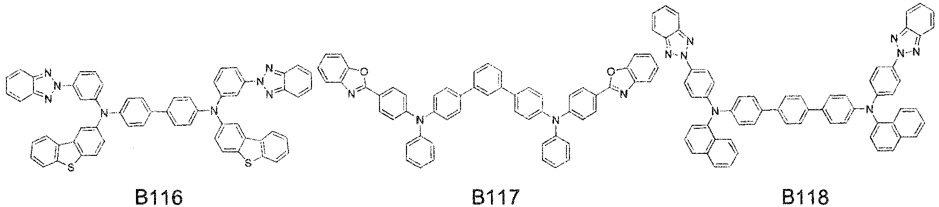

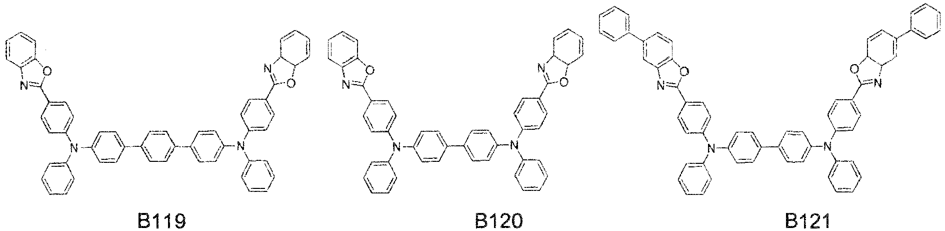

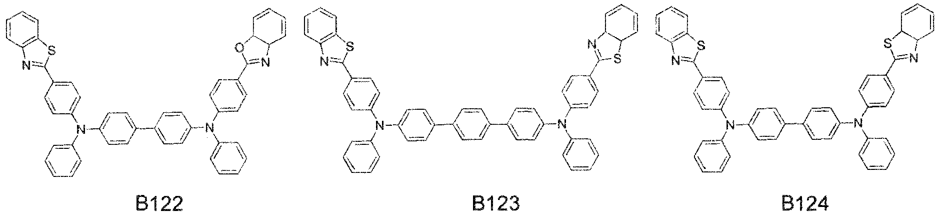

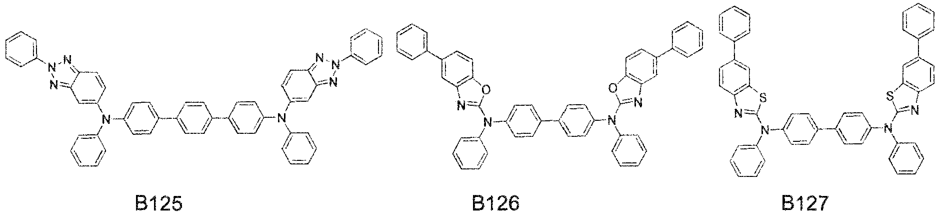

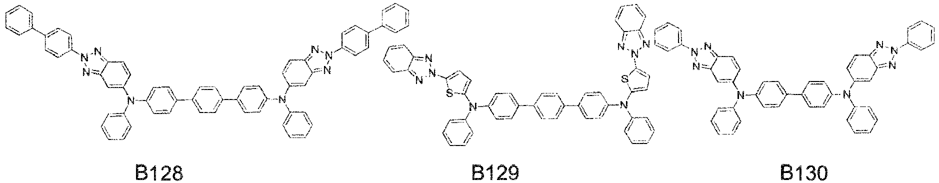

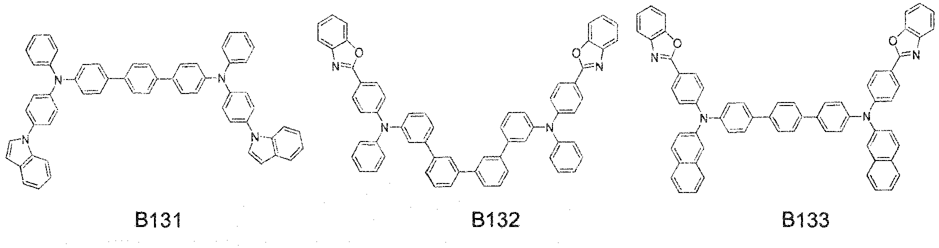

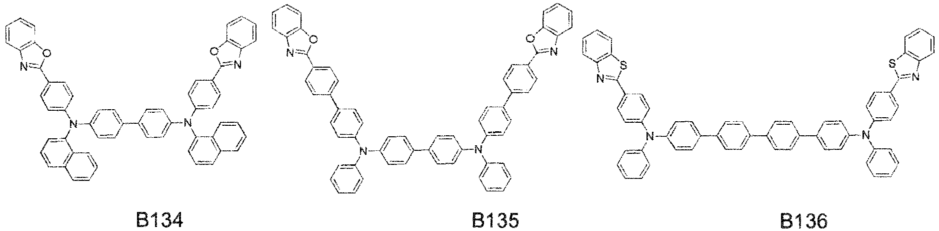

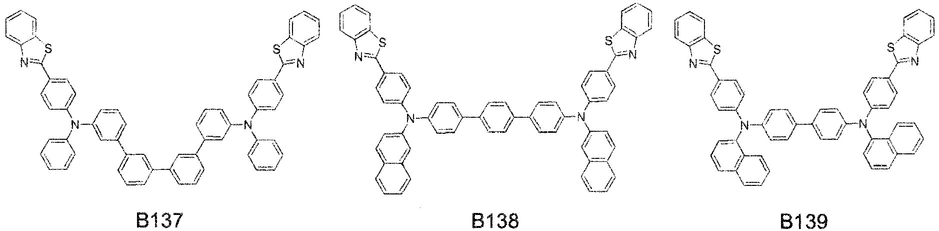

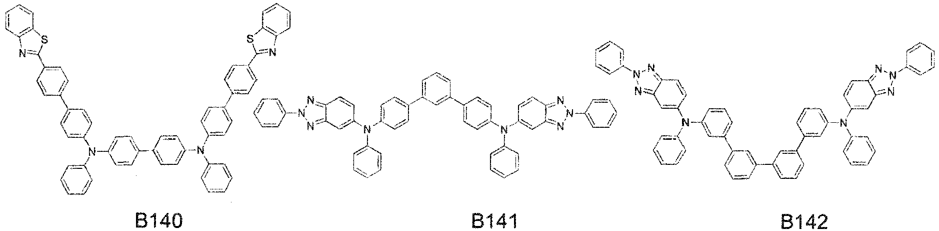

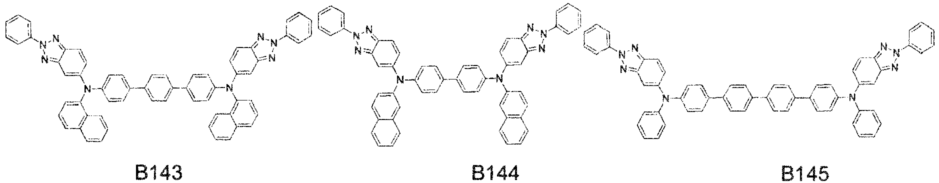

8. Die organische elektrolumineszente Vorrichtung nach Anspruch 1, wobei die lichtemittierende Schicht als Wirtsverbindung ein Anthracenderivat der Formel D umfasst: 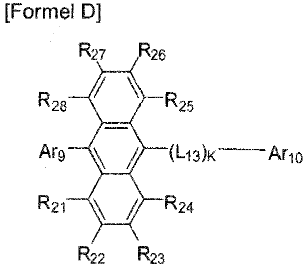 wobei R₂₁ bis R₂₈ identisch oder voneinander verschieden sind und wie R₁ bis R₃ in der Formel A-1 oder A-2 definiert sind, Ar₉ und Ar₁₀ identisch oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₆-C₅₀-Aryl, substituiertem oder unsubstituiertem C₂-C₃₀-Alkenyl, substituiertem oder unsubstituiertem C₂-C₂₀-Alkinyl, substituiertem oder unsubstituiertem C₃-C₃₀-Cycloalkyl, substituiertem oder unsubstituiertem C₅-C₃₀-Cycloalkenyl, substituiertem oder unsubstituiertem C2-C50-Heteroaryl, substituiertem oder unsubstituiertem C₂-C₃₀-Heterocycloalkyl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₆-C₃₀-Arylthioxy, substituiertem oder unsubstituiertem C₁-C₃₀-Alkylamin, substituiertem oder unsubstituiertem C₆-C₃₀-Arylamin, substituiertem oder unsubstituiertem C₁-C₃₀-Alkylsilyl und substituiertem oder unsubstituiertem C₆-C₃₀-Arylsilyl, L₁₃ eine Einfachbindung ist oder ausgewählt ist aus substituiertem oder unsubstituiertem C₆-C₂₀-Arylen und substituiertem oder unsubstituiertem C₂-C₂₀-Heteroarylen, und k eine ganze Zahl von 1 bis 3 ist, mit der Maßgabe, dass, wenn k 2 oder mehr ist, die Verbindungsglieder L₁₃ gleich oder verschieden voneinander sind.

9. Die organische elektrolumineszente Vorrichtung nach Anspruch 8, wobei die Verbindung der Formel D ausgewählt ist aus den Verbindungen der Formeln D1 bis D48:

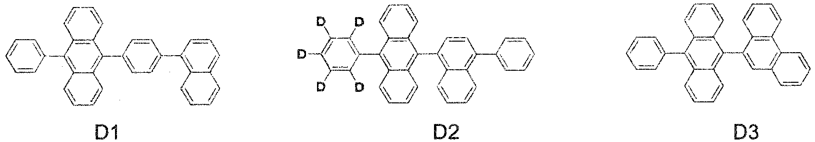

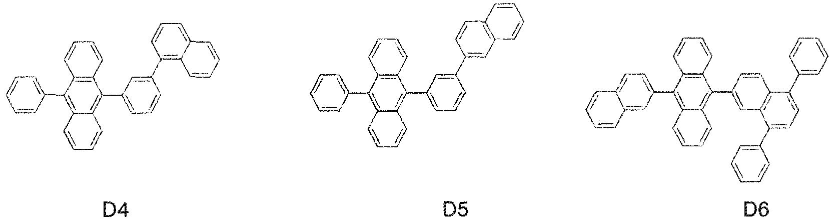

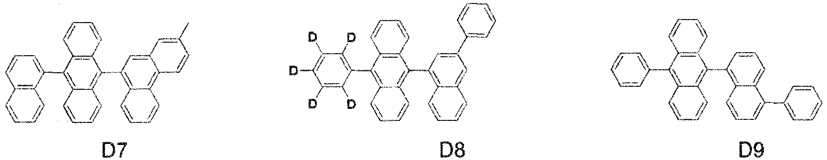

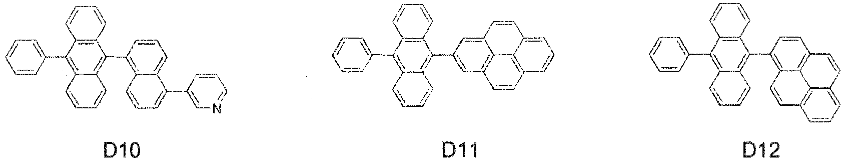

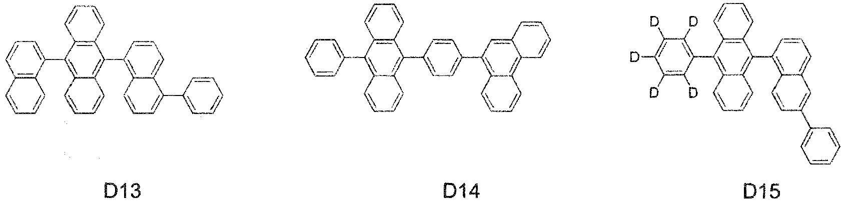

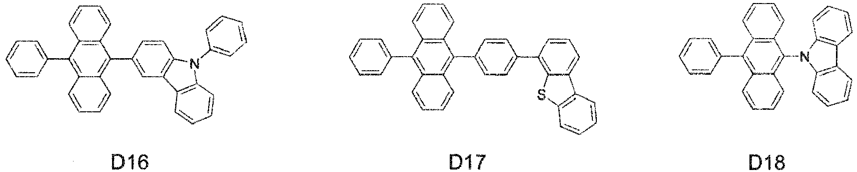

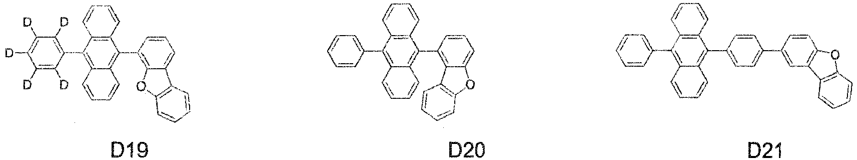

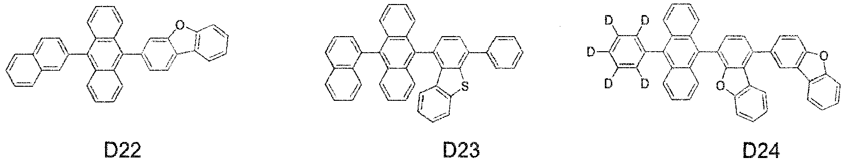

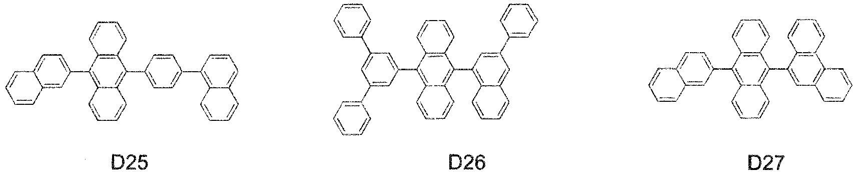

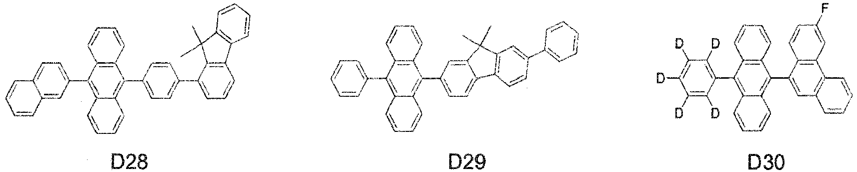

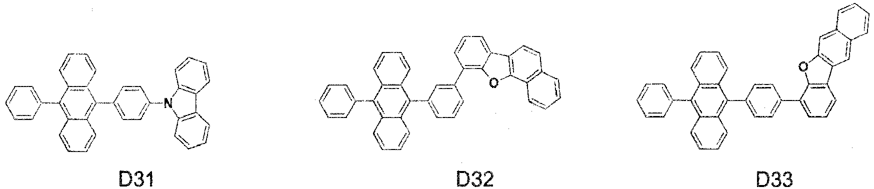

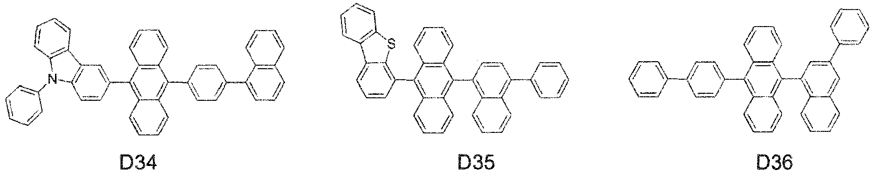

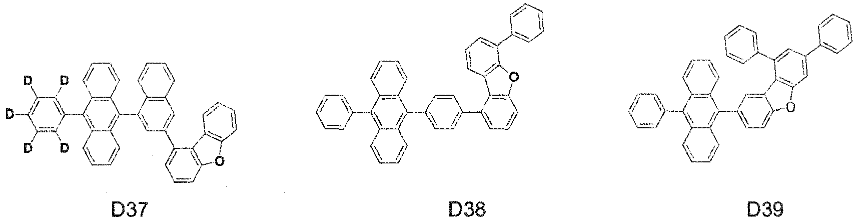

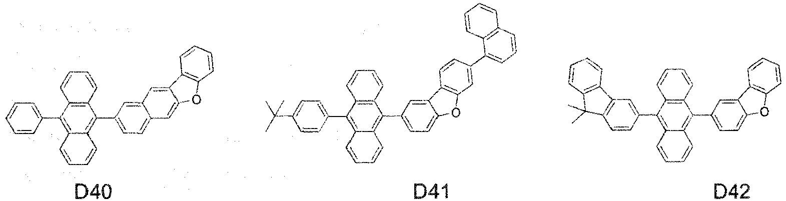

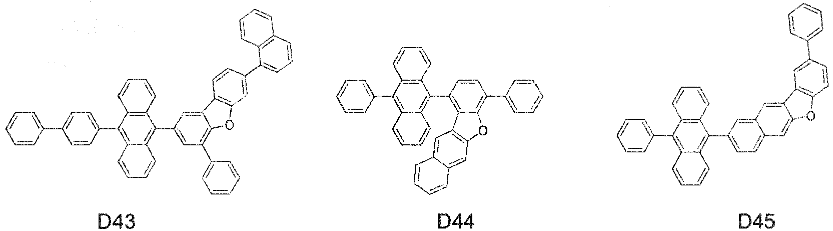

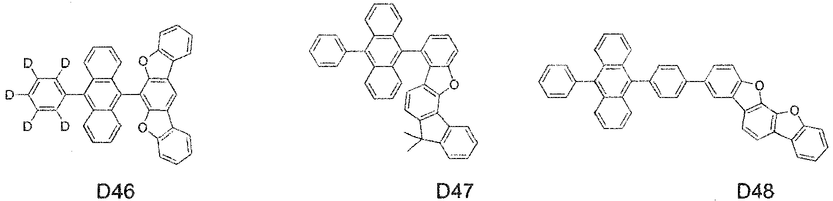

10. Die organische elektrolumineszente Vorrichtung nach Anspruch 1, die ferner eine Öffnungstransportschicht und eine Elektronensperrschicht umfasst, die zwischen der ersten Elektrode und der zweiten Elektrode angeordnet sind, wobei sowohl die Öffnungstransportschicht als auch die Elektronensperrschicht eine Verbindung umfassen, die durch die Formel E: 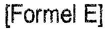 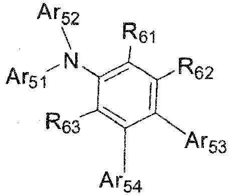 wobei R₆₁ bis R₆₃ identisch oder voneinander verschieden sind und jeweils unabhängig voneinander ausgewählt sind aus Wasserstoff, Deuterium, substituiertem oder unsubstituiertem C₁-C₃₀-Alkyl, substituiertem oder unsubstituiertem C₆-C₅₀-Aryl, substituiertem oder unsubstituiertem C₂-C₃₀-Alkenyl, substituiertem oder unsubstituiertem C₂-C₂₀-Alkinyl, substituiertem oder unsubstituiertem C₃-C₃₀-Cycloalkyl, substituiertem oder unsubstituiertem C₅-C₃₀-Cycloalkenyl, substituiertem oder unsubstituiertem C₂-C₅₀-Heteroaryl, substituiertem oder unsubstituiertem C₂-C₃₀-Heterocycloalkyl, substituiertem oder unsubstituiertem C₁-C₃₀-Alkoxy, substituiertem oder unsubstituiertem C₆-C₃₀-Aryloxy, substituiertem oder unsubstituiertem C₁-C₃₀-Alkylthioxy, substituiertem oder unsubstituiertem C₆-C₃₀-Arylthioxy, substituiertem oder unsubstituiertem C₁-C₃₀-Alkylamin, substituiertem oder unsubstituiertem C₆-C₃₀-Arylamin, substituiertem oder unsubstituiertem C₁-C₃₀-Alkylsilyl, substituiertem oder unsubstituiertem C₆-C₃₀-Arylsilyl, substituiertem oder unsubstituiertem C₁-C₃₀-Alkylgermanium, substituiertem oder unsubstituiertem C₁-C₃₀-Arylgermanium, Cyano, Nitro und Halogen, und Ar₅₁ bis Ar₅₄ gleich oder voneinander verschieden sind und jeweils unabhängig voneinander substituiertes oder unsubstituiertes C₆-C₄₀-Aryl oder substituiertes oder unsubstituiertes C₂-C₃₀-Heteroaryl sind.

11. Die organische elektrolumineszente Vorrichtung nach Anspruch 10, wobei die Verbindung der Formel E ausgewählt ist aus den Verbindungen der Formeln E1 bis E33:

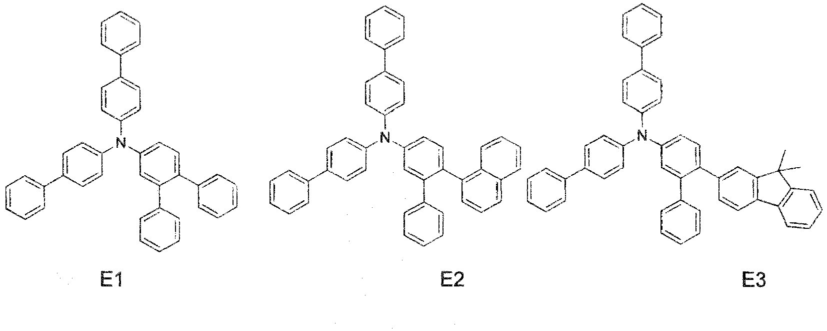

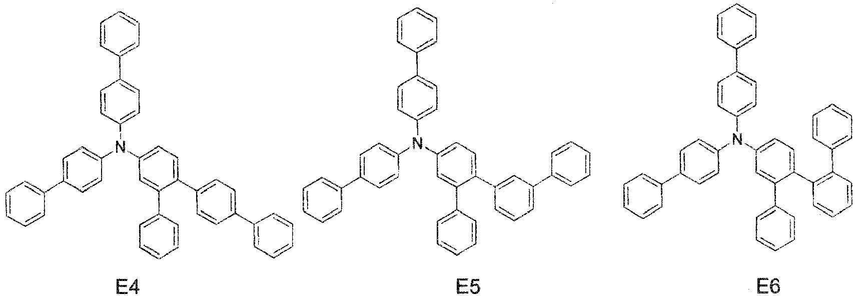

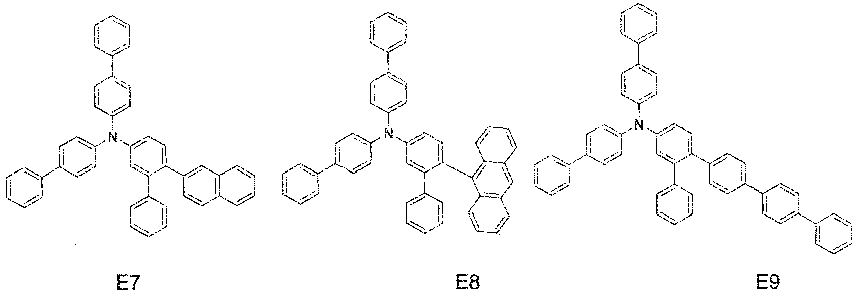

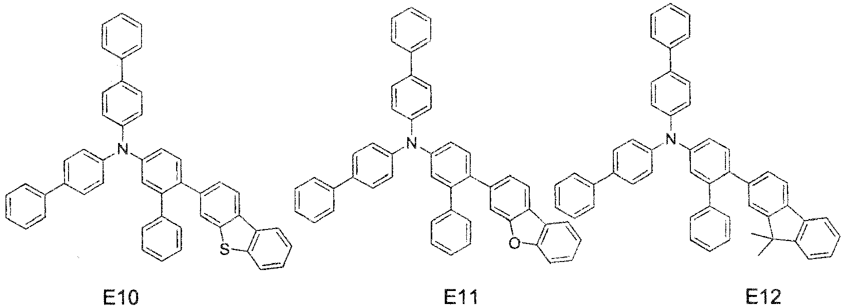

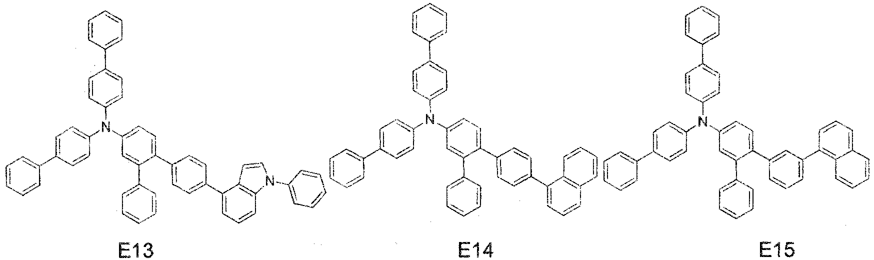

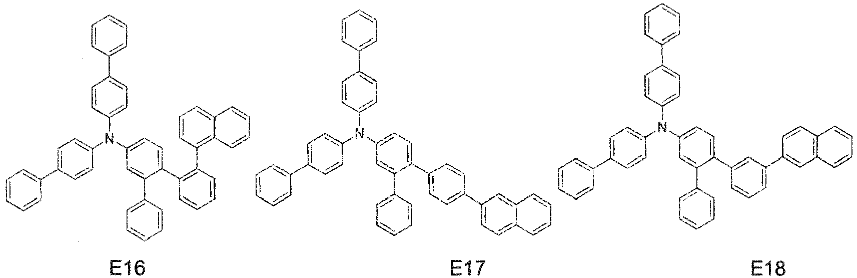

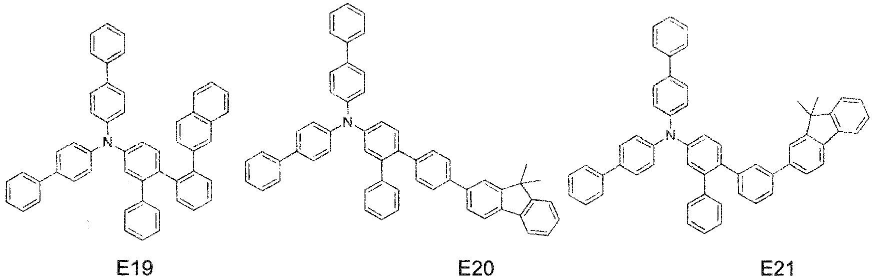

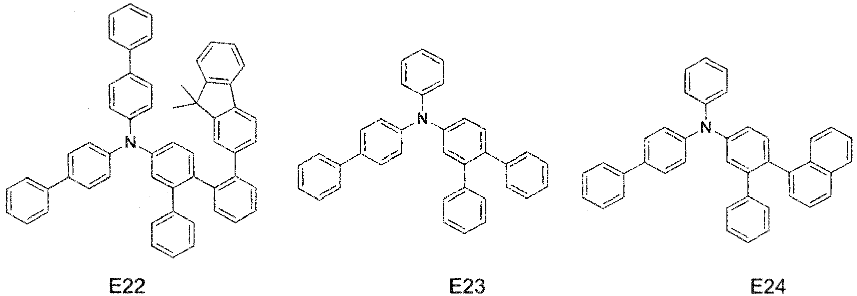

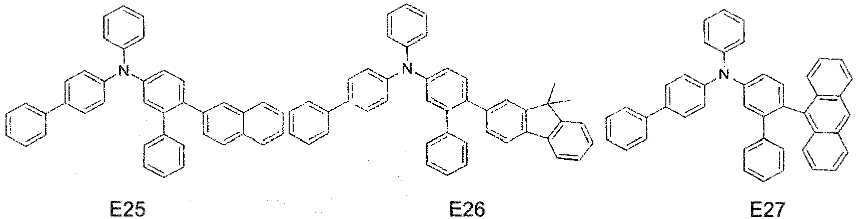

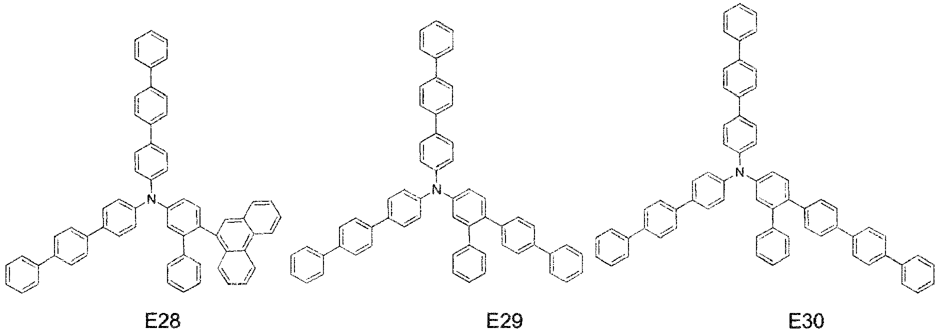

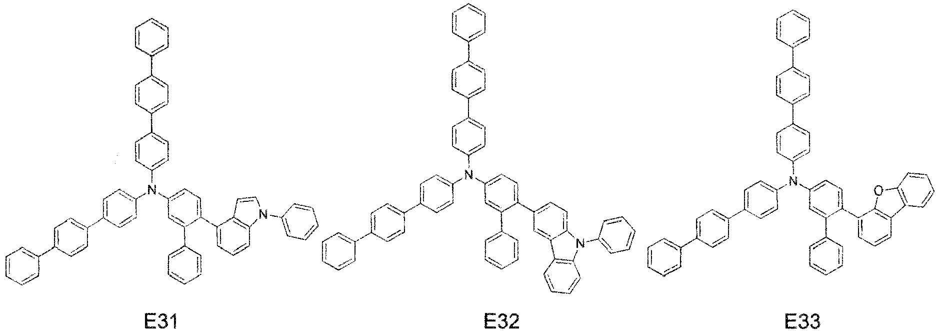

## Revendications

1. Dispositif électroluminescent organique comprenant une première électrode, une deuxième électrode opposée à la première électrode, une couche d'émission de lumière interposée entre les première et deuxième électrodes, et une couche de couverture formée sur au moins une des surfaces des première et deuxième électrodes opposée à la couche d'émission de lumière, ladite couche d'émission de lumière comprenant un quelconque des composés représenté par la formule A-1 ou la formule A-2 et la couche de couverture comprenant un composé représenté par la formule B : 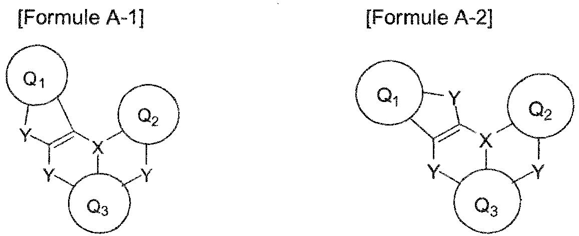 Q₁ à Q₃ étant identiques ou différents l'un de l'autre et étant chacun indépendamment un cycle hydrocarboné aromatique en C₆-C₅₀ substitué ou non substitué ou un cycle hétéroaromatique en C₂-C₅₀ substitué ou non substitué, les lieurs Y étant identiques ou différents l'un de l'autre et étant choisis chacun indépendamment parmi N-R₁, CR₂R₃, O, et S, X étant B, et R₁ à R₃ étant identiques ou différents l'un de l'autre et étant choisis chacun indépendamment parmi hydrogène, deutérium, alkyle en C₁₋C₃₀ substitué ou non substitué, aryle en C₆-C₅₀ substitué ou non substitué, cycloalkyle en C₃-C₃₀ substitué ou non substitué, hétéroaryle en C₂-C₅₀ substitué ou non substitué, alcoxy en C₁₋C₃₀ substitué ou non substitué, aryloxy en C₆-C₃₀ substitué ou non substitué, alkylthioxy en C₁₋C₃₀ substitué ou non substitué, arylthioxy en C₅-C₃₀ substitué ou non substitué, alkylamine en C₁₋C₃₀ substituée ou non substituée, arylamine en C₅-C₃₀ substituée ou non substituée, alkylsilyle en C₁₋C₃₀ substitué ou non substitué, arylsilyle en C₅-C₃₀ substitué ou non substitué, nitro, cyano, et halogène, sous réserve que chacun de R₁ à R₅ est optionnellement lié à Q₁, Q₂ or Q₃ pour former un cycle monocyclique ou polycyclique alicyclique ou aromatique, R₂ et R₃ étant optionnellement liés l'un à l'autre pour former un cycle monocyclique ou polycyclique alicyclique ou aromatique, et 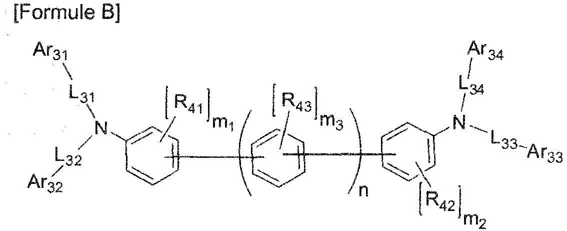 R₄₁ à R₄₃ étant identiques ou différents l'un de l'autre et étant choisis chacun indépendamment parmi hydrogène, deutérium, alkyle en C₁-C₂₀ substitué ou non substitué, aryle en C₆-C₅₀ substitué ou non substitué, arylalkyle en C₇-C₅₀ substitué ou non substitué, cycloalkyl en C₃-C₃₀ substitué ou non substitué, alkylsilyle en C₁₋C₃₀ substitué ou non substitué, arylsilyle en C₆-C₃₀ substitué ou non substitué, et halogène, L₃₁ à L₃₄ étant identiques ou différents l'un de l'autre et étant chacun indépendamment des liaisons simples ou choisis parmi arylène en C₆-C₅₀ substitué ou non substitué et hétéroarylène en C₂-C₅₀ substitué ou non substitué, Ar₃₁ à Ar₃₄ étant identiques ou différents l'un de l'autre et étant choisis chacun indépendamment parmi aryle en C₆-C₅₀ substitué ou non substitué et hétéroaryle en C₂-C₅₀ substitué ou non substitué, n étant un nombre entier compris entre 0 et 4, pourvu que lorsque n est égal ou supérieur à 2, les cycles aromatiques comprenant R₄₃ sont identiques ou différents l'un de l'autre, m₁ à m₃ sont des nombres entiers compris entre 0 et 4, pourvu que lorsque m₁ et m₃ sont égaux ou supérieurs à 2, les groupes R₄₁, R₄₂, et R₄₃ sont identiques ou différents l'un de l'autre, et des atomes d'hydrogène ou de deutérium sont liés aux atomes de carbone des cycles aromatiques auxquels R₄₁ à R₄₃ ne sont pas attachés.

2. Dispositif électroluminescent organique selon la revendication 1, dans lequel le composé de la formule A-1 ou A-2 est représenté par la formule A-3 ou la formule A-4 : 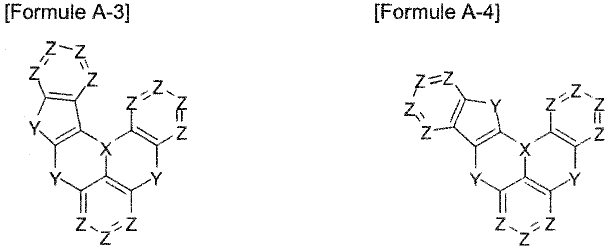 chaque Z étant indépendamment CR ou N, les substituants R étant identiques ou différents l'un de l'autre et étant choisis indépendamment parmi hydrogène, deutérium, alkyle en C₁₋C₃₀ substitué ou non substitué, aryle en C₆-C₅₀ substitué ou non substitué, cycloalkyle en C₃-C₃₀ substitué ou non substitué, hétéroaryle en C₂-C₅₀ substitué ou non substitué, alcoxy en C₁₋C₃₀ substitué ou non substitué, aryloxy en C₆-C₃₀ substitué ou non substitué, alkylthioxy en C₁₋C₃₀ substitué ou non substitué, arylthioxy en C₅-C₃₀ substitué ou non substitué, alkylamine en C₁₋C₃₀ substituée ou non substituée, arylamine en C₅-C₃₀ substituée ou non substituée, alkylsilyle en C₁₋C₃₀ substitué ou non substitué, arylsilyle en C₅-C₃₀ substitué ou non substitué, nitro, cyano, et halogène, sous réserve que les substituants R sont optionnellement liés l'un à l'autre ou sont optionnellement liés à autre substituants adjacents pour former des cycle monocycliques ou polycycliques alicycliques ou aromatiques dont les atomes de carbone sont optionnellement substitués par un ou plusieurs hétéroatomes choisis parmi les atomes de N, S, et O, et X et Y sont tels que définis dans les formules A-1 et A-2.

3. Dispositif électroluminescent organique selon la revendication 1, dans lequel le composé de la formule A-1 ou A-2 est représenté par la formule A-5 ou la formule A-6 : 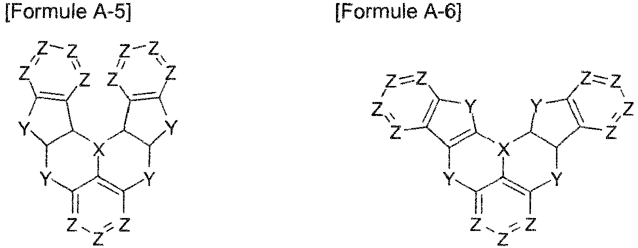 chaque Z étant indépendamment CR ou N, les substituants R étant identiques ou différents l'un de l'autre et étant choisis chacun indépendamment parmi hydrogène, deutérium, alkyle en C₁₋C₃₀ substitué ou non substitué, aryle en C₆-C₅₀ substitué ou non substitué, cycloalkyle en C₃-C₃₀ substitué ou non substitué, hétéroaryle en C₂-C₅₀ substitué ou non substitué, alcoxy en C₁₋C₃₀ substitué ou non substitué, aryloxy en C₆-C₃₀ substitué ou non substitué, alkylthioxy en C₁₋C₃₀ substitué ou non substitué, arylthioxy en C₅-C₃₀ substitué ou non substitué, alkylamine en C₁₋C₃₀ substituée ou non substituée, arylamine en C₅-C₃₀ substituée ou non substituée, alkylsilyle en C₁₋C₃₀ substitué ou non substitué, arylsilyle en C₅-C₃₀ substitué ou non substitué, nitro, cyano, et halogène, sous réserve que les substituants R sont optionnellement liés l'un à l'autre ou sont optionnellement liés à autre substituants adjacents pour former des cycle monocycliques ou polycycliques alicycliques ou aromatiques dont les atomes de carbone sont optionnellement substitués par un ou plusieurs hétéroatomes choisis parmi les atomes de N, S, et O, et X et Y sont tels que définis dans les formules A-1 et A-2.

4. Dispositif électroluminescent organique selon la revendication 1, dans lequel au moins un de Ar₃₁ à Ar₃₄ dans la formule B est représenté par la formule C : 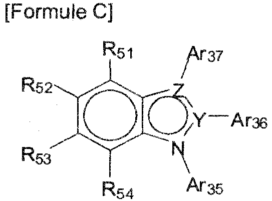 R₅₁ à R₅₄ étant identiques ou différents l'un de l'autre et étant choisis chacun indépendamment parmi hydrogène, deutérium, alkyle en C₁₋C₃₀ substitué ou non substitué, aryle en C₆-C₅₀ substitué ou non substitué, alcényle en C₂-C₃₀ substitué ou non substitué, alcynyle en C₂-C₂₀ substitué ou non substitué, cycloalkyle en C₃-C₃₀ substitué ou non substitué, cycloalcényle en C₅-C₃₀ substitué ou non substitué, hétéroaryle en C₂-C₅₀ substitué ou non substitué, hétérocycloalkyle en C₂-C₃₀ substitué ou non substitué, alcoxy en C₁₋C₃₀ substitué ou non substitué, aryloxy en C₆-C₃₀ substitué ou non substitué, alkylthioxy en C₁₋C₃₀ substitué ou non substitué, arylthioxy en C₅-C₃₀ substitué ou non substitué, alkylamine en C₁₋C₃₀ substituée ou non substituée, arylamine en C₅-C₃₀ substituée ou non substituée, alkylsilyle en C₁₋C₃₀ substitué ou non substitué, arylsilyle en C₅-C₃₀ substitué ou non substitué, nitro, cyano, et halogène, qui sont optionnellement liés l'un à l'autre pour former un cycle, Y étant un atome de carbone ou d'azote, Z étant un atome de carbone, d'oxygène, de soufre ou d'azote, Ar₃₅ à Ar₃₇ étant identiques ou différents l'un de l'autre et étant choisis chacun indépendamment parmi aryle en C₅-C₅₀ substitué ou non substitué et hétéroaryle en C₃-C₅₀ substitué ou non substitué, pourvu que lorsque Z est un atome d'oxygène ou de soufre, Ar₃₇ est rien, pourvu que lorsque Y et Z sont des atomes d'azote, seulement un des Ar₃₅, Ar₃₆, et Ar₃₇ est présent, pourvu que lorsque Y est un atome d'azote et Z est un atome de carbone, Ar₃₆ est rien, sous réserve qu'un des R₅₁ à R₅₄ et des Ar₃₅ à Ar₃₇ est une liaison simple liée à un des lieurs L₃₁ à L₃₄ dans la formule B.

5. Dispositif électroluminescent organique selon la revendication 1, dans lequel le composé de la formule A-1 ou A-2 est choisi parmi les composés :

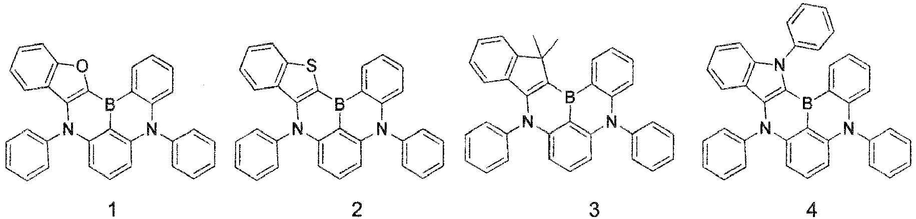

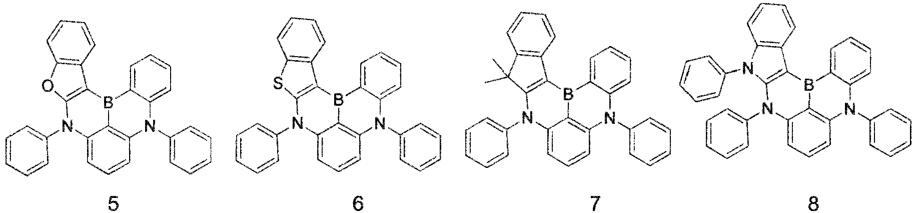

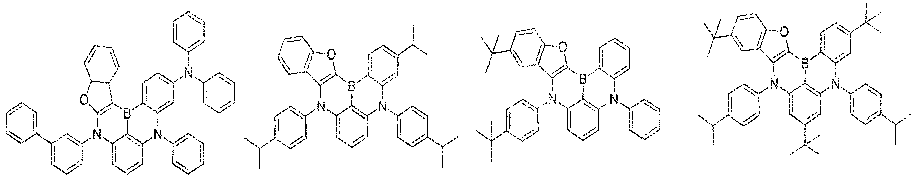

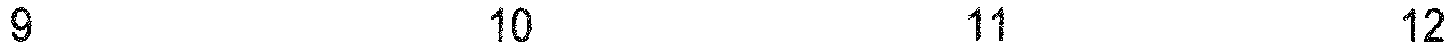

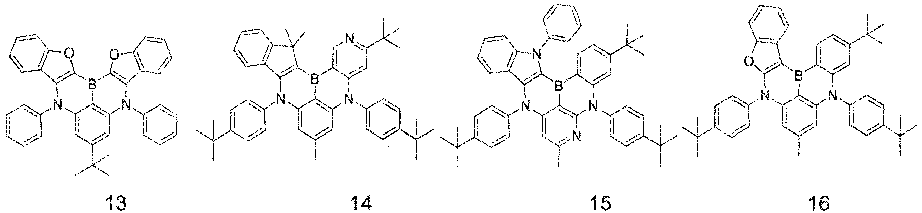

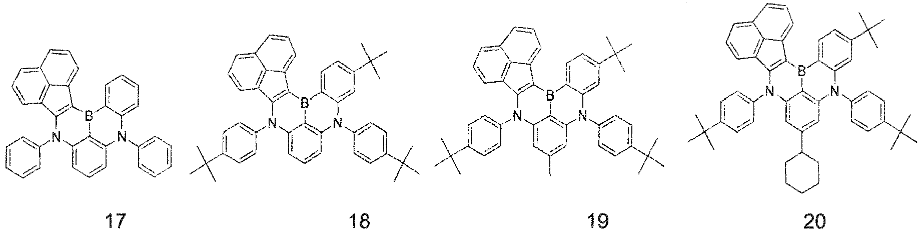

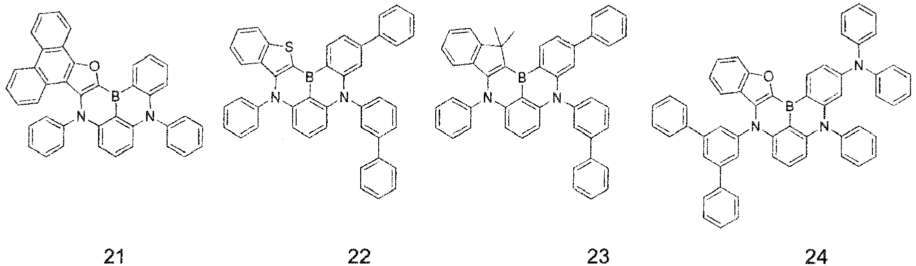

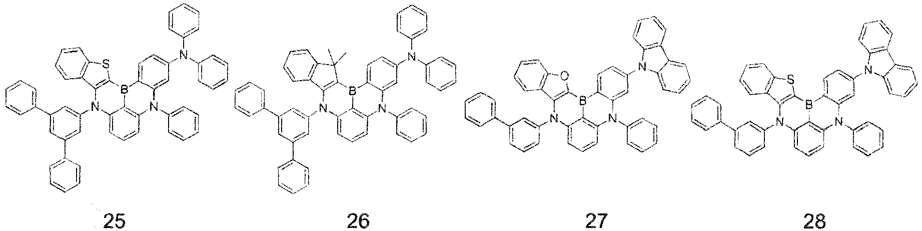

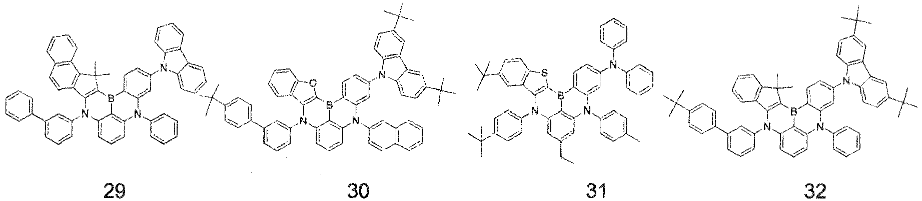

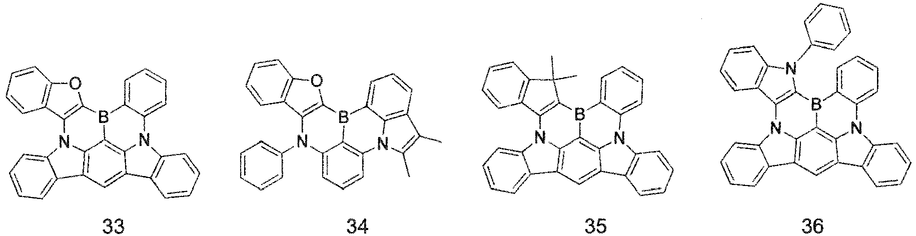

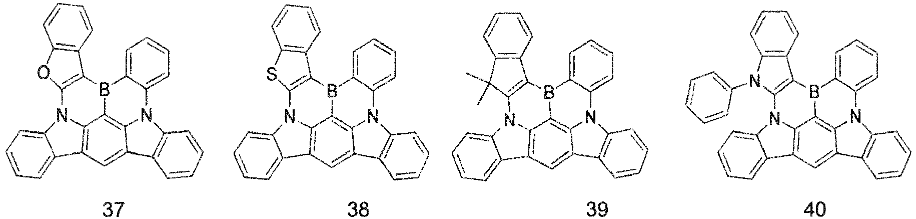

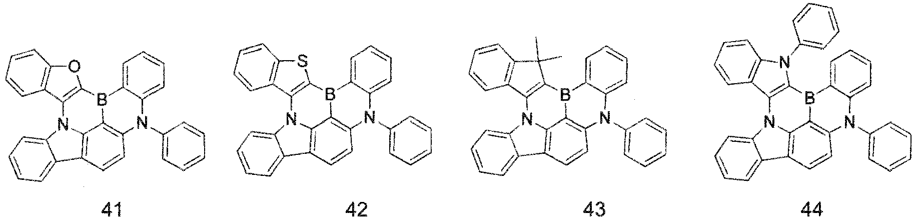

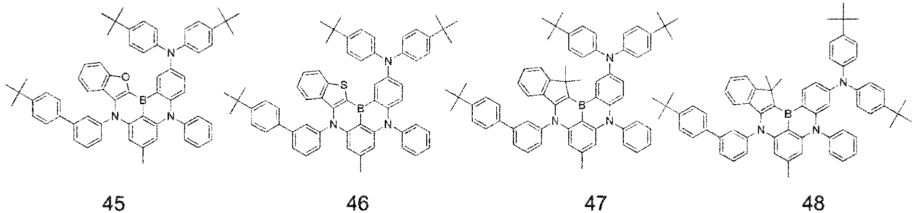

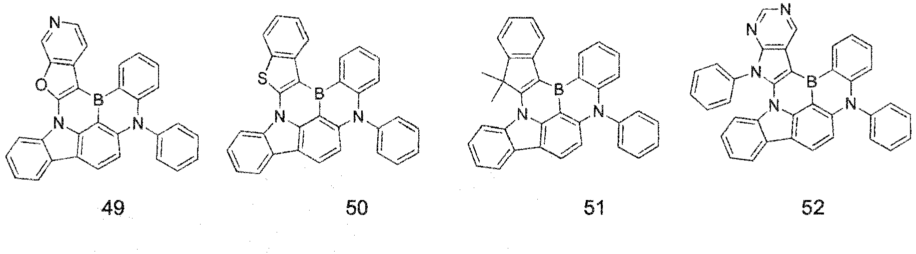

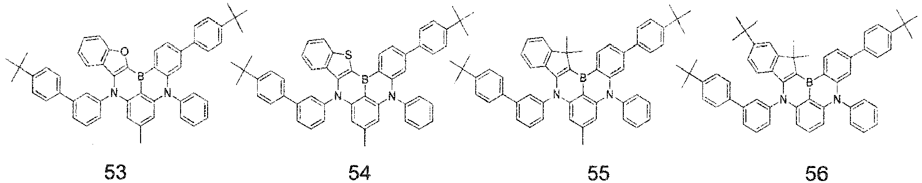

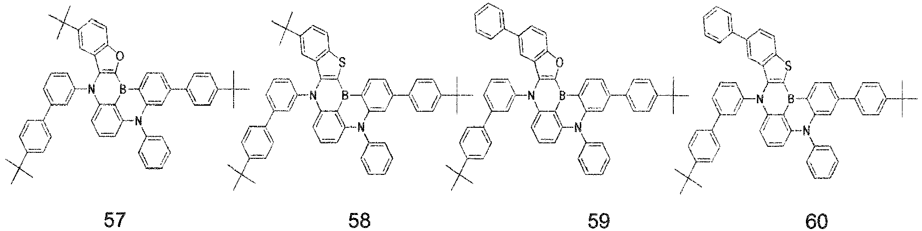

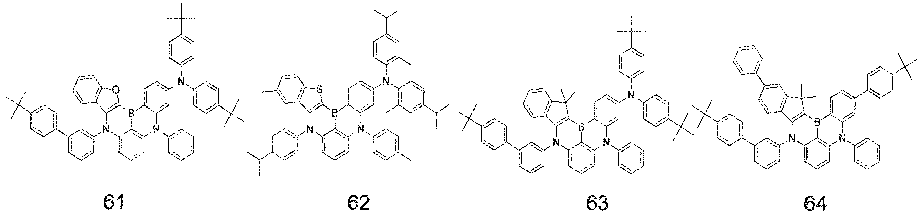

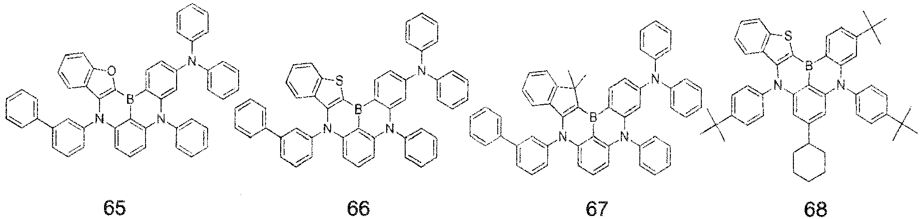

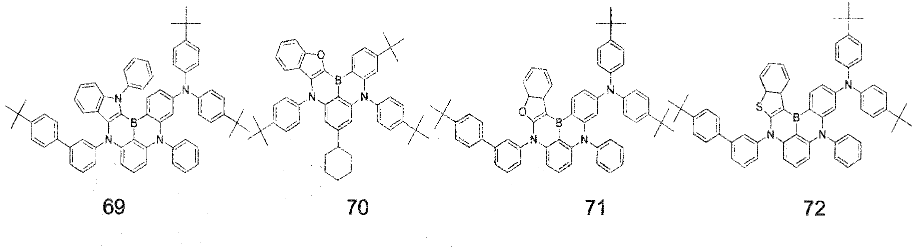

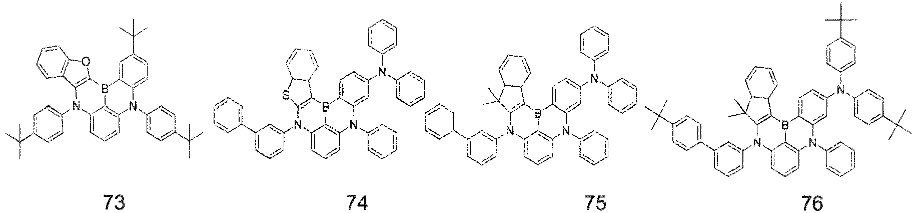

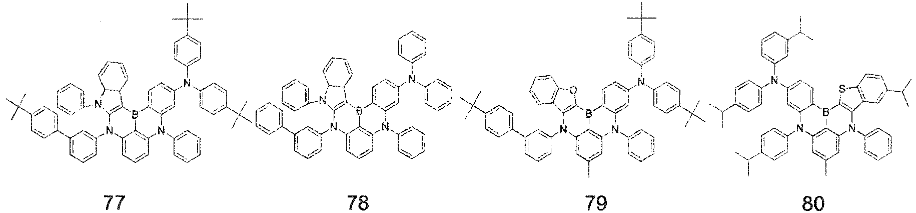

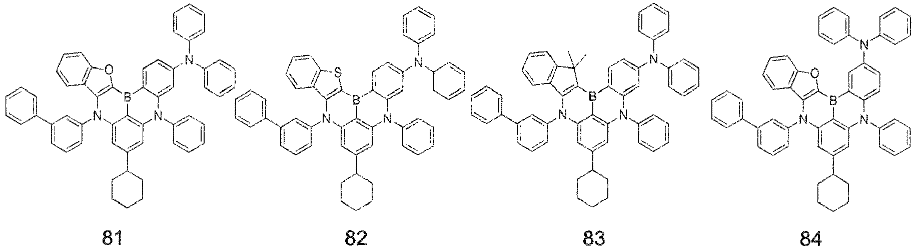

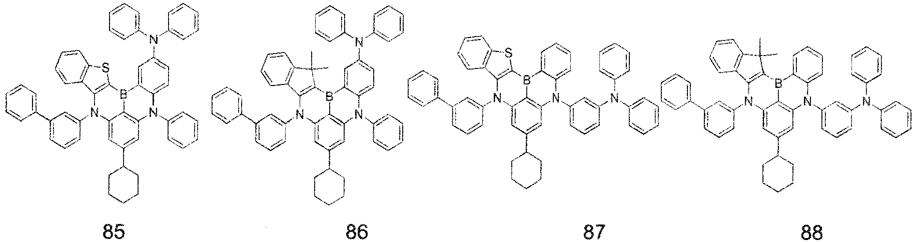

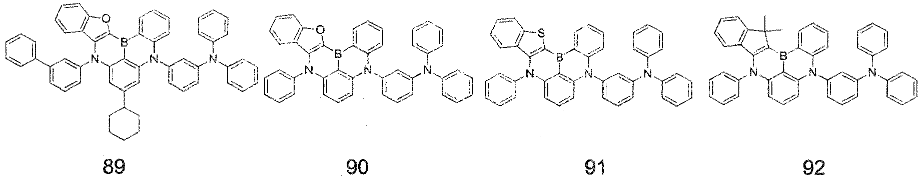

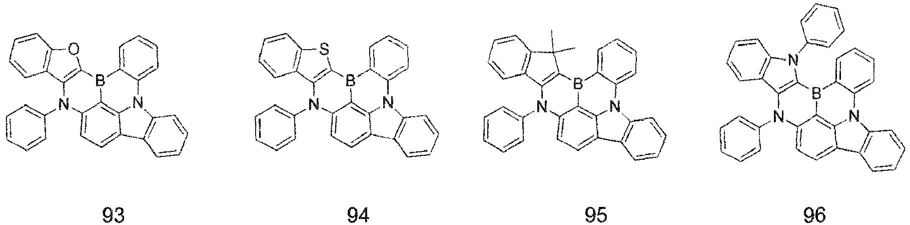

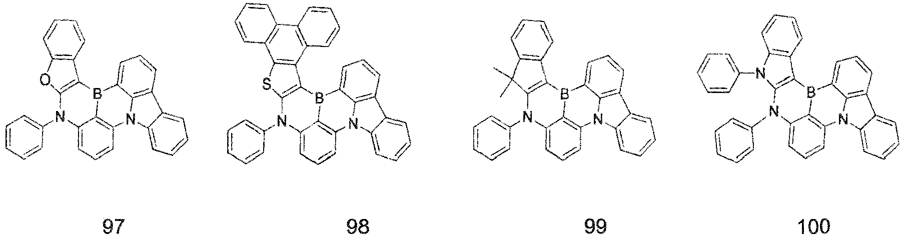

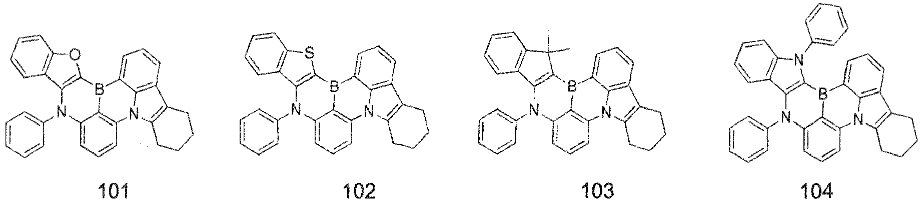

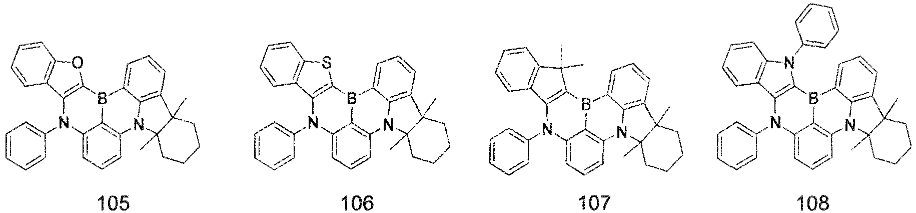

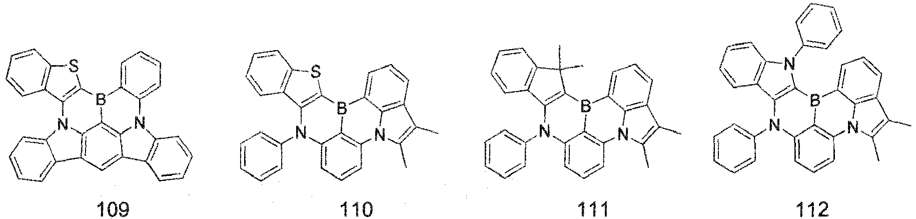

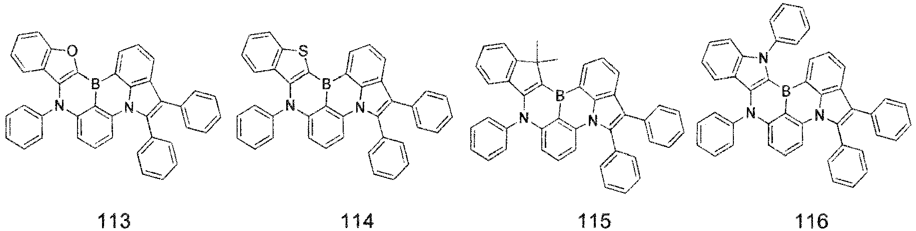

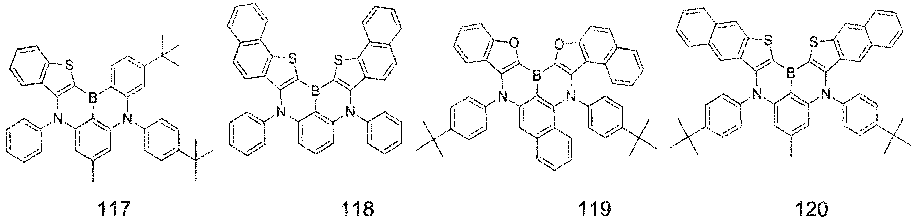

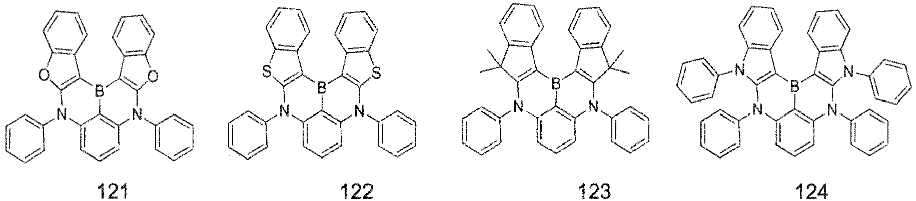

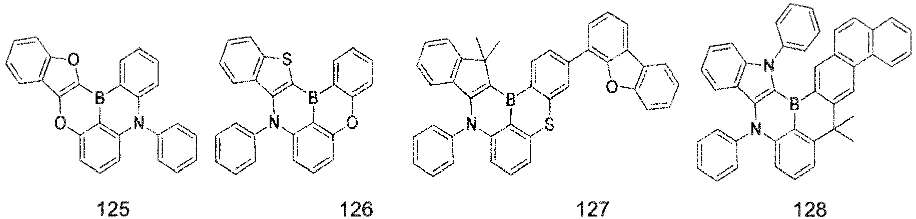

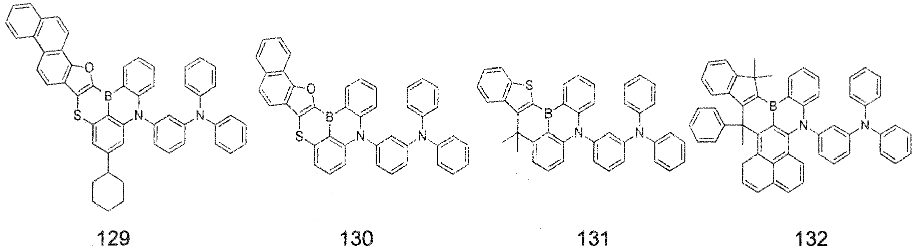

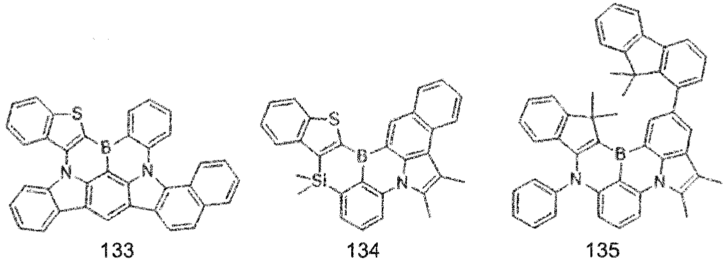

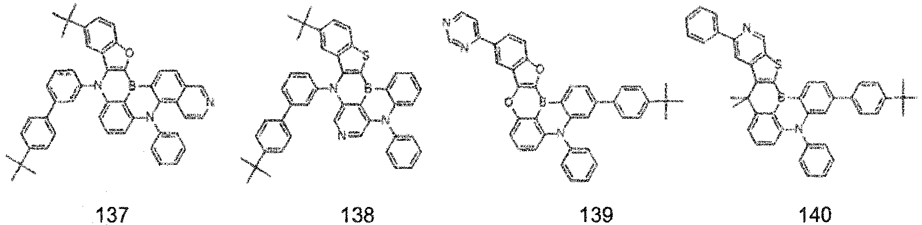

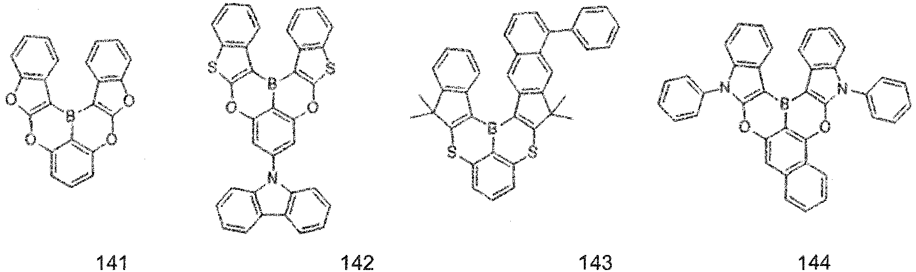

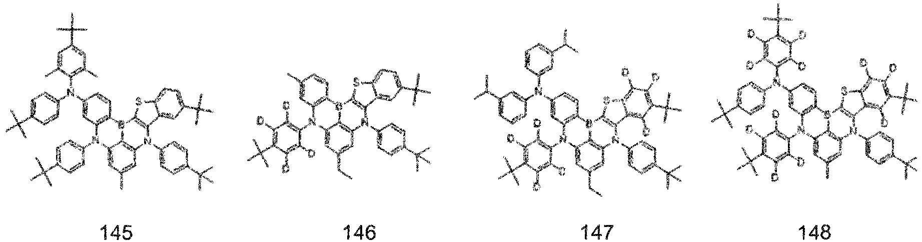

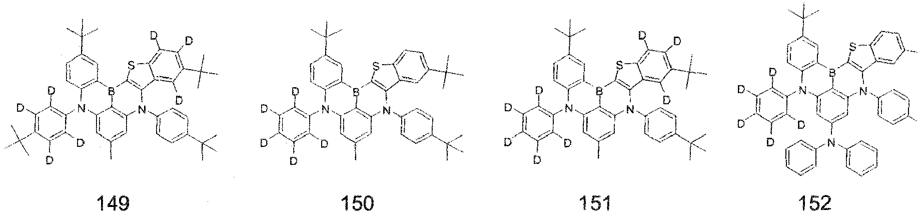

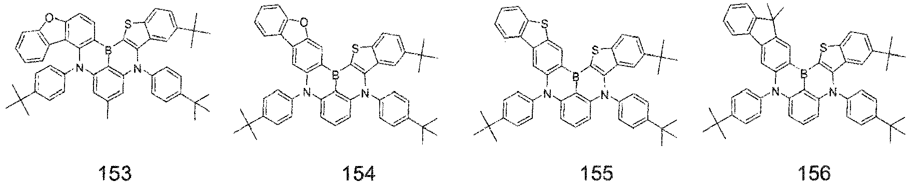

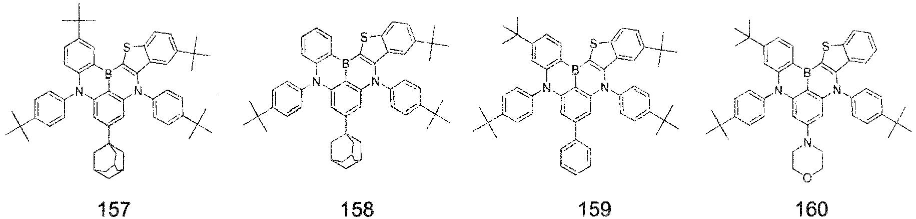

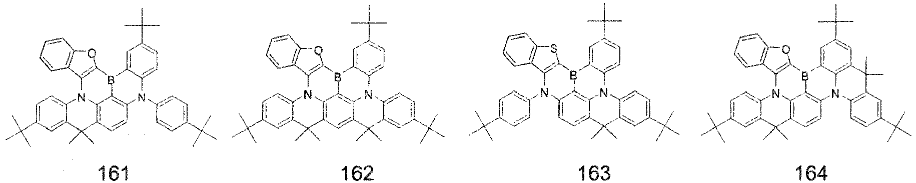

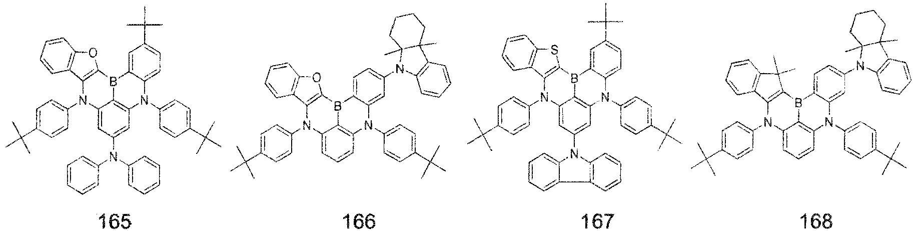

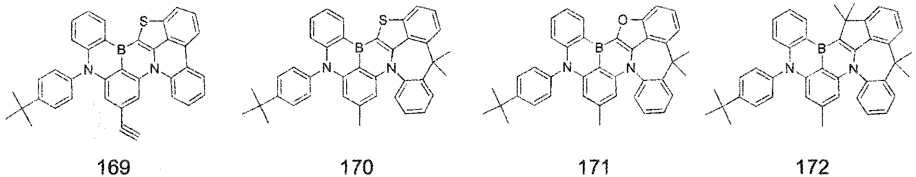

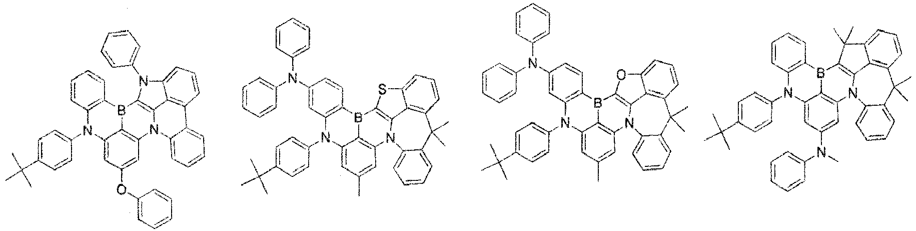

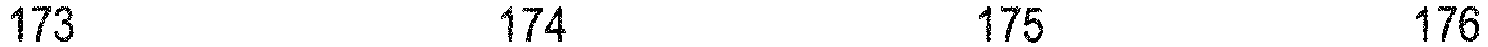

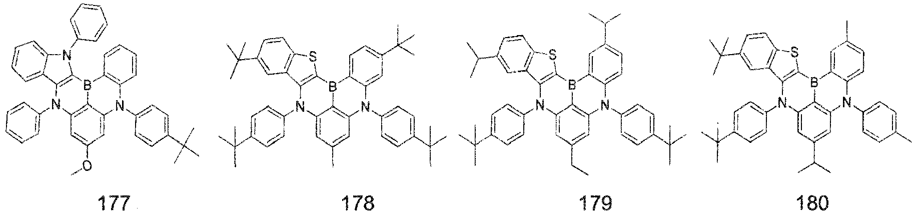

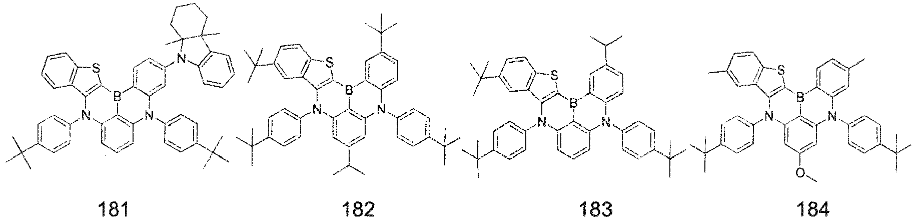

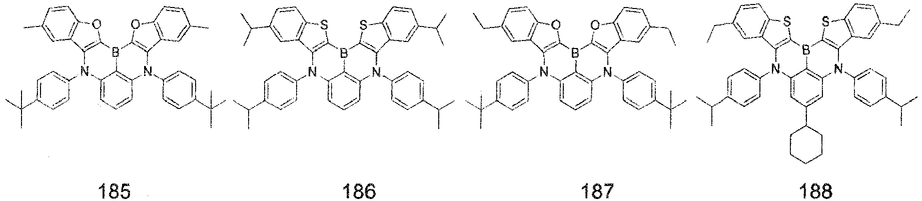

6. Dispositif électroluminescent organique selon la revendication 1, dans lequel le composé de la formule B est choisi parmi les composés suivants des formules B1 à B79 :

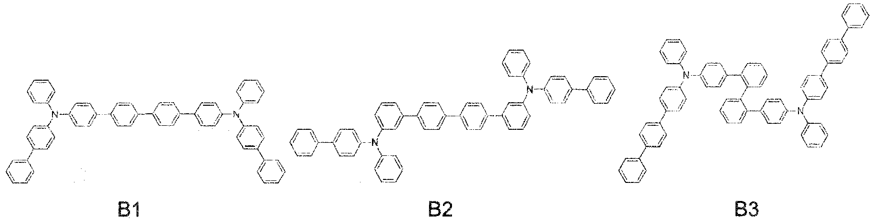

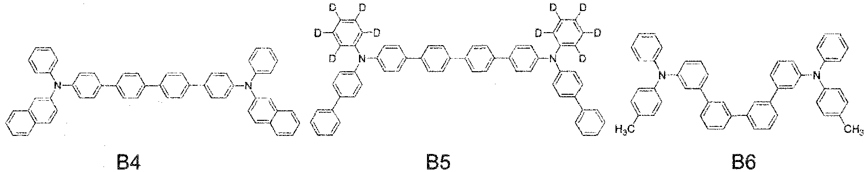

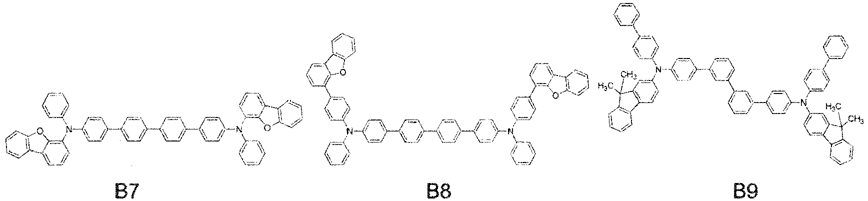

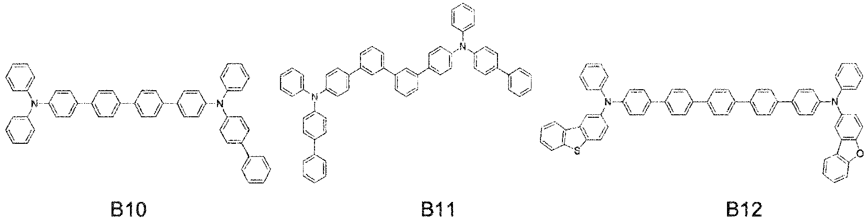

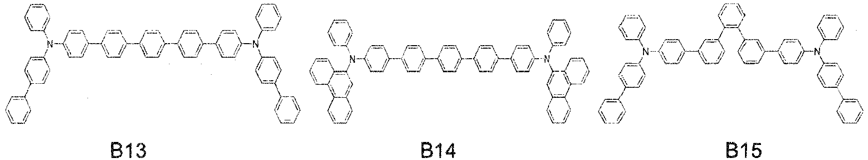

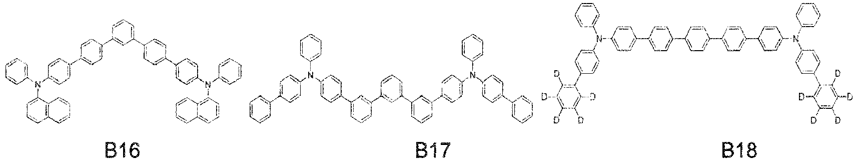

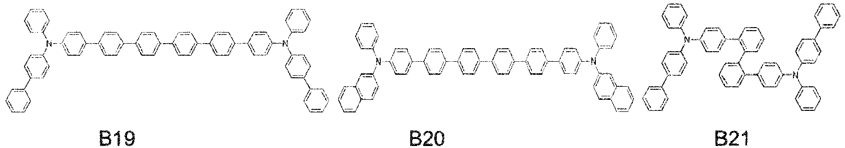

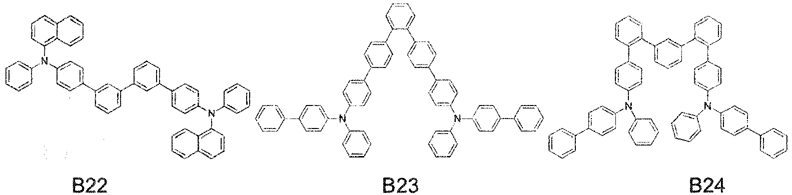

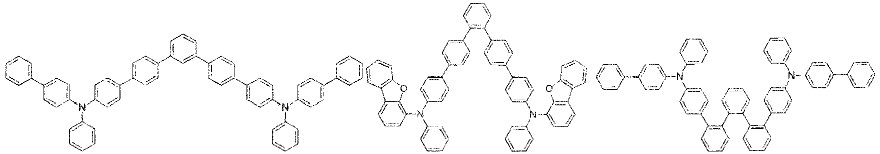

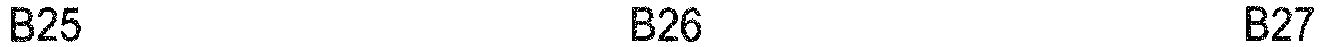

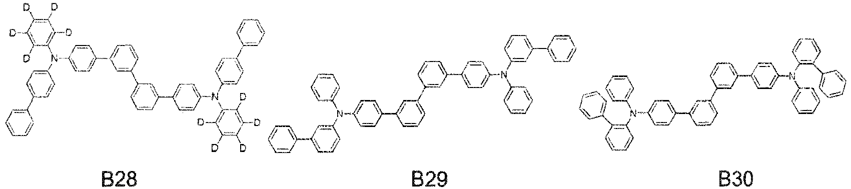

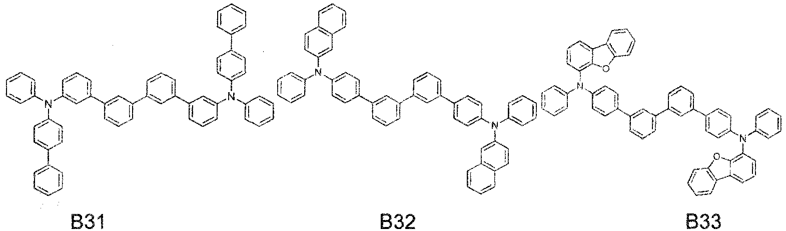

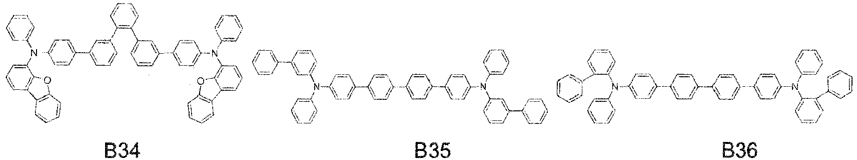

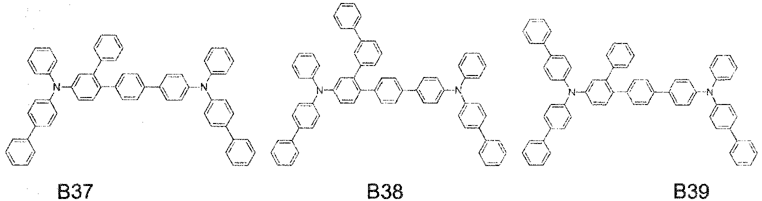

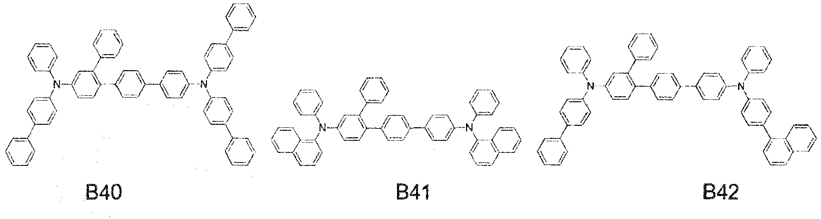

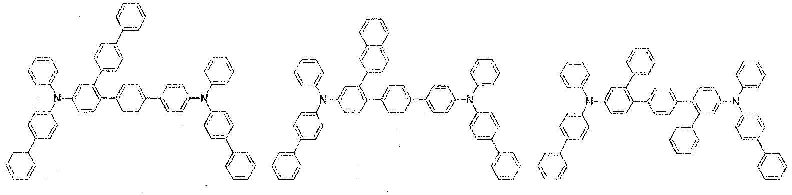

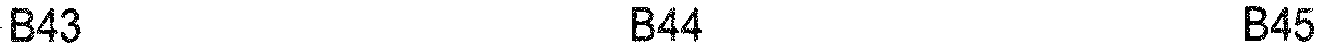

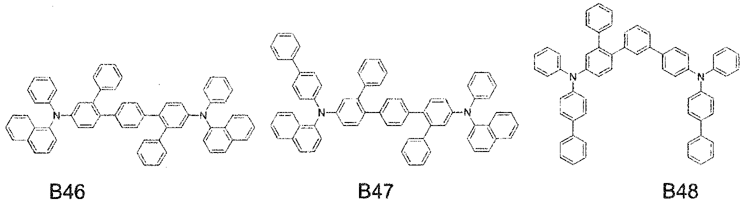

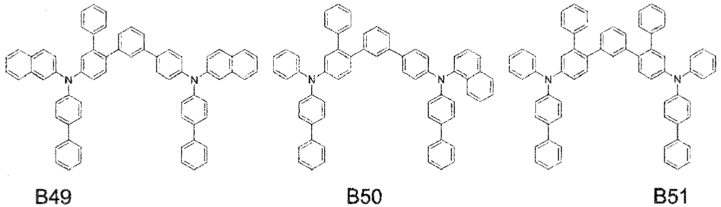

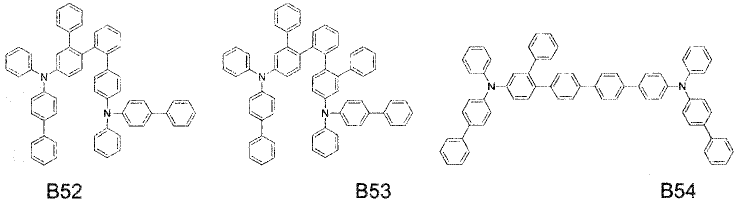

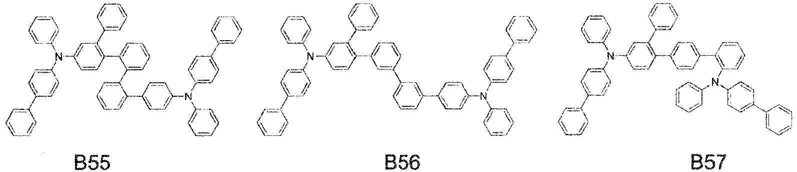

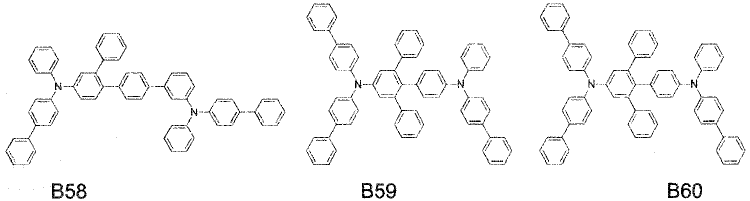

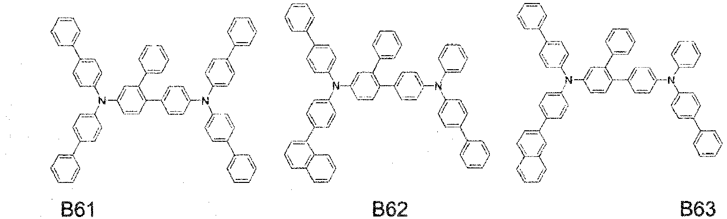

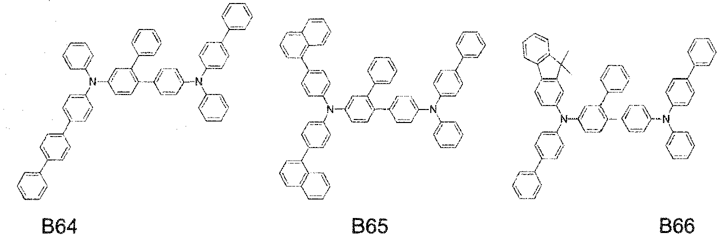

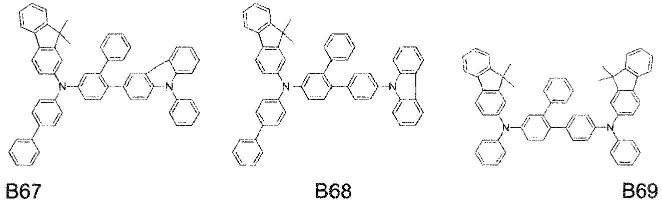

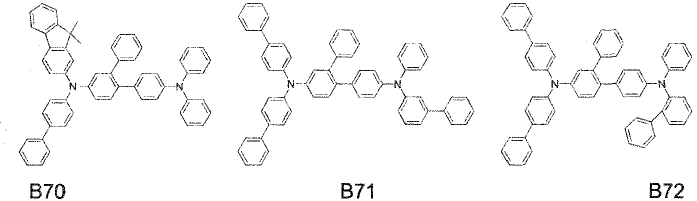

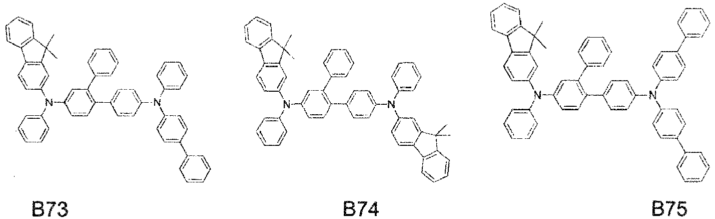

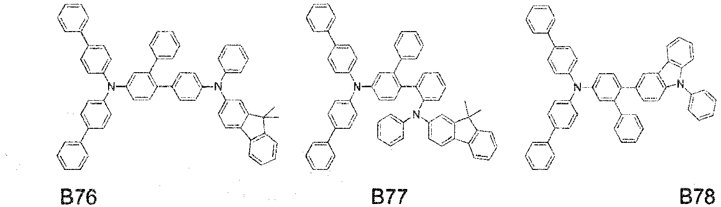

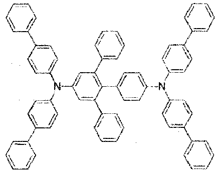

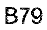

7. Dispositif électroluminescent organique selon la revendication 1, dans lequel le composé de la formule B est choisi parmi les composés suivants des formules B101 à B145 :

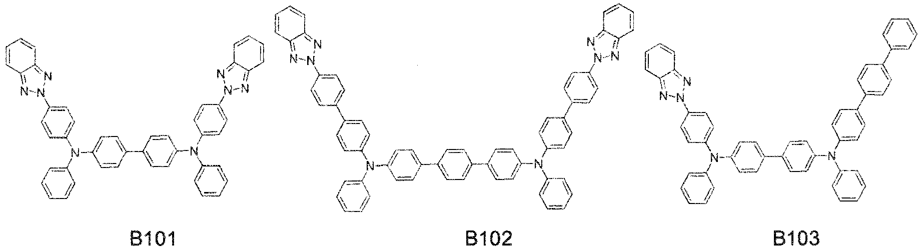

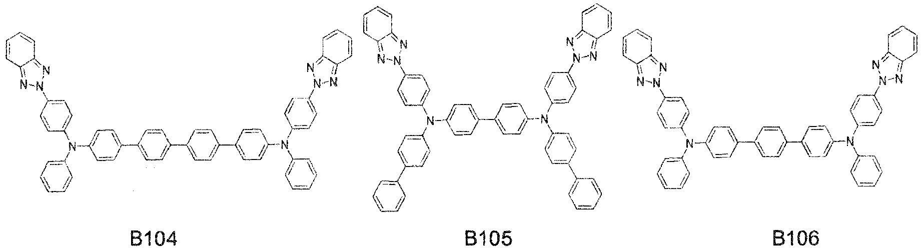

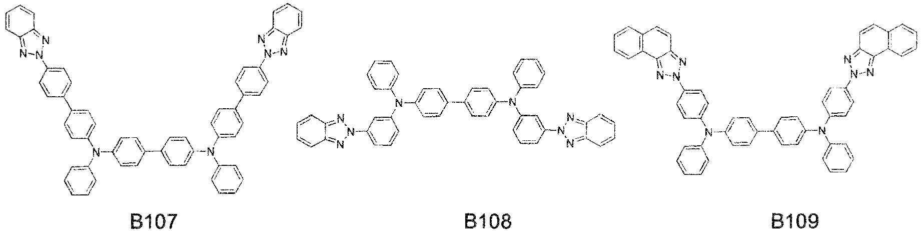

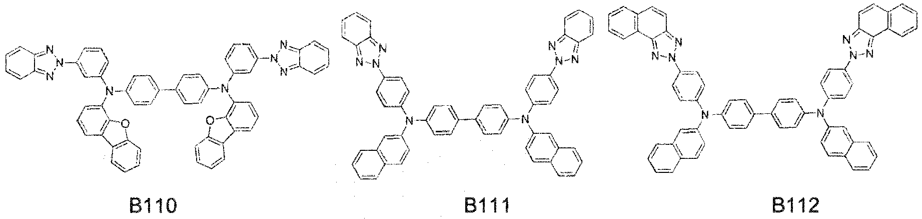

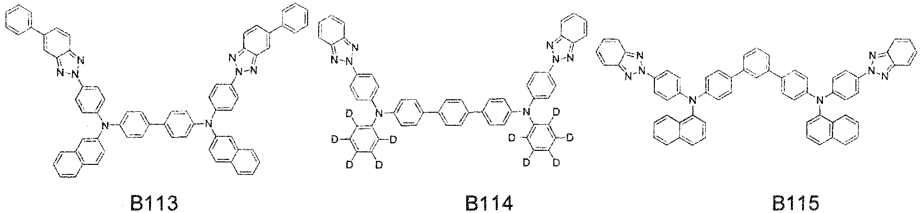

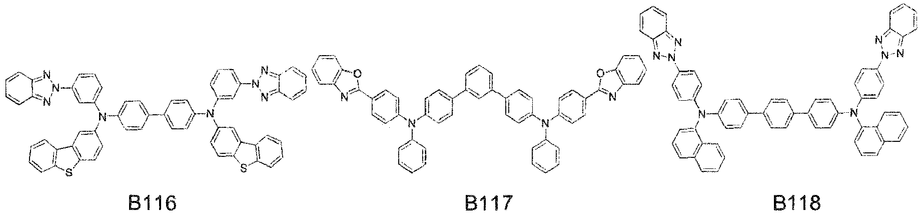

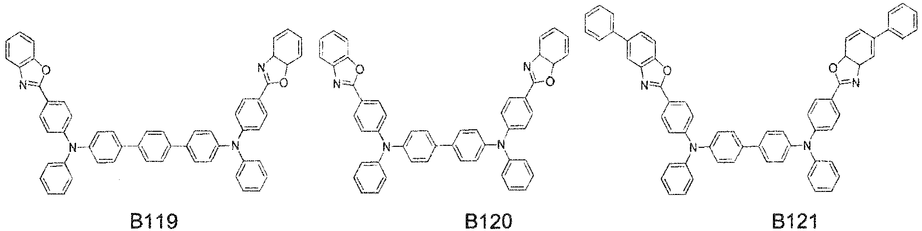

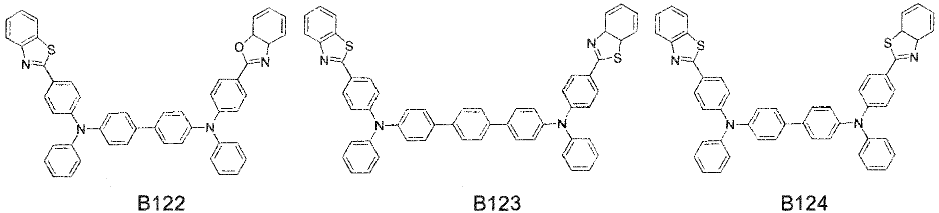

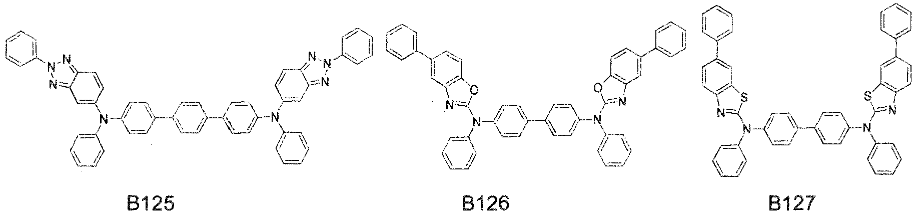

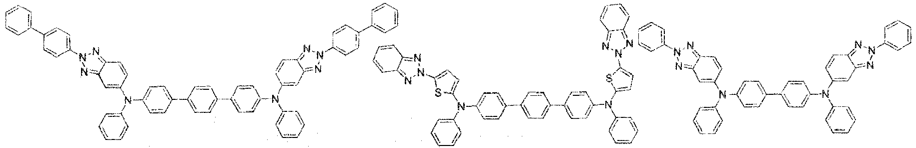

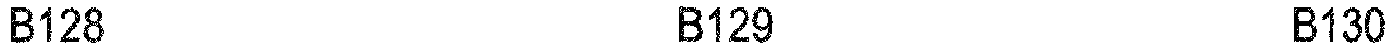

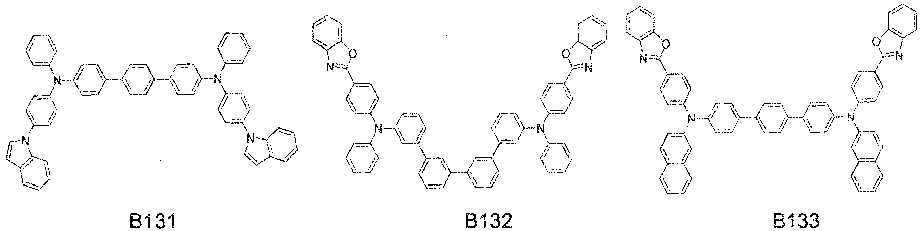

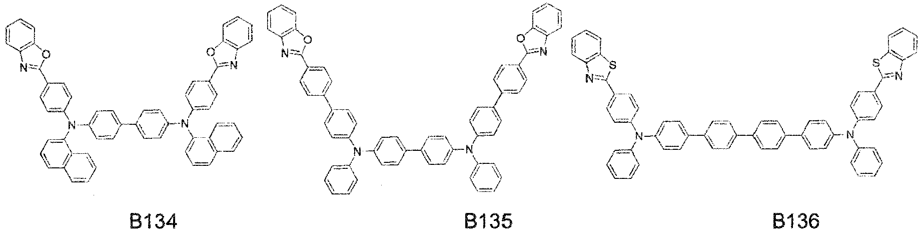

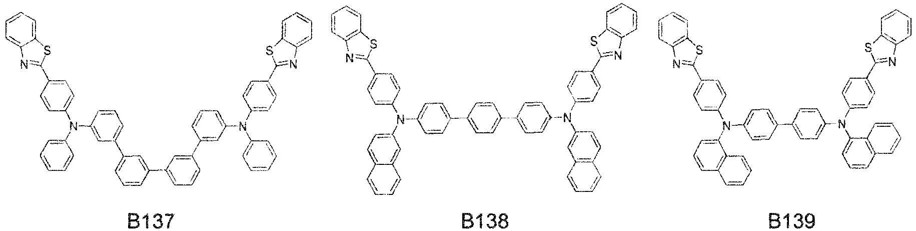

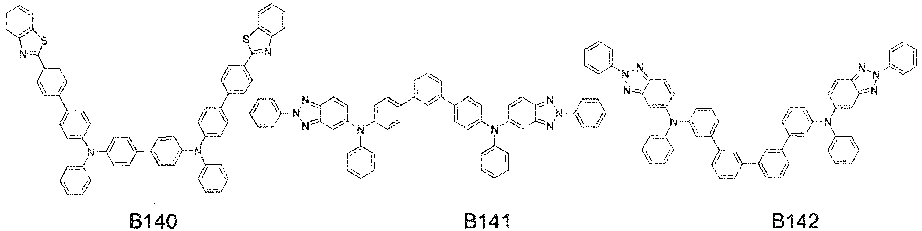

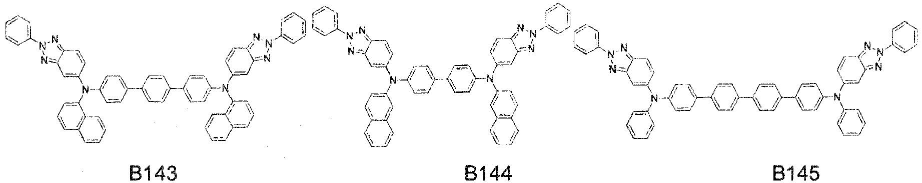

8. Dispositif électroluminescent organique selon la revendication 1, dans lequel ladite couche d'émission de lumière comprend, en tant que composé hôte, un dérivé d'anthracène représenté par la formule D : 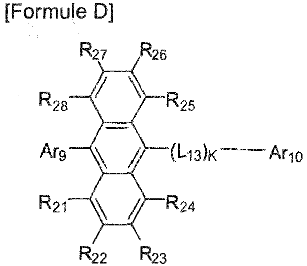 R₂₁ à R₂₈ étant identiques ou différents l'un de l'autre et étant tel que définis pour R₁ à R₃ dans la formule A-1 ou A-2, Ar₉ et Ar₁₀ étant identiques ou différents l'un de l'autre et étant choisis chacun indépendamment parmi hydrogène, deutérium, alkyle en C₁₋C₃₀ substitué ou non substitué, aryle en C₆-C₅₀ substitué ou non substitué, alcényle en C₂-C₃₀ substitué ou non substitué, alcynyle en C₂-C₂₀ substitué ou non substitué, cycloalkyle en C₃-C₃₀ substitué ou non substitué, cycloalcényle en C₅-C₃₀ substitué ou non substitué, hétéroaryle en C₂-C₅₀ substitué ou non substitué, hétérocycloalkyle en C₂-C₃₀ substitué ou non substitué, alcoxy en C₁₋C₃₀ substitué ou non substitué, aryloxy en C₆-C₃₀ substitué ou non substitué, alkylthioxy en C₁₋C₃₀ substitué ou non substitué, arylthioxy en C₆-C₃₀ substitué ou non substitué, alkylamine en C₁₋C₃₀ substituée ou non substituée, arylamine en C₆-C₃₀ substituée ou non substituée, alkylsilyle en C₁₋C₃₀ substitué ou non substitué, et arylsilyle en C₆-C₃₀ substitué ou non substitué, L₁₃ étant une liaison simple ou étant choisi parmi arylène en C₆-C₂₀ substitué ou non substitué et hétéroarylène en C₂-C₂₀ substitué ou non substitué, et k étant un entier compris entre 1 et 3, pourvu que lorsque k est égal ou supérieur à 2, les lieurs L₁₃ sont identiques ou différents l'un de l'autre.

9. Dispositif électroluminescent organique selon la revendication 8, dans lequel le composé de la formule D est choisi parmi les composés des formules D1 à D48 :

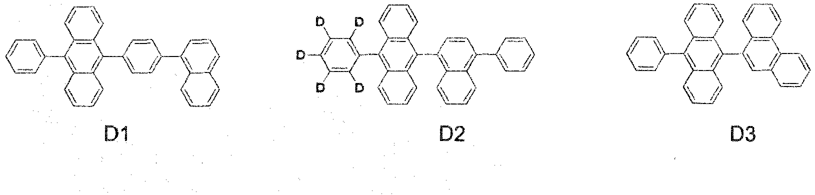

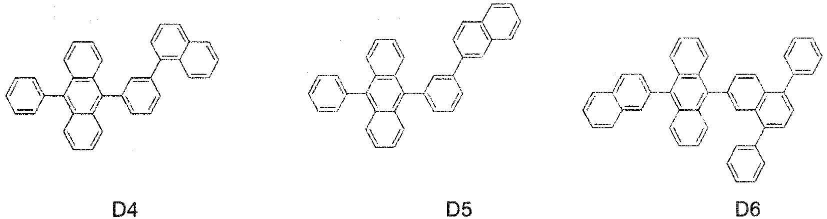

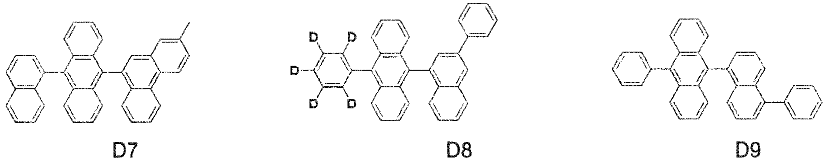

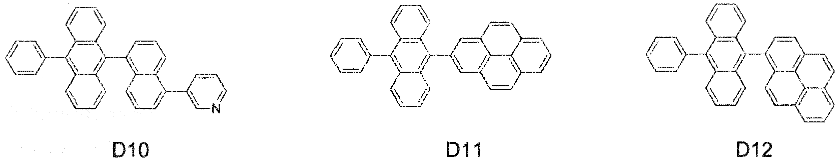

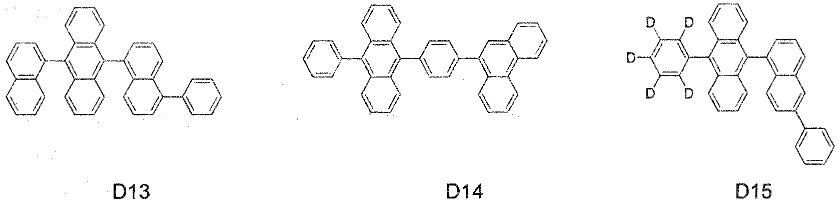

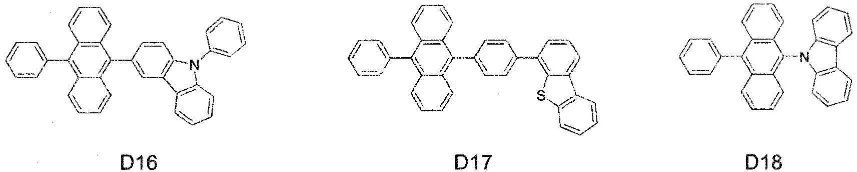

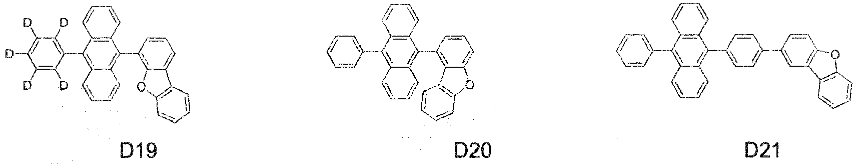

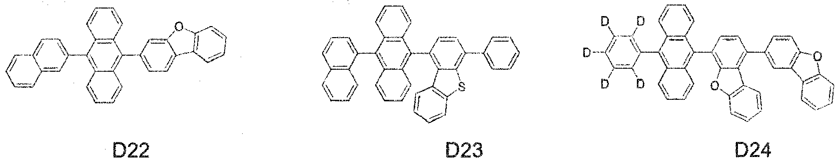

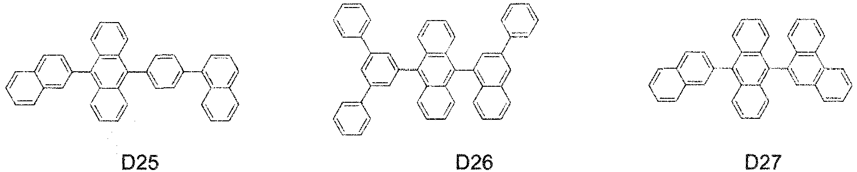

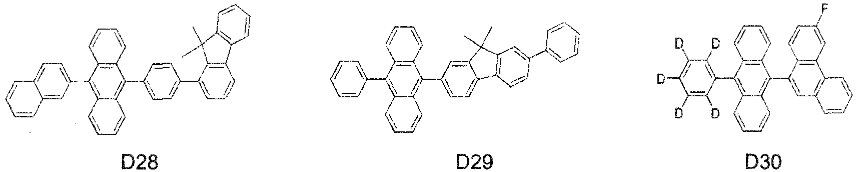

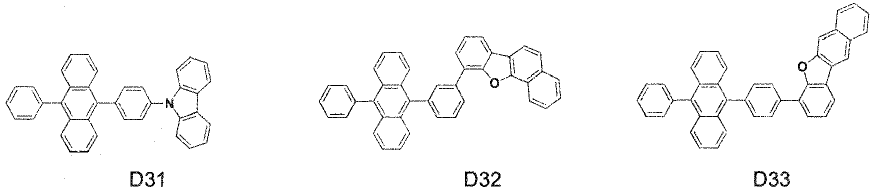

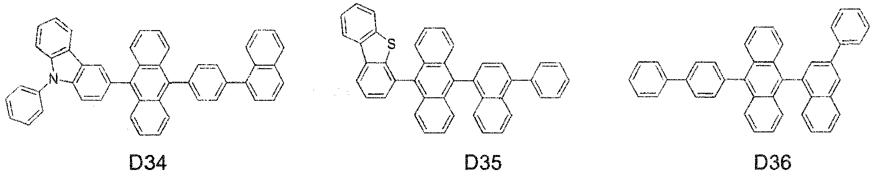

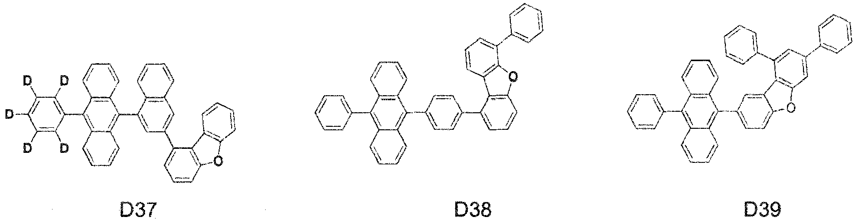

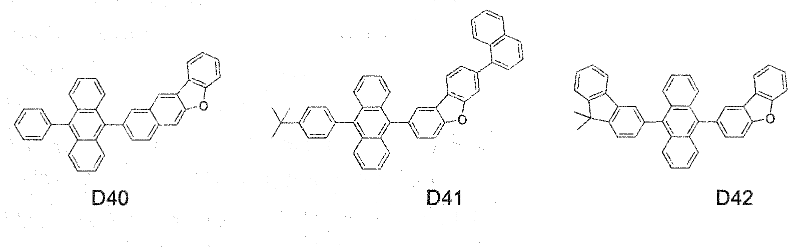

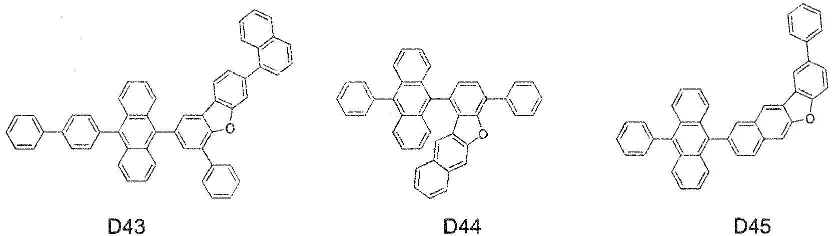

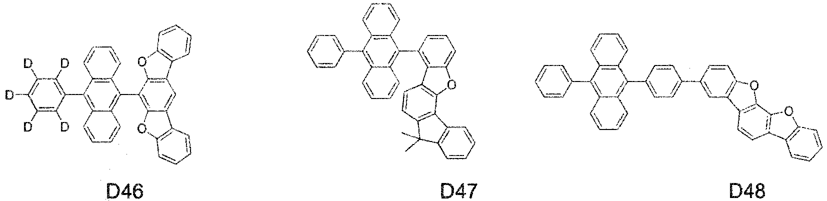

10. Dispositif électroluminescent organique selon la revendication 1, comprenant en outre une couche de transport de trous et une couche de blocage d'électrons interposées entre la première électrode et la deuxième électrode, chacun de la couche de transport de trous et la couche de blocage d'électrons comprenant un composé représenté par la formule E : 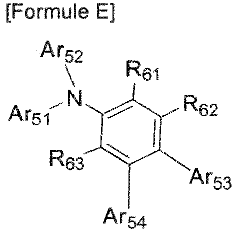 R₆₁ à R₆₃ étant identiques ou différents l'un de l'autre et étant choisis chacun indépendamment parmi hydrogène, deutérium, alkyle en C₁₋C₃₀ substitué ou non substitué, aryle en C₆-C₅₀ substitué ou non substitué, alcényle en C₂-C₃₀ substitué ou non substitué, alcynyle en C₂-C₂₀ substitué ou non substitué, cycloalkyle en C₃-C₃₀ substitué ou non substitué, cycloalcényle en C₅-C₃₀ substitué ou non substitué, hétéroaryle en C₂-C₅₀ substitué ou non substitué, hétérocycloalkyle en C₂-C₃₀ substitué ou non substitué, alcoxy en C₁₋C₃₀ substitué ou non substitué, aryloxy en C₆-C₃₀ substitué ou non substitué, alkylthioxy en C₁₋C₃₀ substitué ou non substitué, arylthioxy en C₆-C₃₀ substitué ou non substitué, alkylamine en C₁₋C₃₀ substituée ou non substituée, arylamine en C₆-C₃₀ substituée ou non substituée, alkylsilyle en C₁₋C₃₀ substitué ou non substitué, arylsilyle en C₆-C₃₀ substitué ou non substitué, alkylgermanium en C₁₋C₃₀ substitué ou non substitué, arylgermanium en C₁₋C₃₀ substitué ou non substitué, cyano, nitro, et halogène, et Ar₅₁ à Ar₅₄ étant identiques ou différents l'un de l'autre et étant chacun indépendamment aryle en C₆-C₄₀ substitué ou non substitué ou hétéroaryle en C₂-C₃₀ substitué ou non substitué.

11. Dispositif électroluminescent organique selon la revendication 10, dans lequel le composé de la formule E est choisi parmi les composés des formules E1 à E33 :
